# EUROPEAN PATENT SPECIFICATION

(11) **EP 4 354 225 B1**
(45) Date of publication and mention of the grant of the patent: **17.09.2025**
(21) Application number: 22815531.3
(22) Date of filing: 13.01.2022
(51) Int. Cl.: H01S 5/183

(54) **SEMICONDUCTOR LIGHT EMITTING ELEMENT AND METHOD FOR MANUFACTURING SEMICONDUCTOR LIGHT EMITTING ELEMENT**
LICHTEMITTIERENDES HALBLEITERELEMENT UND VERFAHREN ZUR HERSTELLUNG EINES LICHTEMITTIERENDEN HALBLEITERELEMENTS
ÉLÉMENT ÉLECTROLUMINESCENT À SEMI-CONDUCTEUR ET PROCÉDÉ DE FABRICATION D'ÉLÉMENT ÉLECTROLUMINESCENT À SEMI-CONDUCTEUR

(30) Priority: 01.06.2021 JP 2021092337
(43) Date of publication of application: 17.04.2024
(73) Proprietor: Sony Group Corporation, Tokyo 108-0075 (JP)
(72) Inventor: NAGANE, Shoetsu, Tokyo 108-0075 (JP); HAMAGUCHI, Tatsushi, Tokyo 108-0075 (JP); NAKAYAMA, Eiji, Kikuchi-gun, Kumamoto 869-1102 (JP); HAYASHI, Kentaro, Tokyo 108-0075 (JP); KAWANISHI, Hidekazu, Tokyo 108-0075 (JP); KODA, Rintaro, Tokyo 108-0075 (JP)
(74) Representative: D Young & Co LLP
(86) International application number: PCT/JP2022/000931
(87) International publication number: WO 2022/254770

(56) References cited:
- EP-A1- 3 588 702
- WO-A1-2020/246280
- JP-A- 2004 056 010
- JP-A- 2009 283 639
- JP-A- H05 136 460
- JP-A- H08 148 755
- US-A1- 2019 386 464
- US-A1- 2020 112 141
- US-A1- 2020 366 067
- US-B2- 6 990 134
- SONG Y M ET AL: "Precise etch-depth control of microlens-integrated intracavity contacted vertical-cavity surface-emitting lasers by in-situ laser reflectometry and reflectivity modeling", THIN SOLID FILMS, ELSEVIER, AMSTERDAM, NL, vol. 517, no. 19, 3 August 2009 (2009-08-03), pages 5773 - 5778, XP026158801, ISSN: 0040-6090, [retrieved on 20090402], DOI: 10.1016/J.TSF.2009.03.198
- GOTO K ET AL: "Self alignment technology between microlens focal points and near-field optical nano-probe apertures in 2-D micro-optical disk head", MICROPROCESSES AND NANOTECHNOLOGY CONFERENCE, 2002. DIGEST OF PAPERS. MICROPROCESSES AND NANOTECHNOLOGY 2002. 2002 INTERNATIONAL NOV. 6-8, 2002, PISCATAWAY, NJ, USA,IEEE, 6 November 2002 (2002-11-06), pages 310 - 311, XP010631342, ISBN: 978-4-89114-031-1

## Description

### Technical Field

The present technology relates to a semiconductor light-emitting device that includes a lens and a method of producing the semiconductor light-emitting device.

### Background Art

In a semiconductor light-emitting device such as a VCSEL (Vertical Cavity Surface Emitting Laser) device, a method of forming a lens on one side has been proposed as a method of nullifying diffraction loss due to optical field confinement in a lateral direction (see Patent Literature 1). In this method, a photosensitive member is patterned on the back surface of a substrate in accordance with a current injection region provided on the front surface of the substrate and this pattern of the photosensitive member is used to form a lens.

In order to cause the light emitted from the current injection region to enter the lens accurately, it is necessary to overlap the current injection region and the photosensitive member with high accuracy. In the above method, by overlapping an alignment mark provided on the front surface of the substrate and an alignment mark provided on a photomask through the substrate, the current injection region and the photomask are aligned and the photosensitive member is patterned by exposure using this photomask.

### Citation List

### Patent Literature

Patent Literature 1: WO 2018-083877. Cited references include US 2020/112141 A1, WO 2020/246280 A1 and US 6990134 B2.

US 2020/112141 discloses in particular a light-emitting device comprising a lens structure having a shape similar to an outer shape of a light-blocking structure, a center of gravity of the lens structure matching a center of gravity of the light-blocking structure as viewed from the direction perpendicular to a main surface.

### Disclosure of Invention

### Technical Problem

However, in the method described in Patent Literature 1, when aligning the current injection region and the photomask, there is a possibility that the center of the alignment mark of the substrate and the center of the alignment mark of the photomask are displaced from each other due to the difference in refractive index between the substrate and air. If exposure is performed in this state, the misalignment between the current injection region and the lens exceeds the specification of an exposure device and there is a risk of deterioration of a threshold value and yield.

Further, since there are few exposure devices that support exposure through a substrate, a large amount of cost is necessary to improve the accuracy of alignment. When measuring the misalignment, it is necessary to measure through a substrate, which increases measurement errors and causes development delays.

In view of the circumstances as described above, it is an object of the present technology to provide a semiconductor light-emitting device that has excellent productivity and is capable of aligning a current injection region and a lens with high accuracy, and a method of producing the semiconductor light-emitting device.

### Solution to Problem

The invention is defined by the claims.

### Brief Description of Drawings

[Fig. 1] Fig. 1 is a cross-sectional view of a light-emitting device according to an embodiment of the present technology.
[Fig. 2] Fig. 2 is a plan view of the light-emitting device as viewed from a side of a first main surface.
[Fig. 3] Fig. 3 is a plan view of a second main surface of the light-emitting device.
[Fig. 4] Fig. 4 is a cross-sectional view of a substrate of the light-emitting device.
[Fig. 5] Fig. 5 is a schematic diagram showing a light-blocking structure of the light-emitting device.
[Fig. 6] Fig. 6 is a schematic diagram showing the light-blocking structure of the light-emitting device.
[Fig. 7] Fig. 7 is a schematic diagram showing a lens structure of the light-emitting device.
[Fig. 8] Fig. 8 is a schematic diagram showing a method of producing the light-emitting device.
[Fig. 9] Fig. 9 is a schematic diagram showing the method of producing the light-emitting device.
[Fig. 10] Fig. 10 is a schematic diagram showing the method of producing the light-emitting device.
[Fig. 11] Fig. 11 is a schematic diagram showing the method of producing the light-emitting device.
[Fig. 12] Fig. 12 is a schematic diagram showing the method of producing the light-emitting device.
[Fig. 13] Fig. 13 is a schematic diagram showing the method of producing the light-emitting device.
[Fig. 14] Fig. 14 is a schematic diagram showing the method of producing the light-emitting device.
[Fig. 15] Fig. 15 is a schematic diagram showing a pattern of a photosensitive layer of the light-emitting device.
[Fig. 16] Fig. 16 is a schematic diagram showing a method of producing a light-emitting device according to a Comparative Example.
[Fig. 17] Fig. 17 is a schematic diagram showing the method of producing the light-emitting device according to the Comparative Example.
[Fig. 18] Fig. 18 is a schematic diagram showing a light-blocking structure having another shape of the light-emitting device according to the embodiment of the present technology.
[Fig. 19] Fig. 19 is a schematic diagram showing a method of forming a lens structure using the light-blocking structure.
[Fig. 20] Fig. 20 is a schematic diagram showing a light-blocking structure having another shape of the light-emitting device according to the embodiment of the present technology.
[Fig. 21] Fig. 21 is a schematic diagram showing a method of forming a lens structure using the light-blocking structure.
[Fig. 22] Fig. 22 is a cross-sectional view of a light-emitting device of a back surface emitting type according to an embodiment of the present technology.
[Fig. 23] Fig. 23 is a cross-sectional view of a light-emitting device according to an Example 1 of the present technology.
[Fig. 24] Fig. 24 is a schematic diagram showing a light-blocking structure of the light-emitting device according to the Example 1 of the present technology.
[Fig. 25] Fig. 25 is a schematic diagram showing a lens structure of the light-emitting device according to the Example 1 of the present technology.
[Fig. 26] Fig. 26 is a schematic diagram showing a method of producing the light-emitting device according to the Example 1 of the present technology.
[Fig. 27] Fig. 27 is a schematic diagram showing the method of producing the light-emitting device according to the Example 1 of the present technology.
[Fig. 28] Fig. 28 is a schematic diagram showing the method of producing the light-emitting device according to the Example 1 of the present technology.
[Fig. 29] Fig. 29 is a schematic diagram showing the method of producing the light-emitting device according to the Example 1 of the present technology.
[Fig. 30] Fig. 30 is a schematic diagram showing the method of producing the light-emitting device according to the Example 1 of the present technology.
[Fig. 31] Fig. 31 is a schematic diagram showing the method of producing the light-emitting device according to the Example 1 of the present technology.
[Fig. 32] Fig. 32 is a schematic diagram showing the method of producing the light-emitting device according to the Example 1 of the present technology.
[Fig. 33] Fig. 33 is a schematic diagram showing the method of producing the light-emitting device according to the Example 1 of the present technology.
[Fig. 34] Fig. 34 is a schematic diagram showing the method of producing the light-emitting device according to the Example 1 of the present technology.
[Fig. 35] Fig. 35 is a cross-sectional view of a light-emitting device of a back surface emitting type according to the Example 1 of the present technology.
[Fig. 36] Fig. 36 is a cross-sectional view of a light-emitting device according to an Example 2 of the present technology.
[Fig. 37] Fig. 37 is a schematic diagram of a light-blocking structure of the light-emitting device according to the Example 2 of the present technology.
[Fig. 38] Fig. 38 is a schematic diagram showing a lens structure of the light-emitting device according to the Example 2 of the present technology.
[Fig. 39] Fig. 39 is a schematic diagram showing a method of producing the light-emitting device according to the Example 2 of the present technology.
[Fig. 40] Fig. 40 is a schematic diagram showing the method of producing the light-emitting device according to the Example 2 of the present technology.
[Fig. 41] Fig. 41 is a schematic diagram showing the method of producing the light-emitting device according to the Example 2 of the present technology.
[Fig. 42] Fig. 42 is a schematic diagram showing the method of producing the light-emitting device according to the Example 2 of the present technology.
[Fig. 43] Fig. 43 is a schematic diagram showing the method of producing the light-emitting device according to the Example 2 of the present technology.
[Fig. 44] Fig. 44 is a schematic diagram showing the method of producing the light-emitting device according to the Example 2 of the present technology.
[Fig. 45] Fig. 45 is a schematic diagram showing the method of producing the light-emitting device according to the Example 2 of the present technology.
[Fig. 46] Fig. 46 is a cross-sectional view of a light-emitting device of a back surface emitting type according to the Example 2 of the present technology.
[Fig. 47] Fig. 47 is a cross-sectional view of a light-emitting device according to an Example 3 of the present technology.
[Fig. 48] Fig. 48 is a schematic diagram showing a light-blocking structure of the light-emitting device according to the Example 3 of the present technology.
[Fig. 49] Fig. 49 is a schematic diagram of a lens structure of the light-emitting device according to the Example 3 of the present technology.
[Fig. 50] Fig. 50 is a schematic diagram showing a method of producing the light-emitting device according to the Example 3 of the present technology.
[Fig. 51] Fig. 51 is a schematic diagram showing the method of producing the light-emitting device according to the Example 3 of the present technology.
[Fig. 52] Fig. 52 is a schematic diagram showing the method of producing the light-emitting device according to the Example 3 of the present technology.
[Fig. 53] Fig. 53 is a schematic diagram showing the method of producing the light-emitting device according to the Example 3 of the present technology.
[Fig. 54] Fig. 54 is a schematic diagram showing the method of producing the light-emitting device according to the Example 3 of the present technology.
[Fig. 55] Fig. 55 is a schematic diagram showing the method of producing the light-emitting device according to the Example 3 of the present technology.
[Fig. 56] Fig. 56 is a schematic diagram showing the method of producing the light-emitting device according to the Example 3 of the present technology.
[Fig. 57] Fig. 57 is a cross-sectional view of a light-emitting device of a back surface emitting type according to the Example 3 of the present technology.
[Fig. 58] Fig. 58 is a cross-sectional view of a light-emitting device according to an Example 4 of the present technology.
[Fig. 59] Fig. 59 is a schematic diagram showing a light-blocking structure of the light-emitting device according to the Example 4 of the present technology.
[Fig. 60] Fig. 60 is a schematic diagram showing a lens structure of the light-emitting device according to the Example 4 of the present technology.
[Fig. 61] Fig. 61 is a schematic diagram showing a method of producing the light-emitting device according to the Example 4 of the present technology.
[Fig. 62] Fig. 62 is a schematic diagram showing the method of producing the light-emitting device according to the Example 4 of the present technology"
[Fig. 63] Fig. 63 is a schematic diagram showing the method of producing the light-emitting device according to the Example 4 of the present technology.
[Fig. 64] Fig. 64 is a schematic diagram showing the method of producing the light-emitting device according to the Example 4 of the present technology.
[Fig. 65] Fig. 65 is a schematic diagram showing the method of producing the light-emitting device according to the Example 4 of the present technology.
[Fig. 66] Fig. 66 is a schematic diagram showing the method of producing the light-emitting device according to the Example 4 of the present technology.
[Fig. 67] Fig. 67 is a schematic diagram showing the method of producing the light-emitting device according to the Example 4 of the present technology.
[Fig. 68] Fig. 68 is a cross-sectional view of a light-emitting device of a back surface emitting type according to the Example 4 of the present technology.
[Fig. 69] Fig. 69 is a cross-sectional view of a light-emitting device that has a lens structure having another shape according to the Example 4 of the present technology.
[Fig. 70] Fig. 70 is a schematic diagram of the lens structure having another shape according to the Example 4 of the present technology.
[Fig. 71] Fig. 71 is a cross-sectional view of a light-emitting device of a back surface emitting type that has a lens structure having another shape according to the Example 4 of the present technology.
[Fig. 72] Fig. 72 is a cross-sectional view of a light-emitting device according to an Example 5 of the present technology.
[Fig. 73] Fig. 73 is a schematic diagram showing a light-blocking structure of the light-emitting device according to the Example 5 of the present technology.
[Fig. 74] Fig. 74 is a schematic diagram showing a lens structure of the light-emitting device according to the Example 5 of the present technology.
[Fig. 75] Fig. 75 is a schematic diagram showing a method of producing the light-emitting device according to the Example 5 of the present technology.
[Fig. 76] Fig. 76 is a schematic diagram showing the method of producing the light-emitting device according to the Example 5 of the present technology.
[Fig. 77] Fig. 77 is a schematic diagram showing the method of producing the light-emitting device according to the Example 5 of the present technology.
[Fig. 78] Fig. 78 is a schematic diagram showing the method of producing the light-emitting device according to the Example 5 of the present technology.
[Fig. 79] Fig. 79 is a schematic diagram showing the method of producing the light-emitting device according to the Example 5 of the present technology.
[Fig. 80] Fig. 80 is a schematic diagram showing the method of producing the light-emitting device according to the Example 5 of the present technology.
[Fig. 81] Fig. 81 is a schematic diagram showing the method of producing the light-emitting device according to the Example 5 of the present technology.
[Fig. 82] Fig. 82 is a schematic diagram showing the method of producing the light-emitting device according to the Example 5 of the present technology.
[Fig. 83] Fig. 83 a cross-sectional view of a light-emitting device of a back surface emitting type according to the Example 5 of the present technology.
[Fig. 84] Fig. 84 is a cross-sectional view of a light-emitting device according to an Example 6 of the present technology.
[Fig. 85] Fig. 85 is a schematic diagram showing a light-blocking structure of the light-emitting device according to the Example 6 of the present technology.
[Fig. 86] Fig. 86 is a schematic diagram showing a lens structure of the light-emitting device according to the Example 6 of the present technology.
[Fig. 87] Fig. 87 is a schematic diagram showing a method of producing the light-emitting device according to the Example 6 of the present technology.
[Fig. 88] Fig. 88 is a schematic diagram showing the method of producing the light-emitting device according to the Example 6 of the present technology.
[Fig. 89] Fig. 89 is a schematic diagram showing the method of producing the light-emitting device according to the Example 6 of the present technology.
[Fig. 90] Fig. 90 is a schematic diagram showing the method of producing the light-emitting device according to the Example 6 of the present technology.
[Fig. 91] Fig. 91 is a schematic diagram showing the method of producing the light-emitting device according to the Example 6 of the present technology.
[Fig. 92] Fig. 92 is a schematic diagram showing the method of producing the light-emitting device according to the Example 6 of the present technology.
[Fig. 93] Fig. 93 is a schematic diagram showing the method of producing the light-emitting device according to the Example 6 of the present technology.
[Fig. 94] Fig. 94 is a schematic diagram showing the method of producing the light-emitting device according to the Example 6 of the present technology.
[Fig. 95] Fig. 95 is a schematic diagram showing the method of producing the light-emitting device according to the Example 6 of the present technology.
[Fig. 96] Fig. 96 is a cross-sectional view of a light-emitting device according to an Example 7 of the present technology.
[Fig. 97] Fig. 97 is a cross-sectional view of a light-emitting device according to an Example 8 of the present technology.
[Fig. 98] Fig. 98 is a schematic diagram showing a method of producing the light-emitting device according to the Example 8 of the present technology.
[Fig. 99] Fig. 99 is a schematic diagram showing the method of producing the light-emitting device according to the Example 8 of the present technology.
[Fig. 100] Fig. 100 is a schematic diagram showing the method of producing the light-emitting device according to the Example 8 of the present technology.
[Fig. 101] Fig. 101 is a schematic diagram showing the method of producing the light-emitting device according to the Example 8 of the present technology?
[Fig. 102] Fig. 102 is a schematic diagram showing the method of producing the light-emitting device according to the Example 8 of the present technology.
[Fig. 103] Fig. 103 is a schematic diagram showing the method of producing the light-emitting device according to the Example 8 of the present technology.
[Fig. 104] Fig. 104 is a schematic diagram showing the method of producing the light-emitting device according to the Example 8 of the present technology.
[Fig. 105] Fig. 105 is a schematic diagram showing the method of producing the light-emitting device according to the Example 8 of the present technology.
[Fig. 106] Fig. 106 is a schematic diagram showing the method of producing the light-emitting device according to the Example 8 of the present technology.
[Fig. 107] Fig. 107 is a schematic diagram showing the method of producing the light-emitting device according to the Example 8 of the present technology.
[Fig. 108] Fig. 108 is a cross-sectional view of a light-emitting device according to an Example 9 of the present technology.
[Fig. 109] Fig. 109 is a schematic diagram showing a method of producing the light-emitting device according to the Example 9 of the present technology.
[Fig. 110] Fig. 110 is a schematic diagram showing the method of producing the light-emitting device according to the Example 9 of the present technology.
[Fig. 111] Fig. 111 is a schematic diagram showing the method of producing the light-emitting device according to the Example 9 of the present technology.
[Fig. 112] Fig. 112 is a schematic diagram showing the method of producing the light-emitting device according to the Example 9 of the present technology.
[Fig. 113] Fig. 113 is a schematic diagram showing the method of producing the light-emitting device according to the Example 9 of the present technology.
[Fig. 114] Fig. 114 is a schematic diagram showing the method of producing the light-emitting device according to the Example 9 of the present technology.
[Fig. 115] Fig. 115 is a schematic diagram showing the method of producing the light-emitting device according to the Example 9 of the present technology.
[Fig. 116] Fig. 116 is a schematic diagram showing the method of producing the light-emitting device according to the Example 9 of the present technology.

### Mode(s) for Carrying Out the Invention

A light-emitting device according to an embodiment of the present technology will be described.

### [Configuration of light-emitting device]

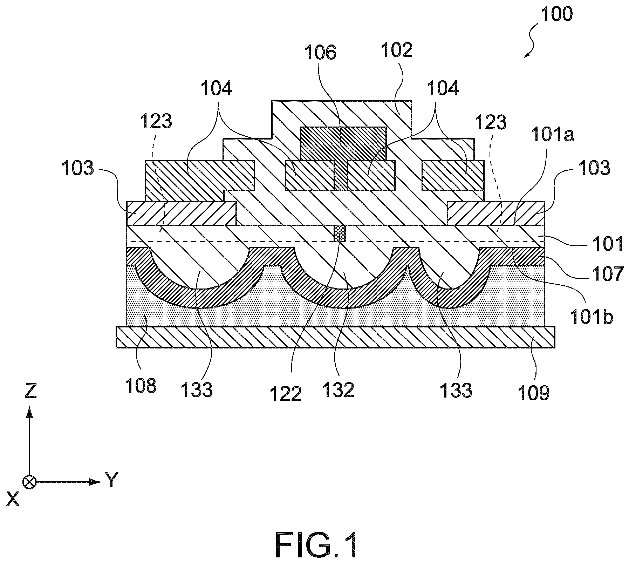

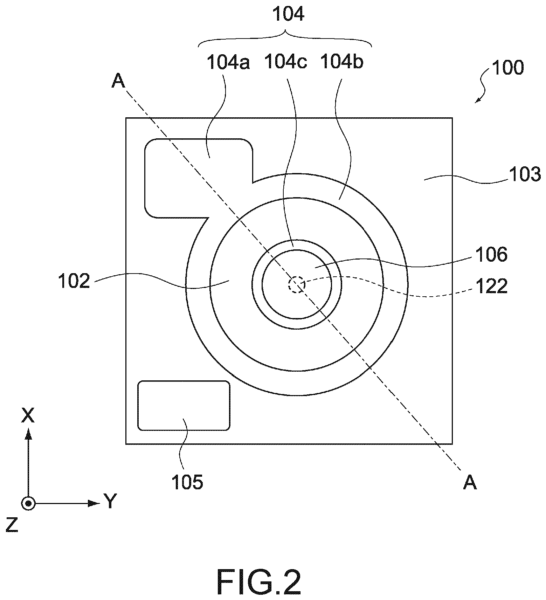

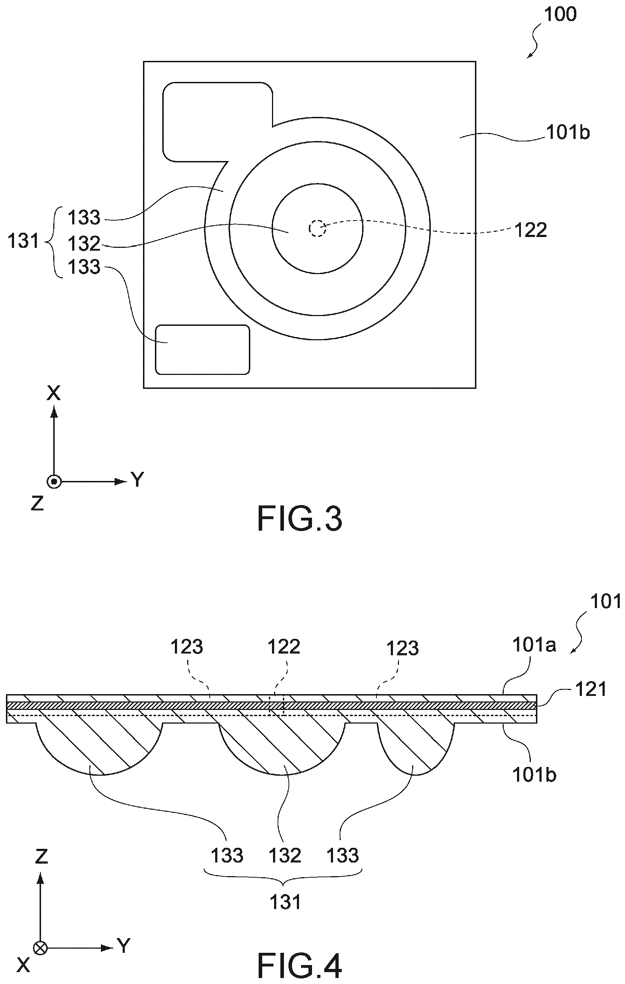

Fig. 1 is a cross-sectional view of a light-emitting device 100 according to this embodiment, and Fig. 2 is a plan view of the light-emitting device 100. Fig. 1 is a cross-sectional view taken along the line A-A in Fig. 2. The light-emitting device 100 is a VCSEL (Vertical Cavity Surface Emitting Laser) device and includes a substrate 101, a transparent conductive layer 102, an insulation layer 103, an upper electrode 104, a lower electrode 105, an upper light-reflecting layer 106, a lower light-reflecting layer 107, a wax 108, and a support substrate 109 as shown in Fig. 1 and Fig. 2. Note that in Fig. 3, illustration of the wax 108 and the support substrate 109 is omitted. Hereinafter, the layer surface direction of the light-emitting device 100 will be referred to as an X-Y direction and the stacking direction will be referred to as a Z direction.

The substrate 101 is formed of a semiconductor material and forms a light-emitting structure of the light-emitting device 100. The semiconductor material forming the substrate 101 is formed of, for example, GaN, GaAs, or InP. Fig. 4 is a cross-sectional view of the substrate 101. As shown in the figure, the substrate 101 has a first main surface 101a and a second main surface 101b, and the first main surface 101a and the second main surface 101b are main surfaces of the substrate 101 opposite to each other. Fig. 2 is a diagram of the light-emitting device 100 as viewed from the side of the first main surface 101a, and Fig. 3 is a diagram of the second main surface 101b of the light-emitting device 100 as viewed from the side of the first main surface 101a.

As shown in Fig. 4, the substrate 101 includes an active layer 121. The active layer 121 is a layer that emits light by carrier recombination. The active layer 121 may have a multiple quantum well structure in which a quantum well layer and a barrier layer are alternately stacked to include a plurality of layers. In addition, the active layer 121 only needs to be a layer that emits light by carrier recombination.

Further, as shown in Fig. 4, the substrate 101 has a current injection region 122 and an insulation region 123. The current injection region 122 is a region having conductivity, and the insulation region 123 is a region having insulation properties. The current injection region 122 and the insulation region 123 are each formed to have a depth including the active layer 121 in the substrate 101. As shown in Fig. 2 and Fig. 3, the current injection region 122 is provided in the central portion of the substrate 101 and is surrounded by the insulation region 123 in the X-Y direction.

The method of forming the current injection region 122 and the insulation region 123 is not particularly limited. For example, by implanting ions such as boron into the constituent material of the substrate 101, the insulation region 123 is formed and the region into which ions are not implanted can be used as the current injection region 122. Further, by oxidizing the constituent material of the substrate 101 from the outer periphery side, the oxidized region can also be used as the insulation region 123 and the non-oxidized region can also be used as the current injection region 122. Further, by forming a buried tunnel junction layer in the substrate 101, the region in which the tunnel junction layer is provided can also be used as the current injection region 122 and the other region can also be used as the insulation region **123.**

As shown in Fig. 3 and Fig. 4, a lens structure 131 is provided on the side of the second main surface 101b of the substrate 101. The lens structure 131 includes a lens 132 and a protective portion 133. The lens 132 has a convex lens shape protruding from the second main surface 101b. As shown in Fig. 3, the lens 132 is disposed such that the center thereof matches the center of the current injection region 122 as viewed from the direction perpendicular to the first main surface 101a (Z direction). The protective portion 133 protrudes from the second main surface 101b and protects the lens 132. The lens structure 131 is formed of the same material as the material of the substrate 101 or a photosensitive material described below.

The transparent conductive layer 102 (see Fig. 1) is formed of a transparent conductive material such as ITO (Indium Tin Oxide) and is provided on the side of the first main surface 101a of the substrate 101. The insulation layer 103 is formed of an insulating material such as SiO₂ and is provided on the side of the first main surface 101a of the substrate 101.

The upper electrode 104 is formed of a metal and is provided on the transparent conductive layer 102 and the insulation layer 103. The upper electrode 104 is electrically connected to the side of the first main surface 101a of the active layer 121 (see Fig. 4) via the transparent conductive layer 102 and functions as one electrode (e.g., a p-type electrode) of the light-emitting device 100. As shown in Fig. 2, the upper electrode 104 is formed in a predetermined shape as viewed from the direction perpendicular to the first main surface 101a (Z direction). Specifically, the upper electrode 104 includes a pad portion 104a, an outer ring potion 104b, and a central portion 104c. The pad portion 104a is a portion to which a terminal that supplies a current to the light-emitting device 100 is joined. The outer ring potion 104b is an annular portion that is connected to the pad portion 104a and surrounds the central portion 104c. The central portion 104c is a portion that is electrically connected to the outer ring potion 104b via the transparent conductive layer 102 and supplies a current to the current injection region 122.

The lower electrode 105 (see Fig. 2) is formed of a metal and is provided on the insulation layer 103. The lower electrode 105 is electrically connected to the side of the second main surface 101b of the active layer 121 (see Fig. 4) via a through hole or the like provided in the insulation layer 103 and functions as the other electrode (e.g., an n-type electrode) of the light-emitting device 100. Specifically, the lower electrode 105 has a portion formed on the second main surface 101b around the lens 132, and supplies a current from this portion to the current injection region 122.

The upper light-reflecting layer 106 is provided on the transparent conductive layer 102 and the insulation layer 103, and is superimposed on the current injection region 122 as viewed from the direction (Z direction) perpendicular to the first main surface 101a. The upper light-reflecting layer 106 reflects a component of a specific wavelength (hereinafter, the wavelength λ) of light that has entered from the active layer 121 toward the active layer 121. The upper light-reflecting layer 106 may be a DBR (Distributed Bragg Reflector) from a multilayer light-reflecting film obtained by alternately stacking a high-refractive index layer and a low-refractive index layer to include a plurality of layers, and is, for example, a dielectric multilayer film having a stacked structure such as Ta₂O₃/SiO₂, SiO₂/SiN, and SiO₂/Nb₂O₅.

The lower light-reflecting layer 107 is provided on the second main surface 101b and is superimposed on the current injection region 122 as viewed from the direction (Z direction) perpendicular to the first main surface 101a. The lower light-reflecting layer 107 reflects a component of the wavelength λ of light that has entered from the active layer 121 toward the active layer 121. Here, since the lens structure 131 is provided on the second main surface 101b, the lower light-reflecting layer 107 has a shape according to the shape of the lens structure 131. Since the lens 132 has a convex lens shape as described above, the lower light-reflecting layer 107 on the lens 132 forms a concave mirror as viewed from the side of the current injection region 122. The lower light-reflecting layer 107 may be a DBR (Distributed Bragg Reflector) formed of a multilayer light-reflecting film obtained by alternately stacking a high-refractive index layer and a low-refractive index layer to include a plurality of layers, and is, for example, a dielectric multilayer film having a stacked structure such as Ta₂O₅/SiO₂, SiO₂/SiN, and SiO₂/Nb₂O₅.

The wax 108 is applied onto the lower light-reflecting layer 107 to join the substrate 101 and the support substrate 109 together. The support substrate 109 is formed of sapphire or the like, and supports the respective layers of the light-emitting device 100.

The light-emitting device 100 has the configuration as described above. In the light-emitting device 100, when a voltage is applied between the upper electrode 104 and the lower electrode 105, a current is injected into the current injection region 122. This injected current causes spontaneous emission light in the vicinity of the current injection region 122 of the active layer 121. The component of the wavelength λ of the spontaneous emission light is reflected by the upper light-reflecting layer 106 and the lower light-reflecting layer 107, forms a standing wave between the upper light-reflecting layer 106 and the lower light-reflecting layer 107, and is amplified by the active layer 121. When the injected current exceeds a threshold value, the light forming a standing wave causes laser oscillation. The laser beam generated thereby passes through the upper light-reflecting layer 106 and is emitted from the light-emitting device 100.

Here, as described above, the lens 132 is provided on the second main surface 101b, and the lower light-reflecting layer 107 on the lens 132 forms a concave mirror. For this reason, the light that has entered the lower light-reflecting layer 107 is collected in the current injection region 122 by this concave mirror, which allows to suppress diffraction loss due to optical field confinement in the lateral direction (X-Y direction). Meanwhile, in order to obtain this effect, the positional relationship between the lens 132 and the current injection region 122 needs to be adjusted with high accuracy.

Note that in the light-emitting device 100, the upper electrode 104 may be a p-type electrode, the lower electrode 105 may be an n-type electrode, the upper light-reflecting layer 106 may be a p-type DBR, and the lower light-reflecting layer 107 may be an n-type DBR. On the contrary, the upper electrode 104 may be an n-type electrode, the lower electrode 105 may be a p-type electrode, the upper light-reflecting layer 106 may be an n-type DBR, and the lower light-reflecting layer 107 may be a p-type DBR.

### [Regarding shapes of light-blocking structure and lens structure]

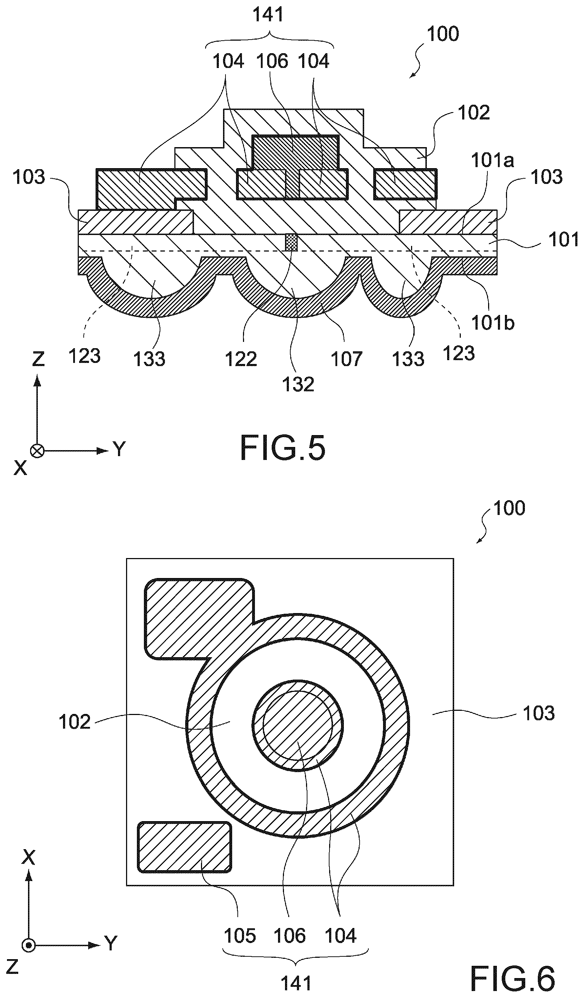

The light-emitting device 100 has a light-blocking structure, and this light-blocking structure has a predetermined relationship with the lens structure 131. The light-blocking structure is a structure that is formed on the side of the first main surface 101a of the substrate 101, of the configurations of the light-emitting device 100, and is opaque to the exposure wavelength described below. Fig. 5 and Fig. 6 are each a schematic diagram showing a light-blocking structure 141. Fig. 5 is a cross-sectional view of a partial configuration of the light-emitting device 100, and shows the light-blocking structure 141 by bold lines. Fig. 6 is a plan view of the light-emitting device 100 as viewed from the direction (Z direction) perpendicular to the first main surface 101a, and shows the light-blocking structure 141 by bold lines and hatching. As shown in Fig. 5 and Fig. 6, the light-blocking structure 141 includes the upper electrode 104, the lower electrode 105, and the upper light-reflecting layer 106.

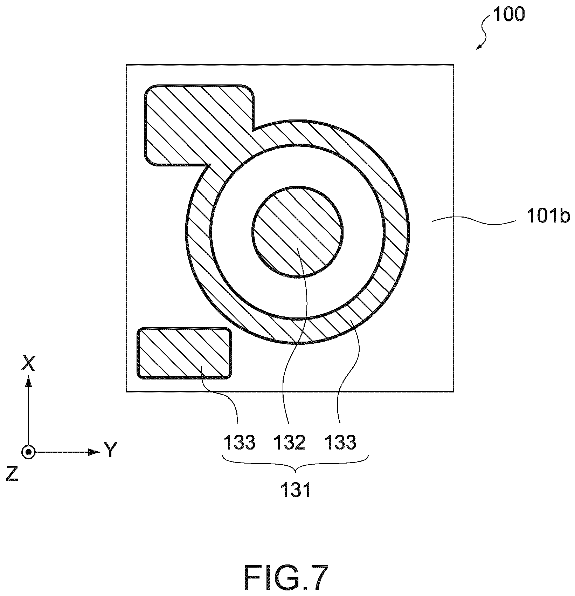

Fig. 7 is a schematic diagram showing the lens structure 131, and is a plan view of the second main surface 101b as viewed from the direction (Z direction) perpendicular to the first main surface 101a. In Fig. 7, the lens structure 131 is shown by bold lines and hatching. As shown in Fig. 6 and Fig. 7, the outer shape of the lens structure 131 as viewed form the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

Specifically, the outer shape of the lens structure 131 as viewed from the direction (Z direction) perpendicular to the first main surface 101a may be the same as the outer shape of the light-blocking structure 141 as viewed from the same direction (Z direction), and the center of gravity as viewed from the same direction (Z direction) may match the center of gravity of the light-blocking structure 141 as viewed from the same direction (Z direction). Further, the outer shape of the lens structure 131 as viewed from the direction (Z direction) perpendicular to the first main surface 101a may be a shape obtained by reducing or enlarging the outer shape of the light-blocking structure 141 as viewed from the same direction (Z direction) by a certain magnification, and the center of gravity as viewed from the same direction (Z direction) may match the center of gravity of the light-blocking structure 141 as viewed from the same direction (Z direction). Such a shape of the lens structure 131 can be formed by the production method described below.

Note that the light-blocking structure 141 does not necessarily need to include all the upper electrode 104, the lower electrode 105, and the upper light-reflecting layer 106, and may include at least one of them (see Examples). Further, the lens structure 131 does not necessarily need to include both the lens 132 and the protective portion 133, and only need to include at least the lens 132 (see Examples).

### [Method of producing light-emitting device]

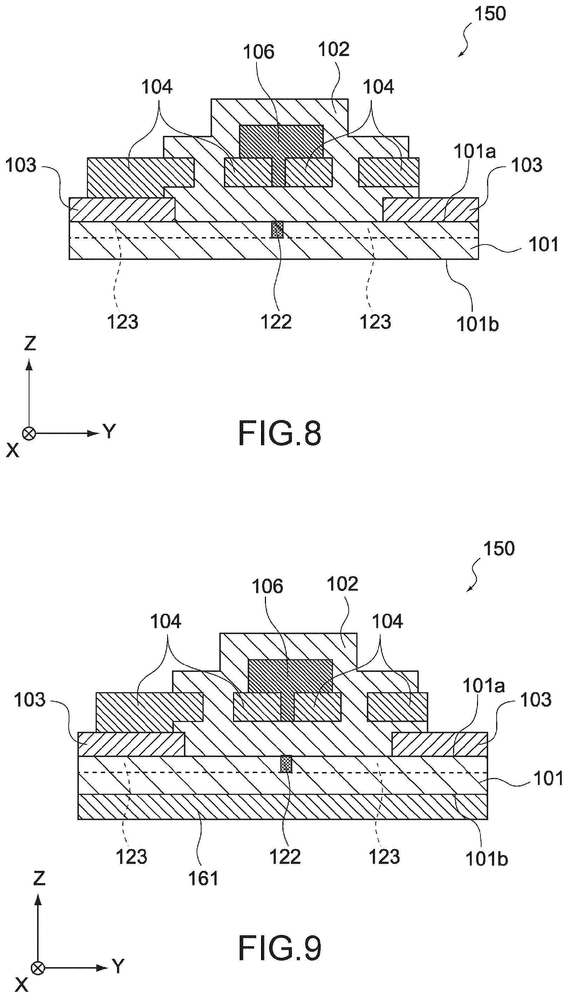

A method of producing the light-emitting device 100 will be described. Fig. 8 to Fig. 14 are each a schematic diagram showing a method of producing the light-emitting device 100.

First, as shown in Fig. 8, a light-emitting device 150 is prepared. The light-emitting device 150 has the same configuration as that of the light-emitting device 100 except that the lens structure 131 is not provided in the substrate 101 and the wax 108 and the support substrate 109 are not provided, and has the light-blocking structure 141. Each configuration of the light-emitting device 150 can be prepared by a general semiconductor process. Subsequently, as shown in Fig. 9, a photosensitive layer 161 is stacked on the second main surface 101b of the substrate 101. The photosensitive layer 161 is formed of a photosensitive material whose solubility increases by exposure, and the photosensitive material is, for example, a positive photoresist.

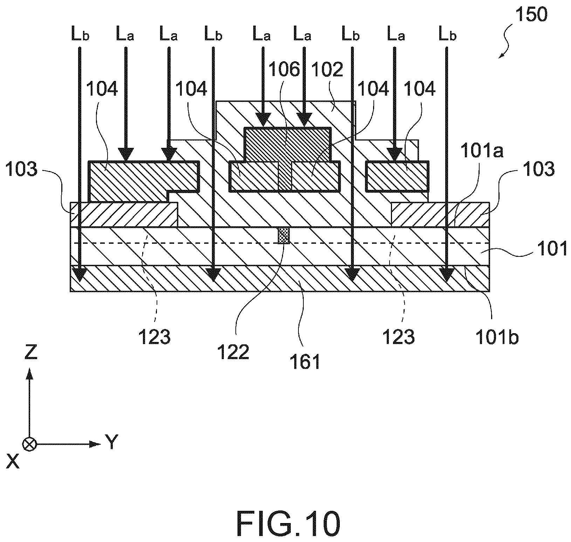

Subsequently, as shown in Fig. 10, light having a predetermined exposure wavelength is applied from the side of the first main surface 101a to exposure the photosensitive layer 161. The upper electrode 104, the lower electrode 105, and the upper light-reflecting layer 106 constitute the light-blocking structure 141 (see Fig. 5 and Fig. 6) as described above, and a light beam Lₐ that has entered the light-blocking structure 141 is blocked by the light-blocking structure 141. Meanwhile, a light L_{b} that has not entered the light-blocking structure 141 is transmitted through the transparent conductive layer 102, the insulation layer 103, the substrate 101, and the like to enter the photosensitive layer 161, and denatures the photosensitive material to form a denatured region. As a result, in the photosensitive layer 161, a denatured region in which the photosensitive material has been denatured and a non-denatured region in which the photosensitive material has not been denatured are formed.

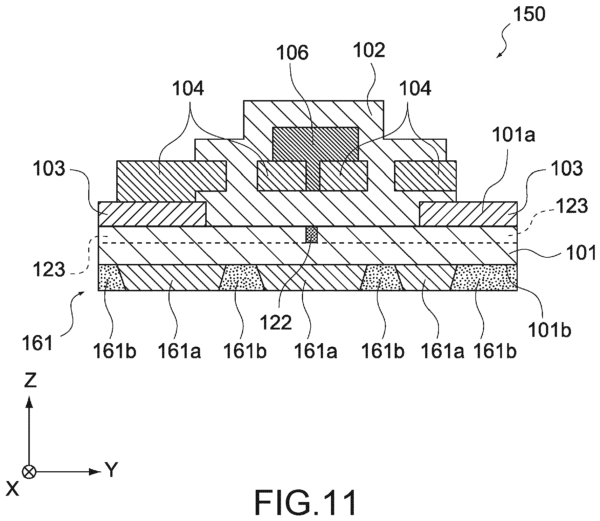

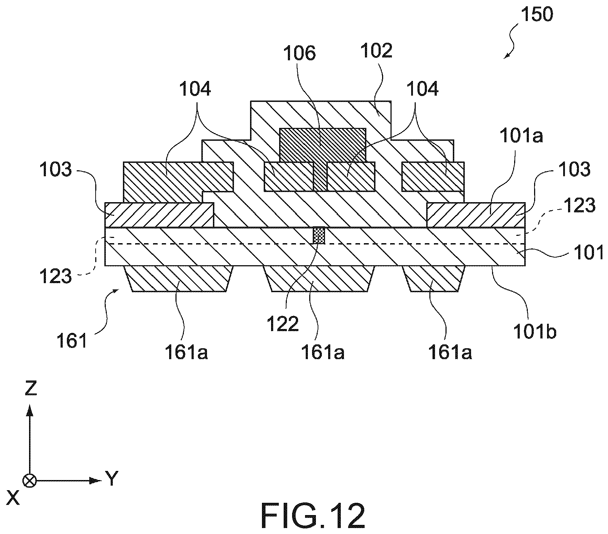

Fig. 11 is a schematic diagram showing a non-denatured region 161a and a denatured region 161b formed in the photosensitive layer 161. As shown in the figure, the denatured region 161b is formed in a region of the photosensitive layer 161 that the light L_{b} has entered. Subsequently, a developer is supplied to the photosensitive layer 161 to dissolve and remove the denatured region 161b as shown in Fig. 12. As a result, a pattern including only the non-denatured region 161a is formed in the photosensitive layer 161. Note that a taper is formed on the outer periphery of the non-denatured region 161a due to the spread of light during the exposure process.

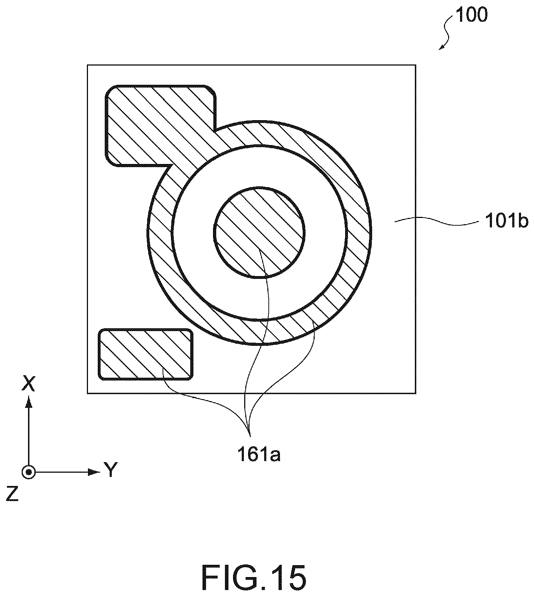

Fig. 15 is a schematic diagram showing a shape of the non-denatured region 161a, and is a diagram of the photosensitive layer 161 as viewed from the direction (Z direction) perpendicular to the side of the first main surface 101a. Since the non-denatured region 161a is a region where light is blocked by the light-blocking structure 141 (see Fig. 6), the non-denatured region 161a is formed in a pattern according to the light-blocking structure 141. Specifically, as shown in Fig. 15, the outer shape of the non-denatured region 161a as viewed from the direction (Z direction) perpendicular to the side of the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

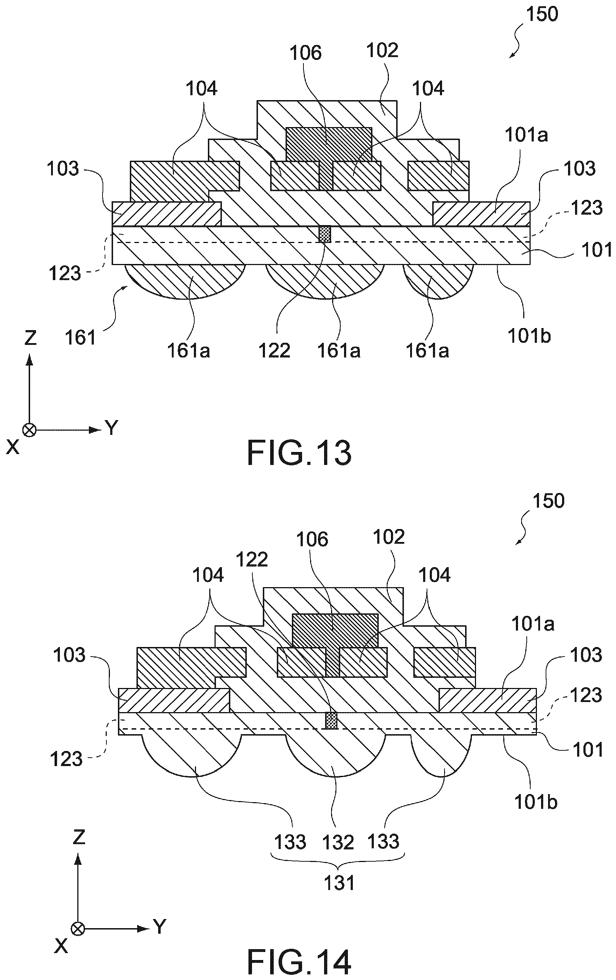

Subsequently, the photosensitive layer 161 is heated and reflowed. As a result, as shown in Fig. 13, the non-denatured region 161a is balled up and changed into a shape having a predetermined radius of curvature. Similarly to the non-denatured region 161a before being balled up, the outer shape (same as that in Fig. 15) of this balled-up non-denatured region 161a as viewed from the direction (Z direction) perpendicular to the side of the first main surface 101a is similar to the outer shape of the light-blocking structure 141 (see Fig. 6) as viewed from the same direction, and the center of gravity as viewed from the same direction (Z direction) matches the center of gravity of the light-blocking structure 141 as viewed from the same direction (Z direction).

Note that depending on the spread of light during exposure and the degree of expansion due to the ball-up, the outer shape of the non-denatured region 161a as viewed from the direction (Z direction) perpendicular to the side of the first main surface 101a is a shape obtained by reducing or enlarging the outer shape of the light-blocking structure 141 as viewed from the same direction (Z direction) at a certain magnification.

Subsequently, the balled-up non-denatured region 161a is used to form the lens structure 131 as shown in Fig. 14. The lens structure 131 can be formed by etching the substrate 101 using the balled-up non-denatured region 161a as an etching mask. This etching can be, for example, RIE (Reactive Ion Etching). In this case, the lens structure 131 is formed of the same materials as that of the substrate 101.

Further, the balled-up non-denatured region 161a may be used as the lens structure 131 as it is. In this case, the lens structure 131 is formed of the photosensitive material forming the photosensitive layer 161. Subsequently, the lower light-reflecting layer 107 (see Fig. 1) is stacked on the lens structure 131 and joined to the support substrate 109 with the wax 108. The light-emitting device 100 can be produced in this way. Note that the method of producing the light-emitting device 100 is not limited to the one shown here, and only needs to include at least the exposure process of the photosensitive layer 161 using the light-blocking structure 141.

### [Effects of light-emitting device]

The effects of the light-emitting device 100 will be described. The light-emitting device 100 can be prepared by blocking light with the light-blocking structure 141 to pattern the photosensitive layer 161 and forming the lens structure 131 using the pattern. Therefore, the light-emitting device 100 does not require alignment of a substrate in the preparation process.

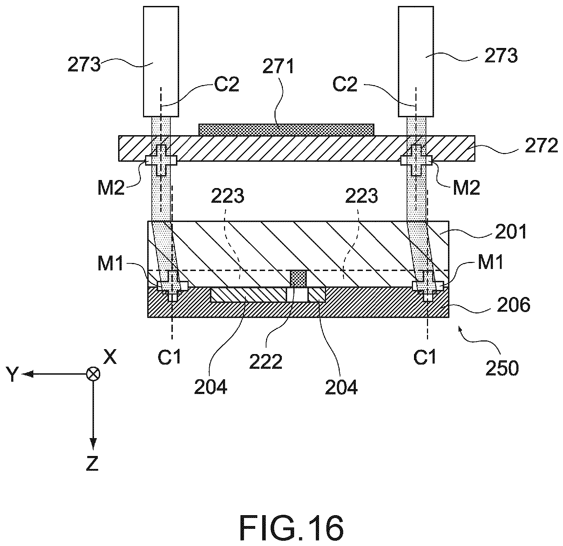

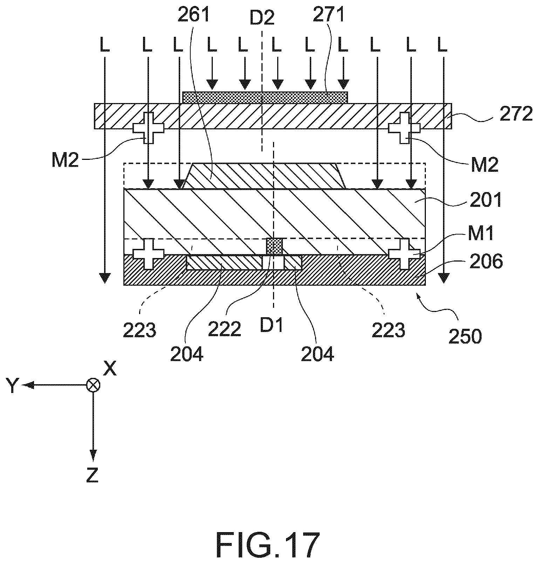

Fig. 16 and Fig. 17 are each a schematic diagram showing a method of forming a lens structure according to the existing technology for comparison. A light-emitting device 250 is shown in Fig. 16 and Fig. 17. The light-emitting device 250 includes a substrate 201, an upper electrode 204, and an upper light-reflecting layer 206, and a current injection region 222 and an insulation region 223 are provided.

In this formation method, as shown in Fig. 16, a photomask 272 having a light-blocking region 271 is disposed on the back surface side of the substrate 201, and a camera 273 images an alignment mark M1 on the side of the substrate 201 and an alignment mark M2 on the side of the photomask 272. The photomask 272 and the substrate 201 are aligned such that the alignment mark M1 and the alignment mark M2 overlap in this captured image. At this time, even if both the alignment marks match in the captured image, a center C1 of the alignment mark M1 and a center C2 of the alignment mark M2 are actually displaced from each other in some cases as shown in Fig. 16 due to the difference in refractive index between the substrate 201 and the air.

When a light beam L is applied in this state as shown in Fig. 17 to pattern a photosensitive layer 261, since a center D1 of the substrate 201 and a center D2 of the photomask 272 are displaced from each other, the pattern of the photosensitive layer 261 is also displaced. For this reason, when a lens structure is formed using the photosensitive layer 261, positional deviation occurs between the lens structure and the current injection region 222. The positional deviation between the lens structure and the current injection region 222 causes an increase in threshold current density and a deterioration in yield.

Meanwhile, in the light-emitting device 100, the light-blocking structure 141 provided on the substrate 101 is used to pattern the photosensitive layer 161, as described above. For this reason, it is possible to align the lens 132 and the current injection region 122 with high accuracy, and improve the electrical properties of the light-emitting device 100, the optical properties, and the yield.

Further, although the substrate 101 is expanded and contracted in some cases during the process of producing the light-emitting device 100, since the light-blocking structure 141 is also expanded and contracted in accordance with the substrate 101, the influence due to the expansion and contraction of the substrate 101 can be excluded. Further, since a photomask is not required in the process of producing the light-emitting device 100 except for some production processes described below, it is possible to reduce the cost of the photomask and reduce the production cost by simplifying the photomask alignment process and the exposure device.

In addition, since the diameter of the lens 132 can be controlled by the outer diameter of the light-blocking structure 141 in the light-emitting device 100, it is possible to control the transverse mode of the light-emitting device 100. Note that since a taper is formed on the outer periphery of the non-denatured region 161a due to the spread of light during the exposure process (see Fig. 12), it is possible to expand the radius of curvature (ROC) of the lens 132 and narrow the pitch of the lens 132.

### [Regarding other shapes of lens structure]

As described above, the outer shape of the lens structure 131 as viewed from the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction) (see Fig. 6 and Fig. 7). Further, the shapes of the light-blocking structure 141 and the lens structure 131 can have the following relationship.

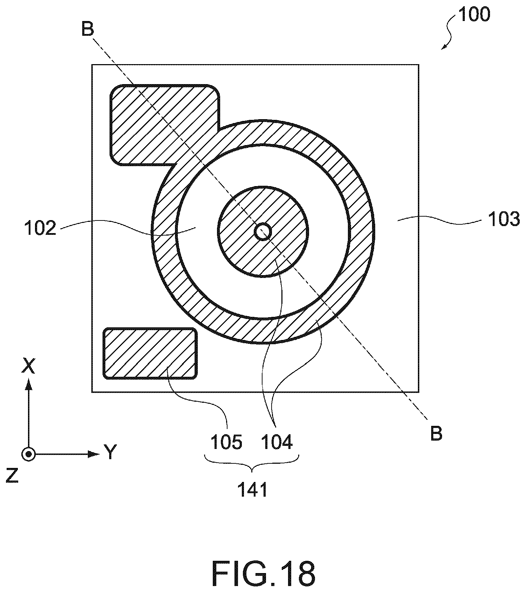

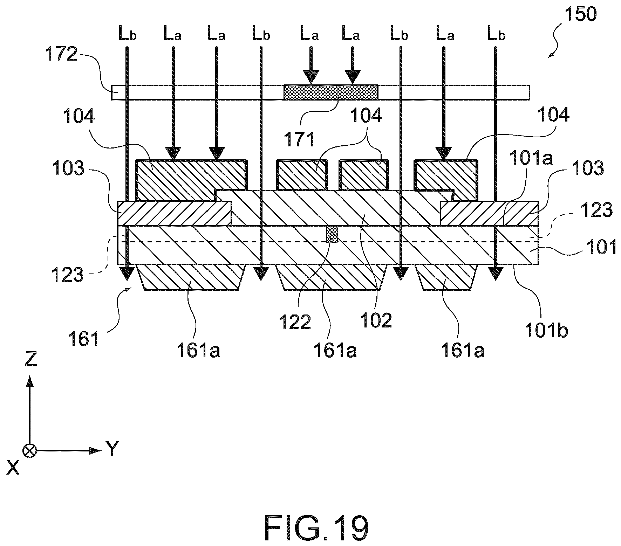

Fig. 18 is a schematic diagram showing the light-blocking structure 141 having another shape, which is included in the light-emitting device 100, and is a plan view of the light-emitting device 100 as viewed from the direction (Z direction) perpendicular to the first main surface 101a. Fig. 19 is a schematic diagram showing a method of forming the lens structure 131 using this light-blocking structure 141, and is a cross-sectional view taken along the line B-B in Fig. 18. As shown in Fig. 18 and Fig. 19, the light-blocking structure 141 may have a structure that does not include the upper light-reflecting layer 106.

In this case, the non-denatured region 161a having the shape shown in Fig. 15 can be formed by blocking light in the vicinity of the current injection region 122 with a photomask 172 in which a light-blocking region 171 is provided as shown in Fig. 19. Further, this non-denatured region 161a can be used to form the lens structure 131 having the shape shown in Fig. 7. That is, the outer shape of the lens structure 131 as viewed from the direction (Z direction) perpendicular to the first main surface 101a does not necessarily need to completely match the outer shape of the light-blocking structure 141 as viewed from the same direction (Z direction) as long as it is similar to the outer shape of the light-blocking structure 141 and the center of gravity matches the center of gravity of the light-blocking structure 141.

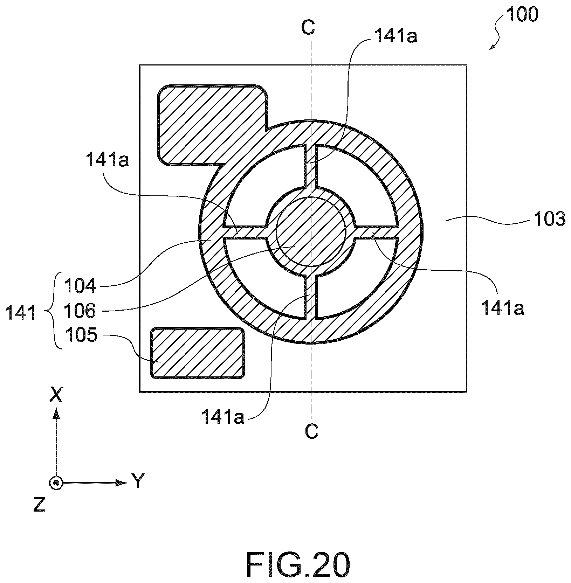

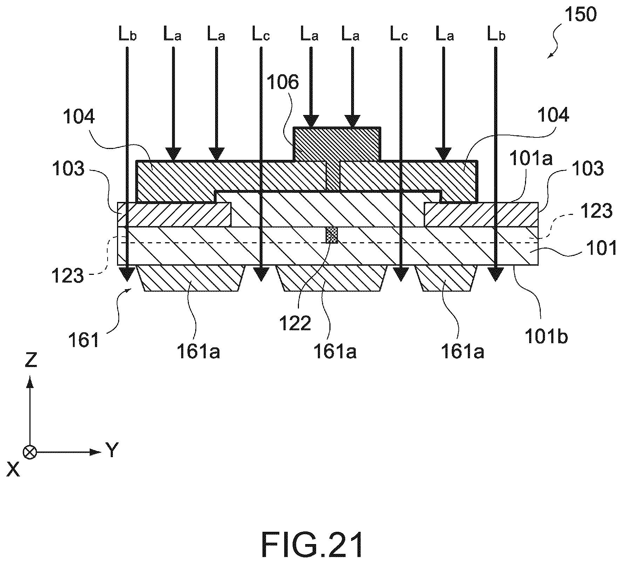

Fig. 20 is a schematic diagram showing the light-blocking structure 141 having another shape, which is included in the light-emitting device 100, and is a plan view of the light-emitting device 100 as viewed from the direction (Z direction) perpendicular to the first main surface 101a. Fig. 21 is a schematic diagram showing a method of forming the lens structure 131 using this light-blocking structure 141, and is a cross-sectional view taken along the line C-C in Fig. 20. As shown in Fig. 20 and Fig. 21, the light-blocking structure 141 may include a beam portion 141a having a narrow width.

In this case, the patten of the non-denatured region 161a can be refrained from reflecting the shape of the beam portion 141a, by causing light diffraction during exposure. In Fig. 21, the light that enters the beam portion 141a is indicated as a light beam L_{c}. By causing light diffraction during exposure, the light beam L_{c} can be caused to enter the photosensitive layer 161 to form the non-denatured region 161a that does not reflect the shape of the beam portion 141a as shown in the figure. Note that whether or not light diffraction occurs during exposure can be controlled by the width of the beam portion 141a and the amount of light.

In this way, the non-denatured region 161a having the shape shown in Fig. 15 can be formed. Further, this non-denatured region 161a can be used to form the lens structure 131 having the shape shown in Fig. 7. That is, the outer shape of the lens structure 131 as viewed from the direction (Z direction) perpendicular to the first main surface 101a does not necessarily need to completely match the outer shape of the light-blocking structure 141 as viewed from the same direction (Z direction) as long as the outer shape as viewed from the same direction (Z direction) is a Fourier transformation shape of the outer shape of the light-blocking structure 141 as viewed from the same direction (Z direction) and the center of gravity matches the center of gravity of the light-blocking structure 141.

### [Regarding back surface emitting structure]

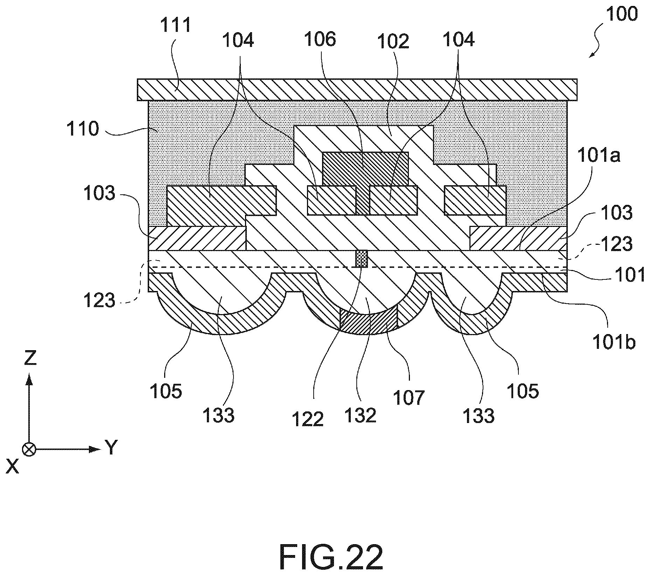

Although the light-emitting device 100 has been descried as having a front surface emitting structure that emits light from the side of the first main surface 101a of the substrate 101, it may have a back surface emitting structure that emits light from the side of the second main surface 101b of the substrate 101. Fig. 22 is a cross-sectional view of the light-emitting device 100 having a back surface emitting structure. As shown in the figure, in this light-emitting device 100, the lower light-reflecting layer 107 is provided only on the lens 132, and the lower electrode 105 is provided around the lower light-reflecting layer 107. Further, a support substrate 111 is joined to the side of the first main surface 101a of the substrate 101 with a conductive paste 110. Other configurations are the same as those of the light-emitting device 100 of a front surface emitting type.

In this configuration, when a voltage is applied to the upper electrode 104 and the lower electrode 105, the light generated in the active layer 121 (see Fig. 4) causes laser oscillation between the upper light-reflecting layer 106 and the lower light-reflecting layer 107, and a laser beam is transmitted through the lower light-reflecting layer 107 and emitted from the light-emitting device 100.

### [Regarding other structures of light-emitting device]

Although the light-emitting device 100 has been described above as a VCSEL device, the light-emitting device 100 may be a light-emitting device other than the VCSEL device, and the present technology is applicable to a light-emitting device having a structure corresponding to the light-blocking structure 141 and the lens structure 131.

### [Regarding Examples]

Specific Examples of the light-emitting device according to this embodiment will be described. Note that in each Example, the same configurations as those of the light-emitting device 100 will be denoted by the same reference symbols as those in the light-emitting device 100, and description thereof will be omitted.

### <Example 1>

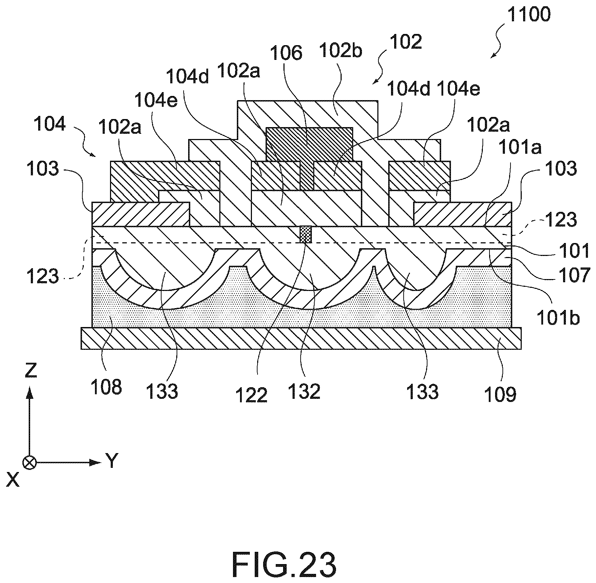

Fig. 23 is a cross-sectional view of a light-emitting device 1100 according to an Example 1. As shown in the figure, the light-emitting device 1100 includes the transparent conductive layer 102 including a first transparent conductive layer 102a and a second transparent conductive layer 102b. Further, the light-emitting device 1100 includes the upper electrode 104 including a first upper electrode 104d and a second upper electrode 104e.

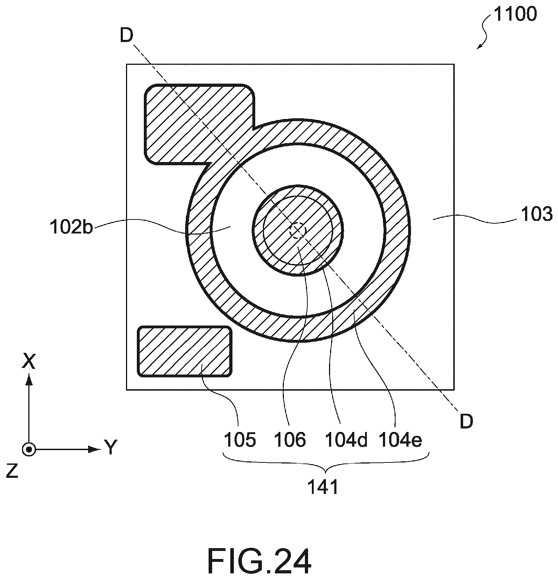

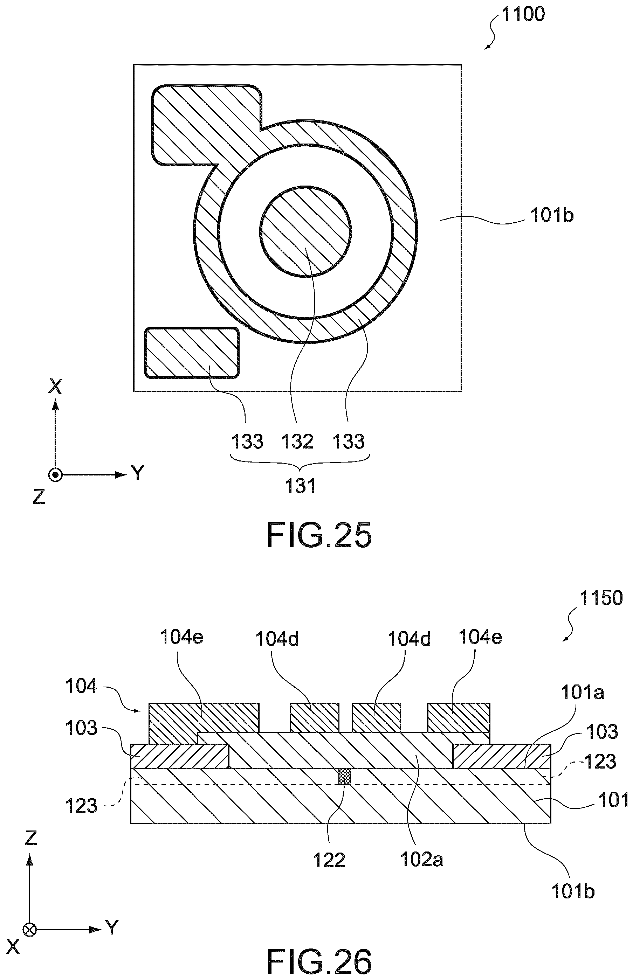

Fig. 24 is a schematic diagram showing the light-blocking structure 141 included in the light-emitting device 1100, and is a plan view of the light-blocking structure 141 as viewed from the direction (Z direction) perpendicular to the first main surface 101a. As shown in the figure, in the light-emitting device 1100, the light-blocking structure 141 includes the upper electrode 104, the lower electrode 105, and the upper light-reflecting layer 106. Fig. 25 is a schematic diagram showing the lens structure 131 included in the light-emitting device 1100, and is a plan view of the lens structure 131 as viewed from the direction (Z direction) perpendicular to the first main surface 101a. Note that Fig. 23 is a cross-sectional view taken along the line D-D in Fig. 24.

As shown in Fig. 24 and Fig. 25, the outer shape of the lens structure 131 as viewed from the direction (Z direction) perpendicular to the first main surface 101a is similar to the outer shape of the light-blocking structure 141 as viewed from the same direction (Z direction) and the center of gravity as viewed from the direction perpendicular to the first main surface 101a matches the center of gravity of the light-blocking structure 141 as viewed from the same direction (Z direction).

Fig. 26 to Fig. 34 are each a schematic diagram showing a method of producing the light-emitting device 1100. As shown in Fig. 26, the current injection region 122 and the insulation region 123 are formed in the substrate 101 to form a light-emitting device 1150. Further, the insulation layer 103 having a certain aperture ratio is formed on the first main surface 101a, and the first transparent conductive layer 102a is formed on the first main surface 101a and the insulation layer 103. Further, the first upper electrode 104d having a certain opening diameter and the second upper electrode 104e having a certain opening diameter are formed thereon. The first upper electrode 104d and the second upper electrode 104e are electrically connected to each other via the first transparent conductive layer 102a. The gap between the first upper electrode 104d and the second upper electrode 104e is, for example, 10 µm, and the outer diameter of the first upper electrode 104d is, for example, 30 µm.

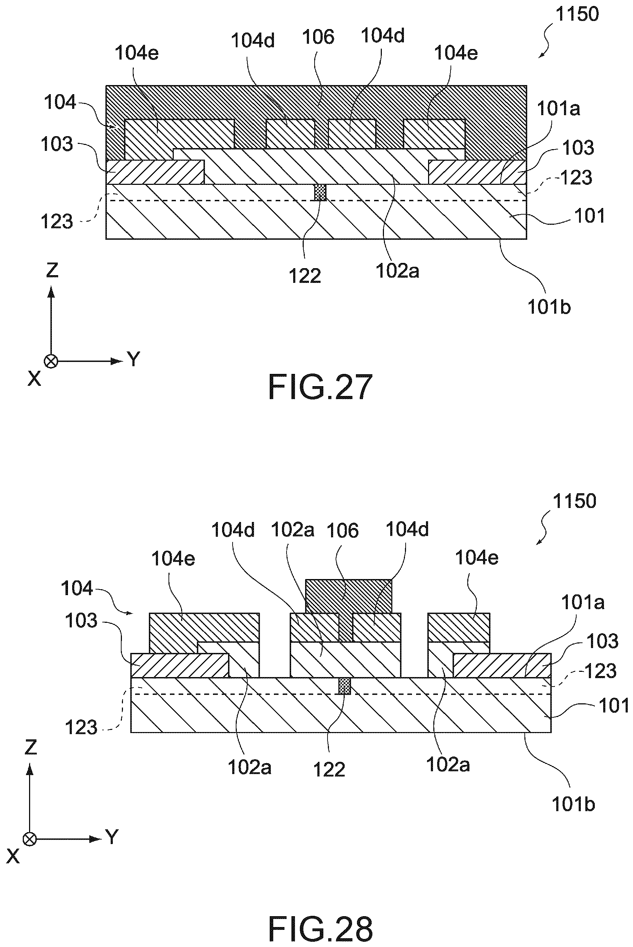

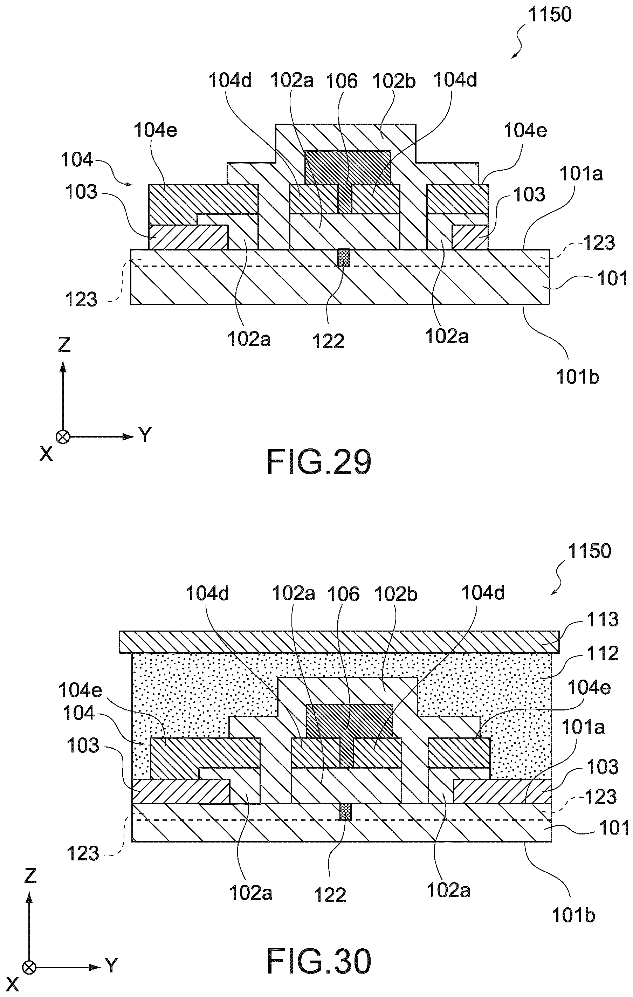

Subsequently, as shown in Fig. 27, the upper light-reflecting layer 106 is formed thereon. After that, as shown in Fig. 28, part of the upper light-reflecting layer 106 is removed by dry etching to separate the upper light-reflecting layer 106 and the second upper electrode 104e from each other. Since the first transparent conductive layer 102a that connects the first upper electrode 104d and the second upper electrode 104e to each other is also removed by this dry etching, the second transparent conductive layer 102b is formed as shown in Fig. 29 to connect the first upper electrode 104d and the second upper electrode 104e to each other again.

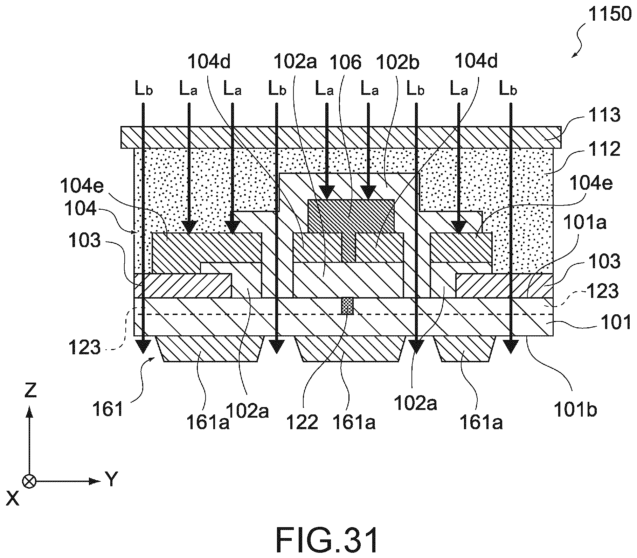

Subsequently, as shown in Fig. 30, a wax 112 is applied to the side of the first main surface 101a of the substrate 101 and bonded to the support substrate 113. Further, the second main surface 101b is ground by a grinding device to reduce the thickness of the second main surface 101b. The thickness of the substrate 101 after the thickness reduction is, for example, 30 µm. Subsequently, the photosensitive layer 161 is formed on the second main surface 101b, and exposure is performed from the side of the first main surface 101a as shown in Fig. 31. The light beam Lₐ is blocked by the light-blocking structure 141 (see Fig. 24), and the light L_{b} forms a denatured region in the photosensitive layer 161. The denatured region is removed by etching, and the pattern of the photosensitive layer 161 including the non-denatured region 161a is formed as shown in Fig. 31.

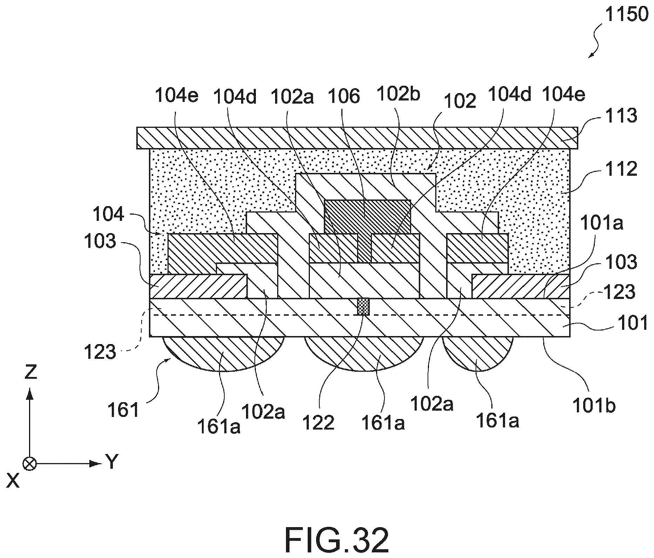

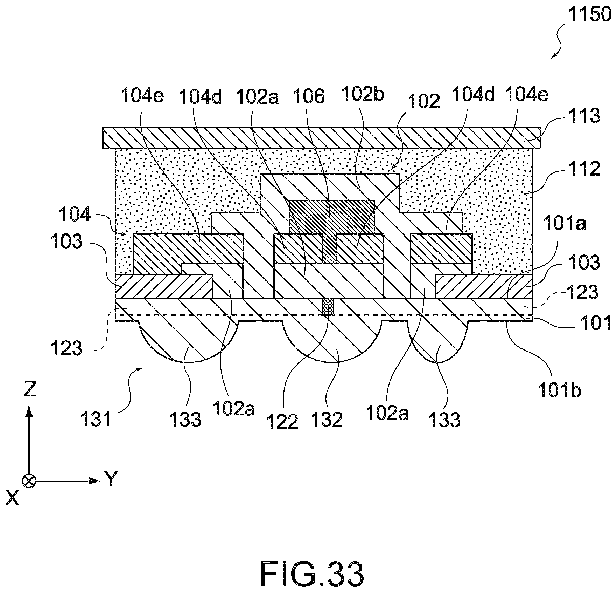

Subsequently, the photosensitive layer 161 is heated and reflowed to ball up the photosensitive layer 161 as shown in Fig. 32. As a result, the photosensitive layer 161 has a shape having a predetermined radius of curvature. This radius of curvature is, for example, 50 µm. Subsequently, this balled-up photosensitive layer 161 is used to form the lens structure 131 as shown in Fig. 33. The lens structure 131 can be formed by etching the substrate 101 using the balled-up photosensitive layer 161 as an etching mask. Further, the balled-up photosensitive layer 161 may be used as the lens structure 131.

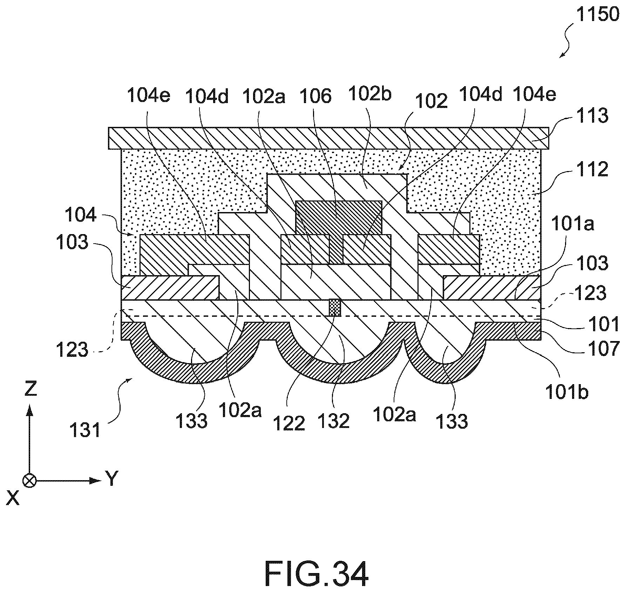

Subsequently, as shown in Fig. 34, the lower light-reflecting layer 107 is formed on the lens structure 131. Further, the support substrate 109 is joined to the lower light-reflecting layer 107 with the wax 108 (see Fig. 23), and the wax 112 and the support substrate 113 are removed. This exposes the light-emitting surface. In this way, the light-emitting device 1100 (see Fig. 23) can be produced.

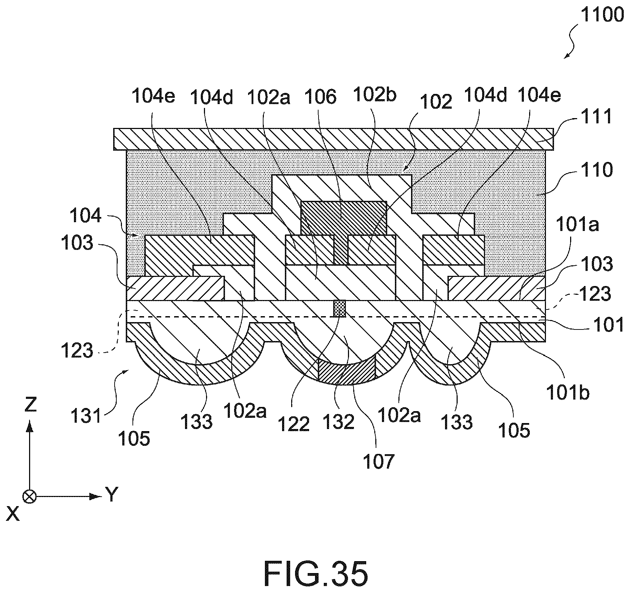

Note that although the above-mentioned light-emitting device 1100 has a front surface emitting structure, the light-emitting device 1100 may have a back surface emitting structure. Fig. 35 is a cross-sectional view of the light-emitting device 1100 having a back surface emitting structure. As shown in the figure, in this light-emitting device 1100, the lower light-reflecting layer 107 is provided only on the lens 132, and the lower electrode 105 is provided around the lower light-reflecting layer 107. Further, the support substrate 111 is bonded to the side of the first main surface 101a of the substrate 101 with the conductive paste 110. The other configurations are the same as those of the light-emitting device 1100 of a front surface emitting type.

In the light-emitting device 1100 according to the Example 1, since the light-blocking structure 141 is used to form the lens structure 131 as described above, it is possible to align the lens 132 and the current injection region 122 with high accuracy and improve the electrical properties of the light-emitting device 100, the optical properties, and yield.

### <Example 2>

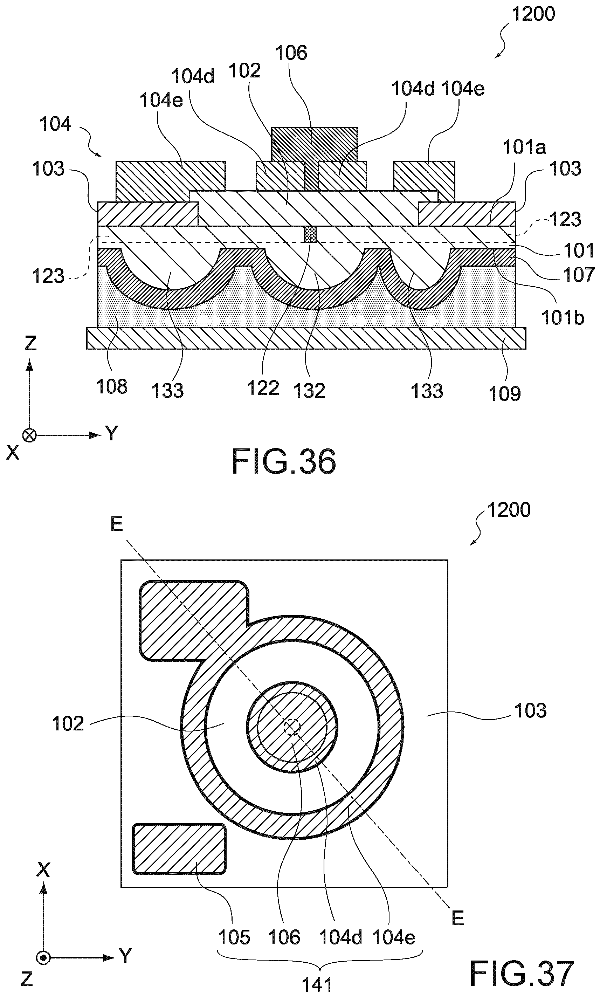

An Example 2 is a modified example of the Example 1. Fig. 36 is a cross-sectional view of a light-emitting device 1200 according to the Example 2. As shown in the figure, the light-emitting device 1200 includes the upper electrode 104 including the first upper electrode 104d and the second upper electrode 104e.

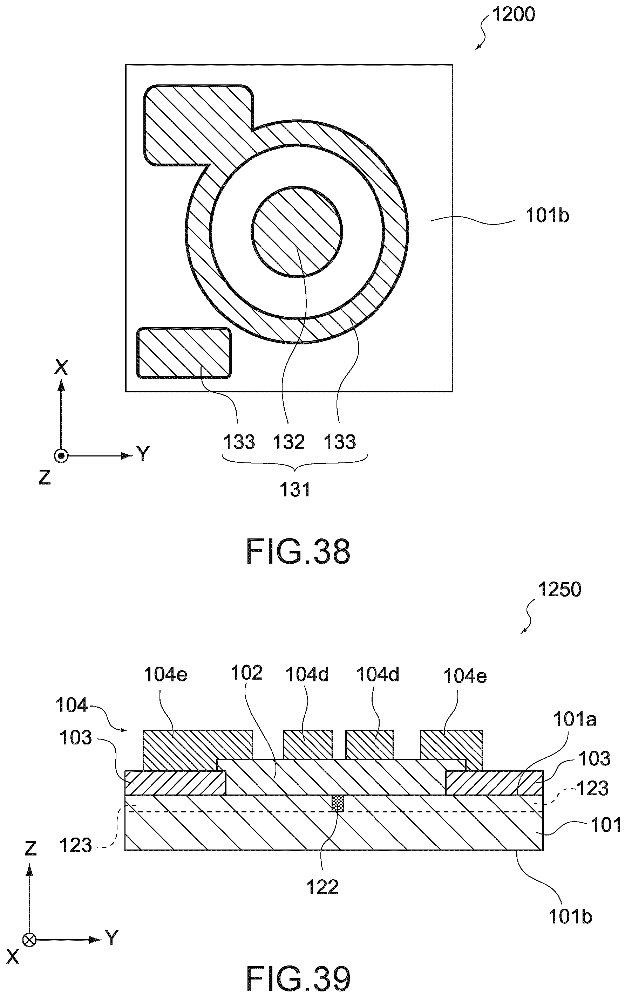

Fig. 37 is a schematic diagram showing the light-blocking structure 141 included in the light-emitting device 1200, and is a plan view of the light-blocking structure 141 as viewed from the direction (Z direction) perpendicular to the first main surface 101a. As shown in the figure, in the light-emitting device 1200, the light-blocking structure 141 includes the upper electrode 104, the lower electrode 105, and the upper light-reflecting layer 106. Fig. 38 is a schematic diagram showing the lens structure 131 included in the light-emitting device 1200, and is a plan view of the lens structure 131 as viewed from the direction (Z direction) perpendicular to the first main surface 101a. Note that Fig. 36 is a cross-sectional view taken along the line E-E in Fig. 37.

As shown in Fig. 37 and Fig. 38, the outer shape of the lens structure 131 as viewed from the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

Fig. 39 to Fig. 45 are each a schematic diagram showing a method of producing the light-emitting device 1200. As shown in Fig. 39, the current injection region 122 and the insulation region 123 are formed in the substrate 101 to form a light-emitting device 1250. Further, the insulation layer 103 having a certain aperture ratio is formed on the first main surface 101a, and the transparent conductive layer 102 is formed on the first main surface 101a and the insulation layer 103. Further, the first upper electrode 104d having a certain opening diameter and the second upper electrode 104e having a certain opening diameter are formed thereon. The first upper electrode 104d and the second upper electrode 104e are electrically connected to each other via the transparent conductive layer 102. The gap between the first upper electrode 104d and the second upper electrode 104e is, for example, 10 µm, and the outer diameter of the first upper electrode 104d is, for example, 30 µm.

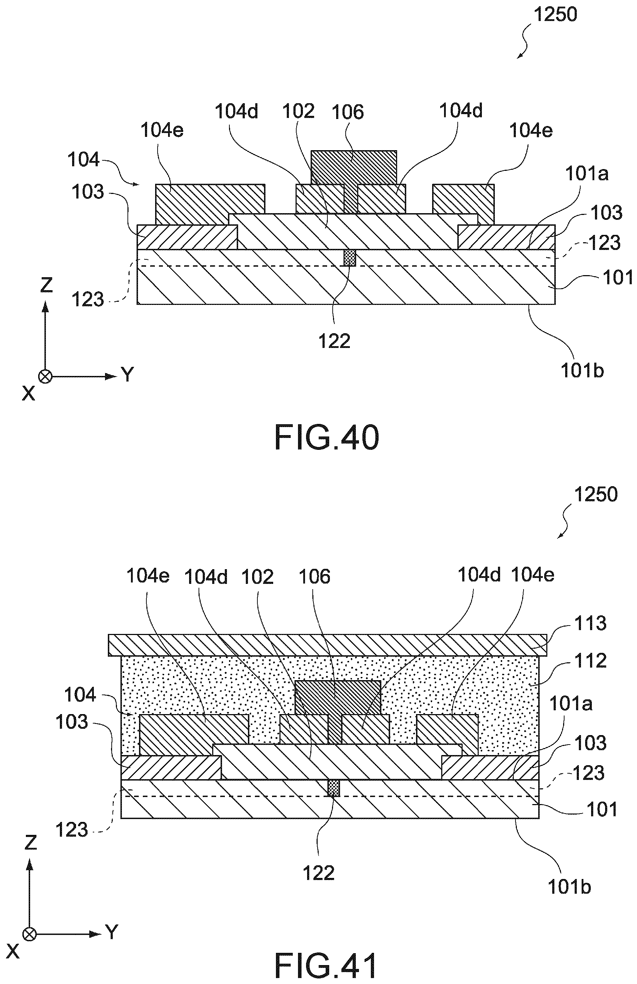

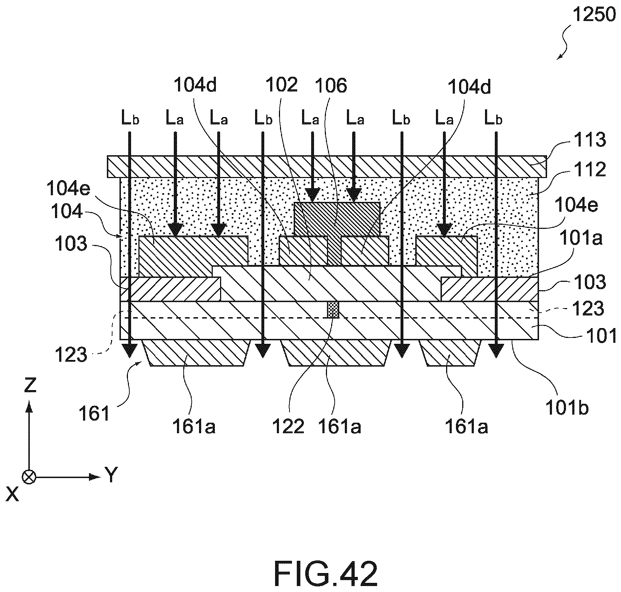

Subsequently, as shown in Fig. 40, the upper light-reflecting layer 106 is formed thereon by lift-off. Subsequently, as shown in Fig. 41, the wax 112 is applied to the side of the first main surface 101a of the substrate 101 and bonded to the support substrate 113. Further, the second main surface 101b is ground by a grinding device to reduce the thickness of the second main surface 101b. The thickness of the substrate 101 after the thickness reduction is, for example, 30 µm. Subsequently, the photosensitive layer 161 is formed on the second main surface 101b, and exposure is performed from the side of the first main surface 101a as shown in Fig. 42. The light beam Lₐ is blocked by the light-blocking structure 141 (see Fig. 37), and the light L_{b} forms a denatured region in the photosensitive layer 161. The denatured region is removed by etching, and the pattern of the photosensitive layer 161 including the non-denatured region 161a is formed as shown in Fig. 42.

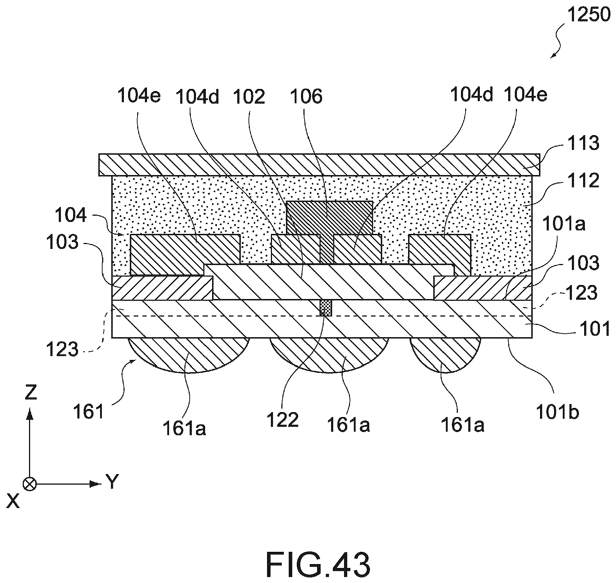

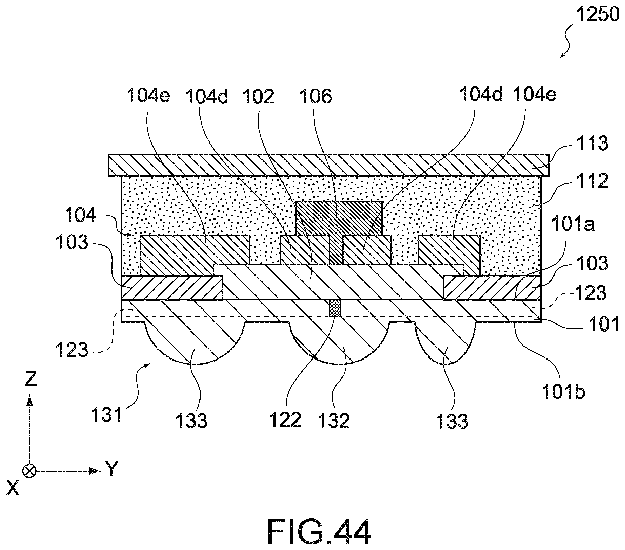

Subsequently, the photosensitive layer 161 is heated and reflowed to ball up the photosensitive layer 161 as shown in Fig. 43. As a result, the photosensitive layer 161 has a shape having a predetermined radius of curvature. This radius of curvature is, for example, 50 µm. Subsequently, the balled-up photosensitive layer 161 is used to form the lens structure 131 as shown in Fig. 44. The lens structure 131 can be formed by etching the substrate 101 using the balled-up photosensitive layer 161 as an etching mask. Further, the balled-up photosensitive layer 161 may be used as the lens structure 131.

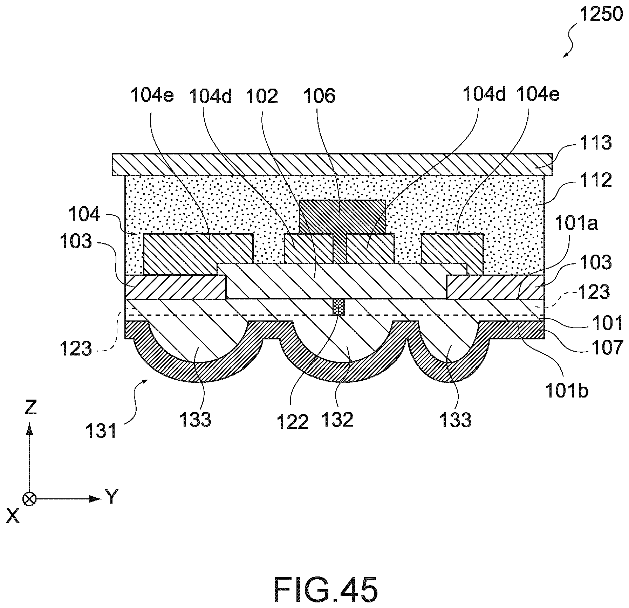

Subsequently, as shown in Fig. 45, the lower light-reflecting layer 107 is formed on the lens structure 131. Further, the support substrate 109 is joined to the lower light-reflecting layer 107 with the wax 108 (see Fig. 36), and the wax 112 and the support substrate 113 are removed. This exposes the light-emitting surface. In this way, the light-emitting device 1200 (see Fig. 36) can be produced.

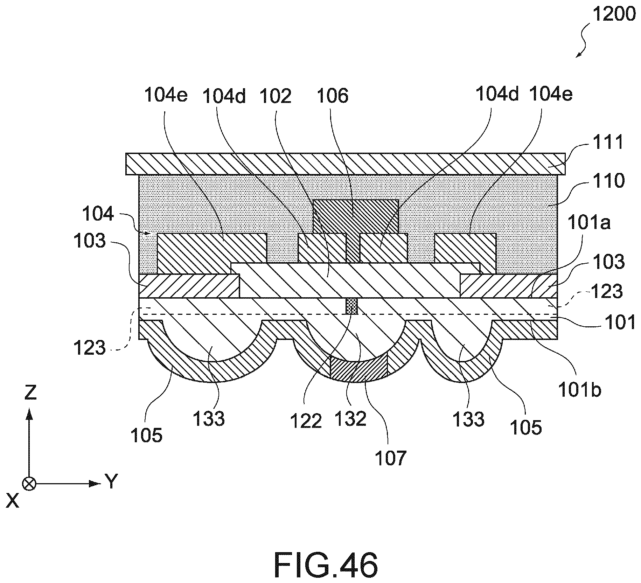

Note that although the above-mentioned light-emitting device 1200 has a front surface emitting structure, the light-emitting device 1200 may have a back surface emitting structure. Fig. 46 is a cross-sectional view of the light-emitting device 1200 having a back surface emitting structure. As shown in the figure, in this light-emitting device 1200, the lower light-reflecting layer 107 is provided only on the lens 132, and the lower electrode 105 is provided around the lower light-reflecting layer 107. Further, the support substrate 111 is bonded to the side of the first main surface 101a of the substrate 101 with the conductive paste 110. The other configurations are the same as those of the light-emitting device 1200 of a front surface emitting type.

In the light-emitting device 1200 according to the Example 2, since the light-blocking structure 141 is used to form the lens structure 131 as described above, it is possible to align the lens 132 and the current injection region 122 with high accuracy. Further, since the upper light-reflecting layer 106 is formed by lift-off, the patterning of the upper light-reflecting layer 106 does not damage the transparent conductive layer 102, and it is possible to improve the electrical properties and yield. Further, since the process of patterning the upper light-reflecting layer 106 and the subsequent process of forming the transparent conductive layer 102 are unnecessary, it is possible to reduce the production cost.

### <Example 3>

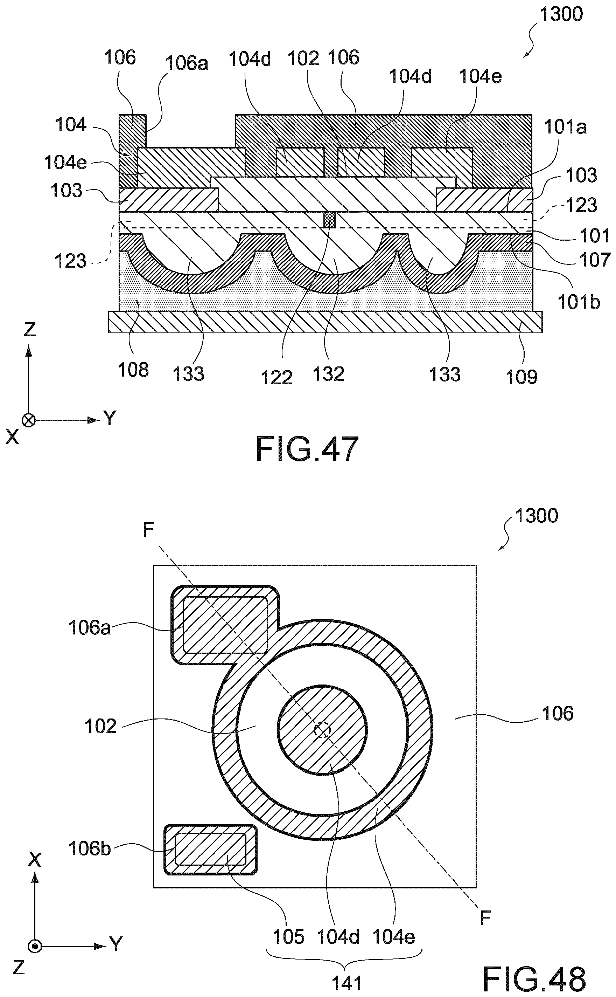

An Example 3 is a modified example of the Example 1. Fig. 47 is a cross-sectional view of a light-emitting device 1300 according to the Example 3. As shown in the figure, the light-emitting device 1300 includes the upper electrode 104 including the first upper electrode 104d and the second upper electrode 104e. Further, the light-emitting device 1300 includes he upper light-reflecting layer 106 in which an opening 106a and an opening 106b (see Fig. 48) are provided.

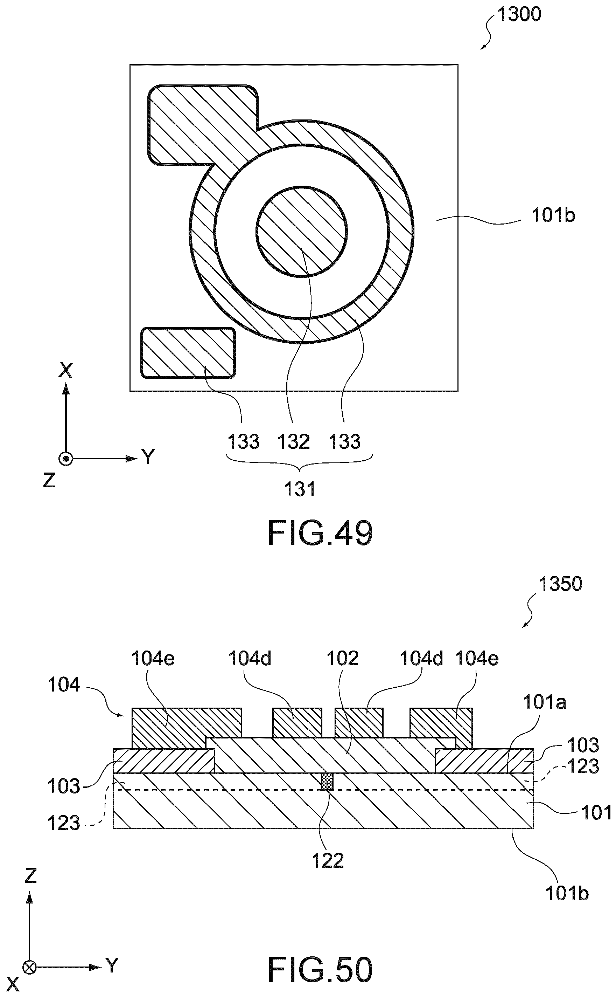

Fig. 48 is a schematic diagram showing the light-blocking structure 141 including the light-emitting device 1300, and is a plan view of the light-blocking structure 141 as viewed from the direction (Z direction) perpendicular to the first main surface 101a. As shown in the figure, in the light-emitting device 1300, the light-blocking structure 141 includes the upper electrode 104 and the lower electrode 105. Fig. 49 is a schematic diagram showing the lens structure 131 included in the light-emitting device 1300, and is a plan view of the lens structure 131 as viewed from the direction (Z direction) perpendicular to the first main surface 101a. Note that Fig. 47 is a cross-sectional view taken along the line F-F in Fig. 48.

As shown in Fig. 48 and Fig. 49, the outer shape of the lens structure 131 as viewed from the direction (Z direction) perpendicular to the first main surface 101a is similar to the outer shape of the light-blocking structure 141 as viewed from the same direction (Z direction) and the center of gravity as viewed from the same direction (Z direction) matches the center of gravity of the light-blocking structure 141 as viewed from the same direction (Z direction).

Fig. 50 to Fig. 56 are each a schematic diagram showing a method of producing the light-emitting device 1300. As shown in Fig. 50, the current injection region 122 and the insulation region 123 are formed in the substrate 101 to form a light-emitting device 1350. Further, the insulation layer 103 having a certain aperture ratio is formed on the first main surface 101a, and the transparent conductive layer 102 is formed on the first main surface 101a and the insulation layer 103. Further, the first upper electrode 104d having a certain opening diameter and the second upper electrode 104e having a certain opening diameter are formed thereon. The first upper electrode 104d and the second upper electrode 104e are electrically connected each other via the transparent conductive layer 102. The gap between the first upper electrode 104d and the second upper electrode 104e is, for example, 10 µm, and the outer diameter of the first upper electrode 104d is, for example, 30 um.

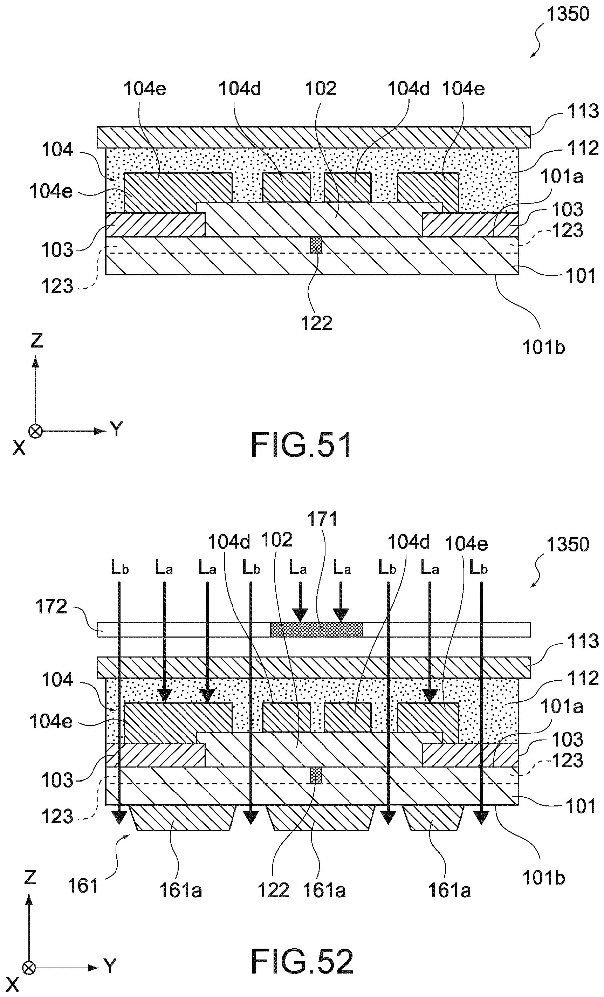

Subsequently, as shown in Fig. 51, the wax 112 is applied to the side of the first main surface 101a of the substrate 101 and bonded to the support substrate 113. Further, the second main surface 101b is ground by a grinding device to reduce the thickness of the second main surface 101b. The thickness of the substrate 101 after the thickness reduction is, for example, 30 µm. Subsequently, the photosensitive layer 161 is formed on the second main surface 101b, and exposure is performed from the side of the first main surface 101a as shown in Fig. 52. At this time, the photomask 172 having the light-blocking region 171 is disposed on the side of the first main surface 101a of the light-emitting device 1350, and light is applied via the photomask 172. The light-blocking region 171 is provided so as to shield the current injection region 122 from light. The light beam Lₐ is blocked by the light-blocking structure 141 (see Fig. 49) and the light-blocking region 171, and the light L_{b} forms a denatured region in the photosensitive layer 161. The denatured region is removed by etching, and the pattern of the photosensitive layer 161 including the non-denatured region 161a is formed as shown in Fig. 52.

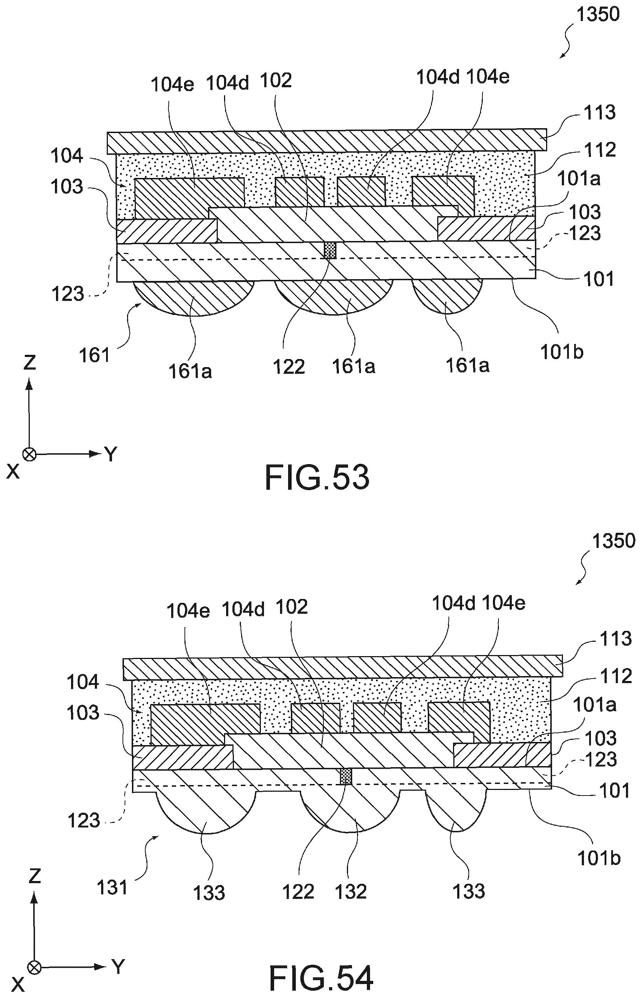

Subsequently, the photosensitive layer 161 is heated and reflowed to ball up the photosensitive layer 161 as shown in Fig. 53. As a result, the photosensitive layer 161 has a shape having a predetermined radius of curvature. This radius of curvature is, for example, 50 µm. Subsequently, the balled-up photosensitive layer 161 is used to form the lens structure 131 as shown in Fig. 54. The lens structure 131 can be formed by etching the substrate 101 using the balled-up photosensitive layer 161 as an etching mask. Further, the balled-up photosensitive layer 161 may be used as the lens structure 131.

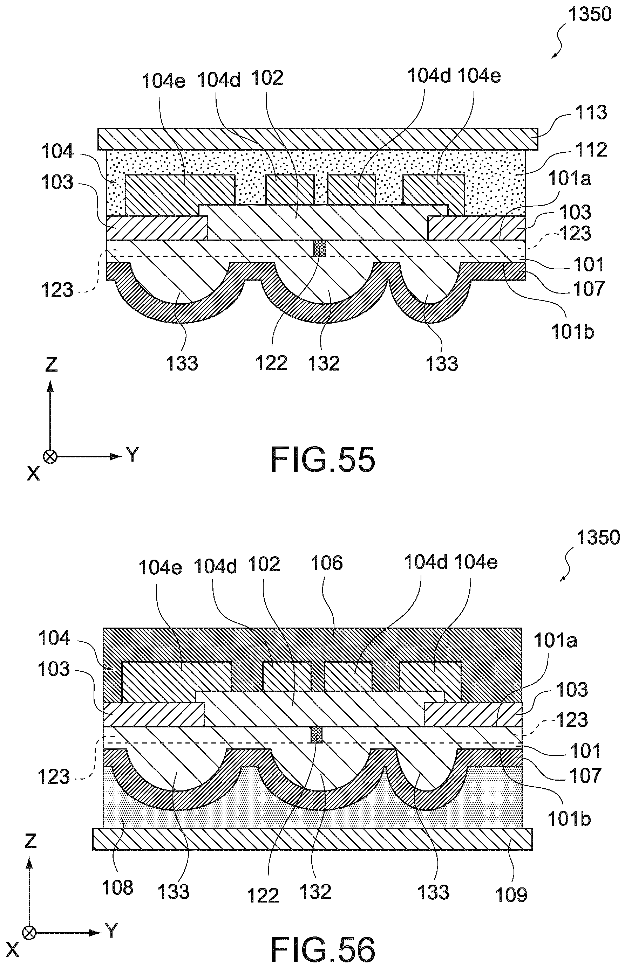

Subsequently, as shown in Fig. 55, the lower light-reflecting layer 107 is formed on the lens structure 131. Further, as shown in Fig. 56, the support substrate 109 is joined to the lower light-reflecting layer 107 with the wax 108 (see Fig. 47), and the wax 112 and the support substrate 113 are removed. This exposes the light-emitting surface. Subsequently, the opening 106a and the opening 106b (see Fig. 48) are formed in the upper light-reflecting layer 106. In this way, the light-emitting device 1300 (see Fig. 47) can be produced.

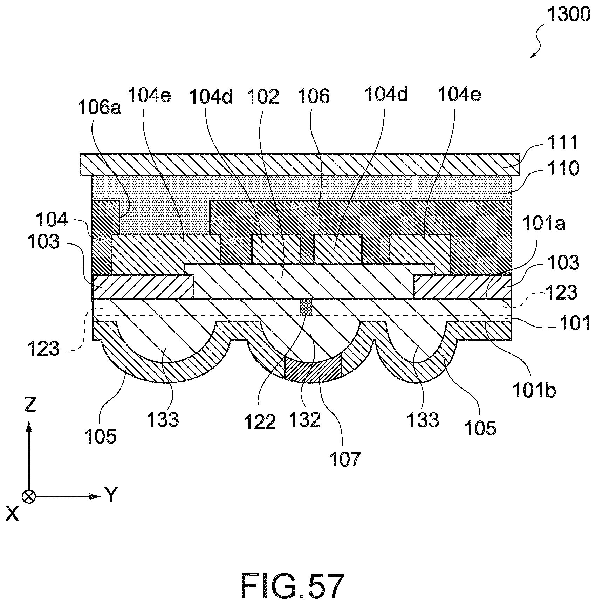

Note that although the above-mentioned light-emitting device 1300 has a front surface emitting structure, the light-emitting device 1300 may have a back surface emitting structure. Fig. 57 is a cross-sectional view of the light-emitting device 1300 having a back surface emitting structure. As shown in the figure, in this light-emitting device 1300, the lower light-reflecting layer 107 is provided on the lens 132, and the lower electrode 105 is provided around the lower light-reflecting layer 107. Further, the support substrate 111 is bonded to the side of the first main surface 101a of the substrate 101 with the conductive paste 110. The other configurations are the same as those of the light-emitting device 1300 of a front surface emitting type.

In the light-emitting device 1300 according to the Example 3, since the light-blocking structure 141 is used to form the lens structure 131 as described above, it is possible to align the lens 132 and the current injection region 122 with high accuracy. Further, since the upper light-reflecting layer 106 is formed after the exposure process, the patterning of the upper light-reflecting layer 106 does not damage the transparent conductive layer 102, and it is possible to improve the electrical properties and yield. Further, since the process of forming the transparent conductive layer 102 again is unnecessary, it is possible to reduce the production cost.

### <Example 4>

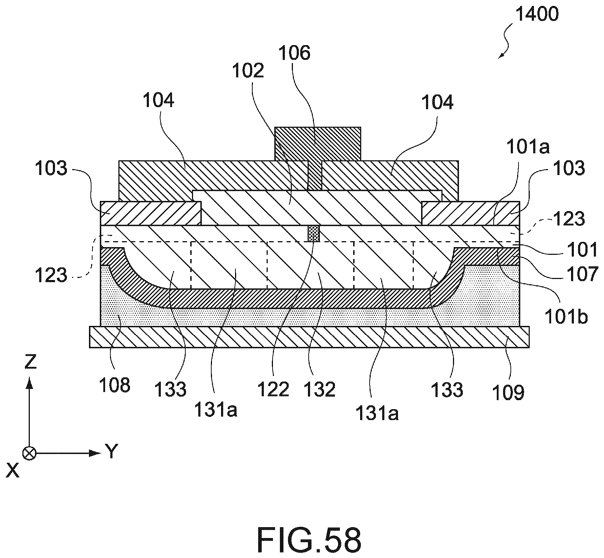

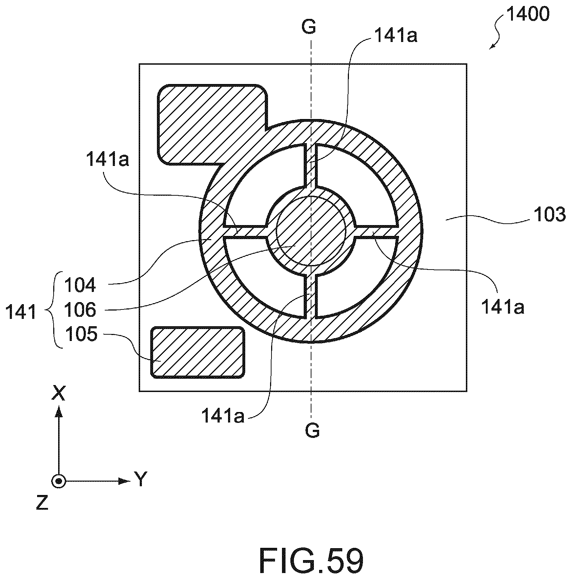

An Example 4 is a modified example of the Example 2. Fig. 58 is a cross-sectional view of a light-emitting device 1400 according to the Example 4. Fig. 59 is a schematic diagram showing the light-blocking structure 141 included in the light-emitting device 1400, and is a plan view of the light-blocking structure 141 as viewed from the direction (Z direction) perpendicular to the first main surface 101a. As shown in the figure, in the light-emitting device 1400, the light-blocking structure 141 includes the upper electrode 104, the lower electrode 105, and the upper light-reflecting layer 106. Further, the light-blocking structure 141 includes the beam portion 141a formed by the upper electrode 104.

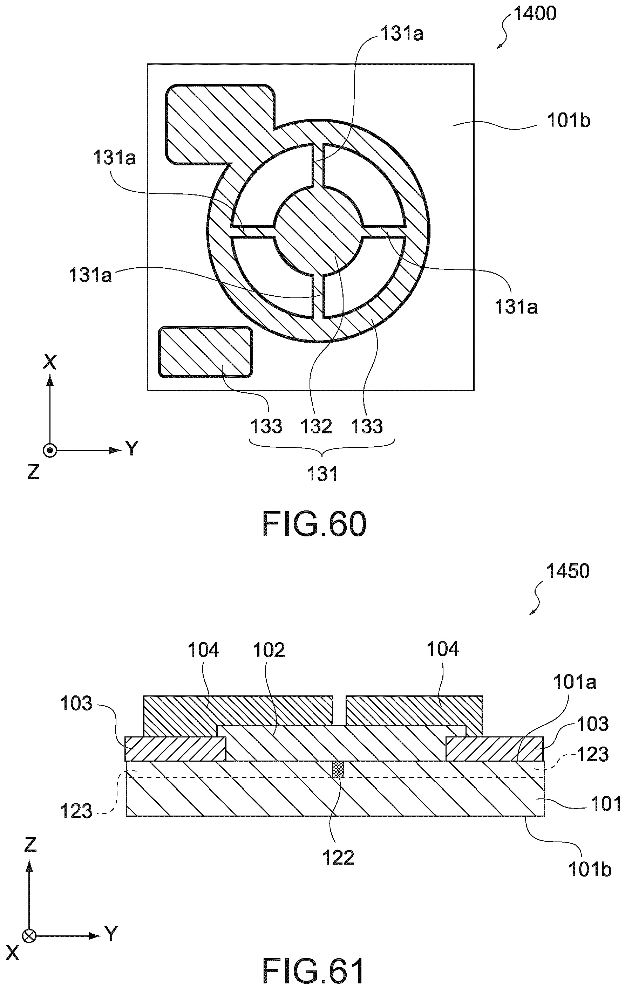

Fig. 60 is a schematic diagram showing the lens structure 131 included in the light-emitting device 1400, and is a plan view of the lens structure 131 as viewed from the direction (Z direction) perpendicular to the first main surface 101a. As shown in the figure, the lens structure 131 includes a beam portion 131a. Note that Fig. 58 is a cross-sectional view taken along the line G-G in Fig. 59.

As shown in Fig. 59 and Fig. 60, the outer shape of the lens structure 131 as viewed from the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

Fig. 61 to Fig. 68 are each a schematic diagram showing a method of producing the light-emitting device 1400. As shown in Fig. 61, the current injection region 122 and the insulation region 123 are formed in the substrate 101 to form a light-emitting device 1450. Further, the insulation layer 103 having a certain aperture ratio is formed on the first main surface 101a, and the transparent conductive layer 102 is formed on the first main surface 101a and the insulation layer 103. Further, the upper electrode 104 is formed thereon.

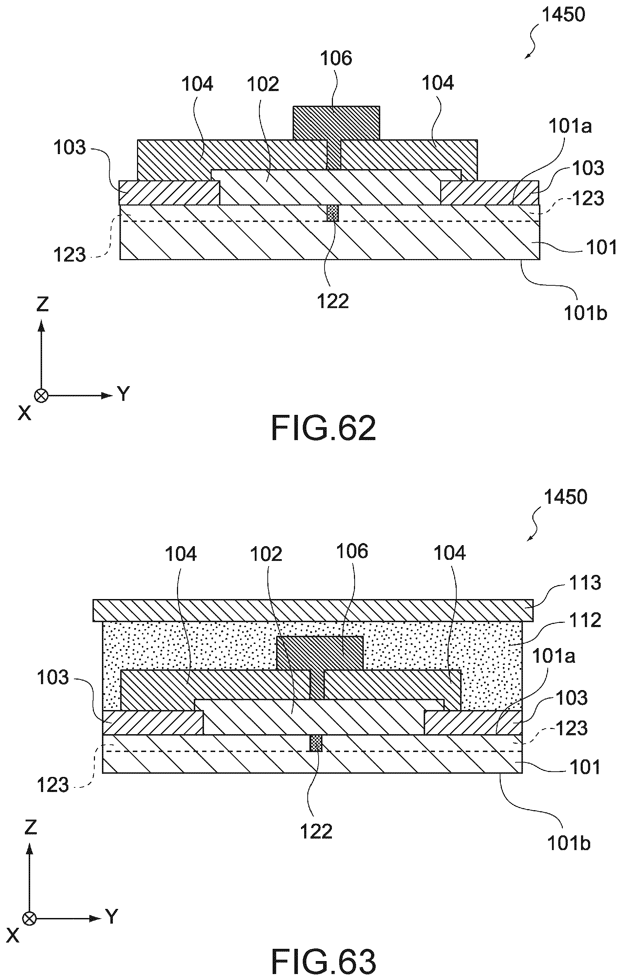

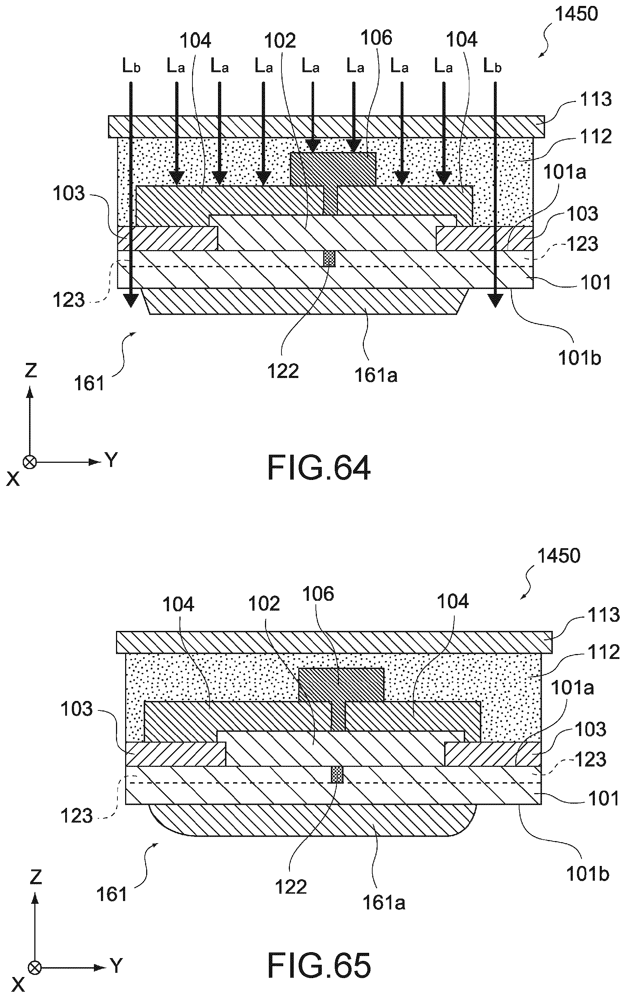

Subsequently, as shown in Fig. 62, the upper light-reflecting layer 106 is formed thereon by lift-off. Subsequently, as shown in Fig. 63, the wax 112 is applied to the side of the first main surface 101a of the substrate 101 and bonded to the support substrate 113. Further, the second main surface 101b is ground by a grinding device to reduce the thickness of the second main surface 101b. The thickness of the substrate 101 after the thickness reduction is, for example, 30 µm. Subsequently, the photosensitive layer 161 is formed on the second main surface 101b, and exposure is performed from the side of the first main surface 101a as shown in Fig. 64. The light beam Lₐ is blocked by the light-blocking structure 141 (see Fig. 59), and the light L_{b} forms a denatured region in the photosensitive layer 161. The denatured region is removed by etching, and the pattern of the photosensitive layer 161 including the non-denatured region 161a is formed as shown in Fig 64.

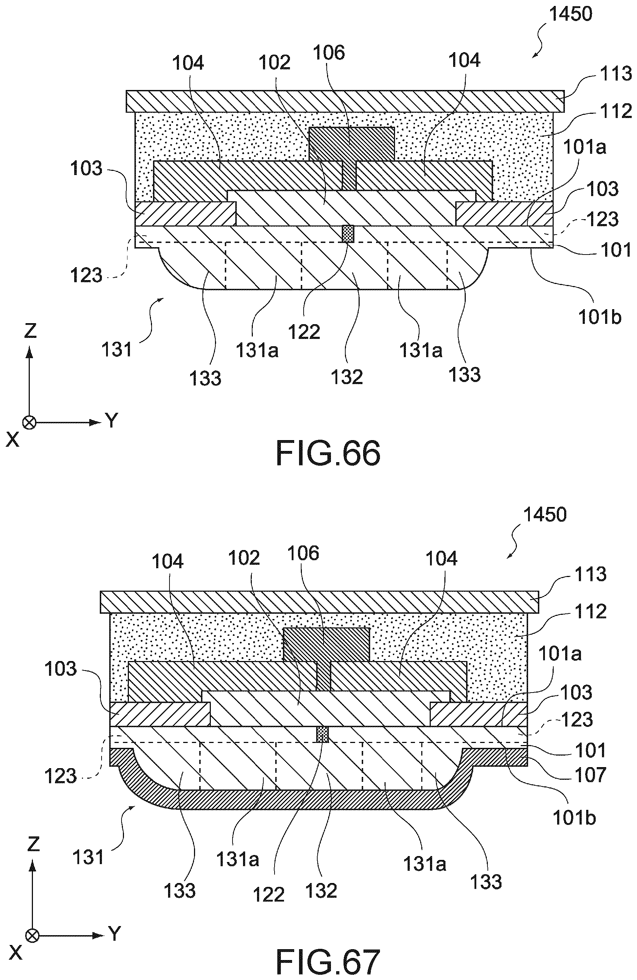

Subsequently, the photosensitive layer 161 is heated and reflowed to ball up the photosensitive layer 161 as shown in Fig. 65. As a result, the photosensitive layer 161 has a shape having a predetermined diameter. This radius of curvature is, for example, 50 µm. Subsequently, the balled-up photosensitive layer 161 is used to form the lens structure 131 as shown in Fig. 66. The lens structure 131 can be formed by etching the substrate 101 using the balled-up photosensitive layer 161 as an etching mask. Further, the balled-up photosensitive layer 161 may be used as the lens structure 131.

Subsequently, as shown in Fig. 67, the lower light-reflecting layer 107 is formed on the lens structure 131. Further, the support substrate 109 is joined to the lower light-reflecting layer 107 with the wax 108 (see Fig. 58), and the wax 112 and the support substrate 113 are removed. This exposes the light-emitting surface. In this way, the light-emitting device 1400 (see Fig. 58) can be produced.

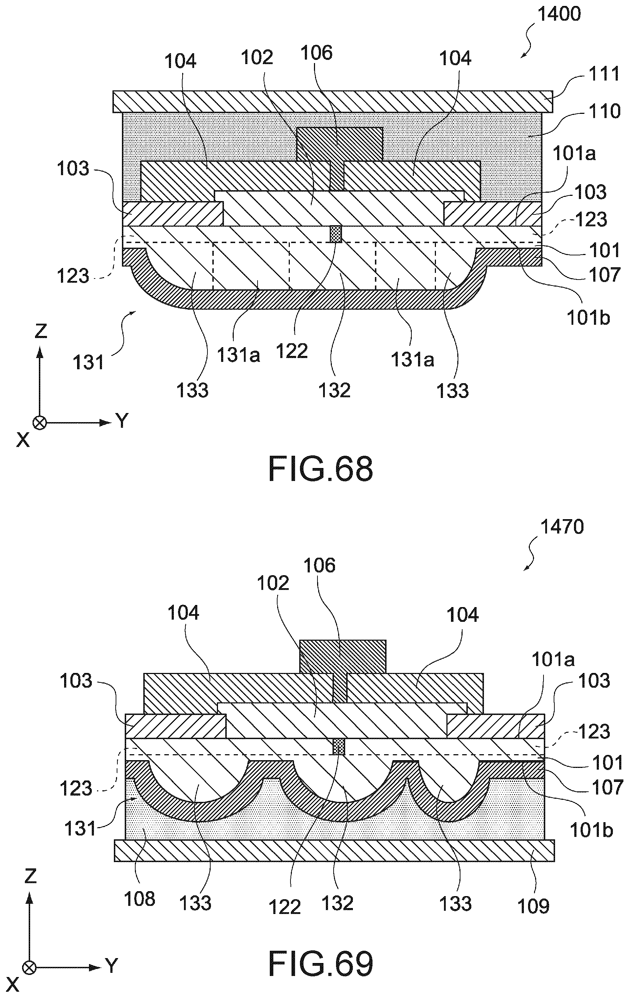

Note that although the above-mentioned light-emitting device 1400 has a front surface emitting structure, the light-emitting device 1400 may have a back surface emitting structure. Fig. 68 is a cross-sectional view of the light-emitting device 1400 having a back surface emitting structure. As shown in the figure, in this light-emitting device 1400, the support substrate 111 is bonded to the side of the first main surface 101a of the substrate 101 with the conductive paste 110. The other configurations are the same as those of the light-emitting device 1400 of a front surface emitting type.

In the light-emitting device 1400 according to the Example 4, since the light-blocking structure 141 is used to form the lens structure 131 as described above, it is possible to align the lens 132 and the current injection region 122 with high accuracy. Further, since the lens structure 131 includes the beam portion 131a, the current density of the transparent conductive layer 102 is reduced, and it is possible to improve the reliability and electrical properties. Further, since the radius of curvature of the lens 132 can be increased, it is possible to lower the order of the transverse mode.

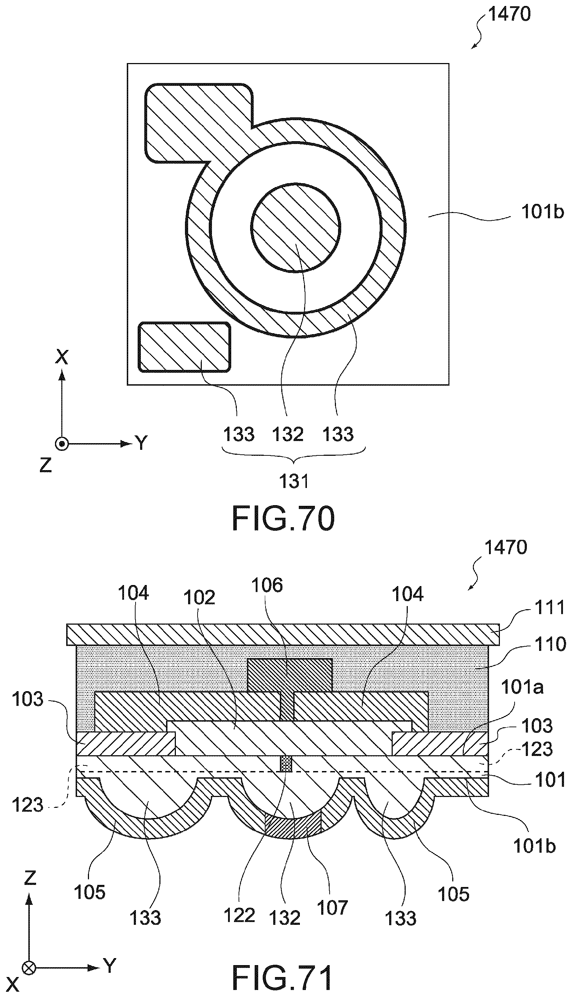

Further, in the light-emitting device 1400 according to the Example 4, by causing light diffraction during exposure, it is possible to prevent the lens structure 131 from reflecting the beam portion 141a of the light-blocking structure 141 (see Fig. 59). Fig. 69 is a cross-sectional view of a light-emitting device 1470 including this lens structure 131. Fig. 70 is a schematic diagram showing this lens structure 131, and is a plan view of the lens structure 131 as viewed from the direction (Z direction) perpendicular to the first main surface 101a. As shown in Fig. 59 and Fig. 70, the lens structure 131 does not necessarily need to include the beam portion 131a, and the outer shape thereof as viewed from the direction (Z direction) perpendicular to the first main surface 101a may be a Fourier transformation shape of the outer shape of the light-blocking structure 141 as viewed from the same direction (Z direction).

Fig. 71 is a cross-sectional view showing the light-emitting device 1470 having a back surface emitting structure. As shown in the figure, in the light-emitting device 1470 having a back surface emitting structure, the lower light-reflecting layer 107 is provided only on the lens 132, and the lower electrode 105 is provided around the lower light-reflecting layer 107. Further, the support substrate 111 is bonded to the side of the first main surface 101a of the substrate 101 with the conductive paste 110. The other configurations are the same as those of the light-emitting device 1470 of a front surface emitting type.

### <Example 5>

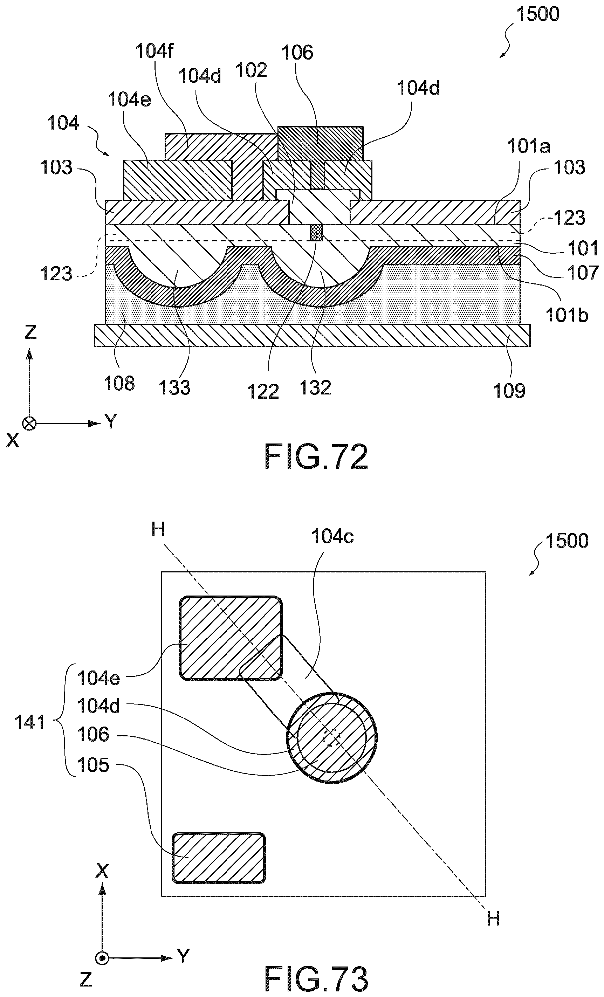

An Example 5 is a modified example of the Example 2. Fig. 72 is a cross-sectional view of a light-emitting device 1500 according to the Example 5. As shown in the figure, the light-emitting device 1500 includes the upper electrode 104 including the first upper electrode 104d, the second upper electrode 104e, and a third the upper electrode 104f.

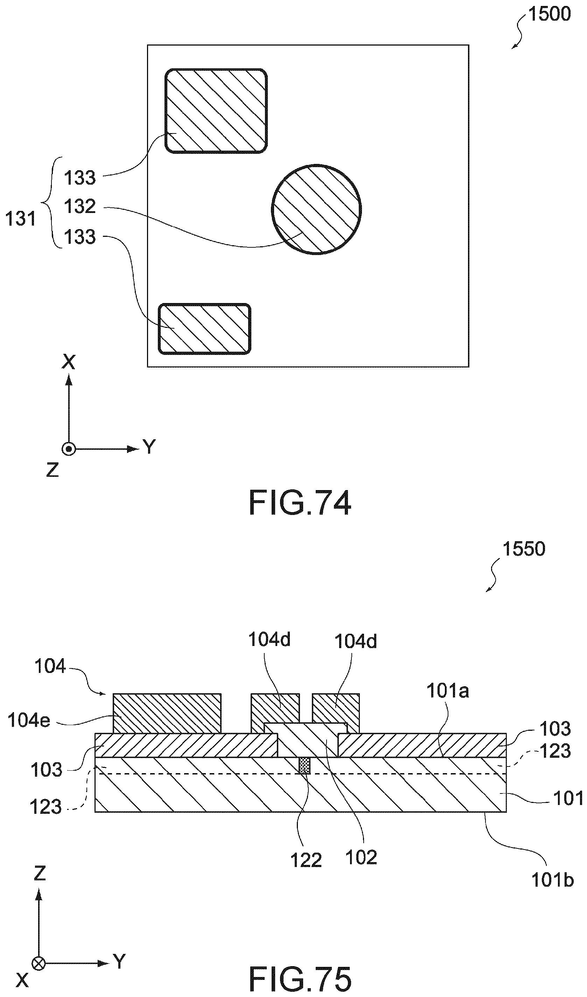

Fig. 73 is a schematic diagram showing the light-blocking structure 141 included in the light-emitting device 1500, and is a plan view of the light-blocking structure 141 as viewed from the direction (Z direction) perpendicular to the first main surface 101a. As shown in the figure, in the light-emitting device 1500, the light-blocking structure 141 includes the first upper electrode 104d, the second upper electrode 104e, the lower electrode 105, and the upper light-reflecting layer 106. Fig. 74 is a schematic diagram showing the lens structure 131 included in the light-emitting device 1500, and is a plan view of the lens structure 131 as viewed from the direction (Z direction) perpendicular to the first main surface 101a. Note that Fig. 72 is a cross-sectional view taken along the line H-H in Fig. 73.

As shown in Fig. 73 and Fig. 74, the outer shape of the lens structure 131 as viewed from the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

Fig. 75 to Fig. 82 are each a schematic diagram showing a method of producing the light-emitting device 1500. As shown in Fig. 75, the current injection region 122 and the insulation region 123 are formed in the substrate 101 to form a light-emitting device 1550. Further, the insulation layer 103 having a certain aperture ratio is formed on the first main surface 101a, and the transparent conductive layer 102 is formed on the first main surface 101a and the insulation layer 103. Further, the first upper electrode 104d and the second upper electrode 104e are formed thereon. The outer diameter of the first upper electrode 104d is, for example, 30 µm.

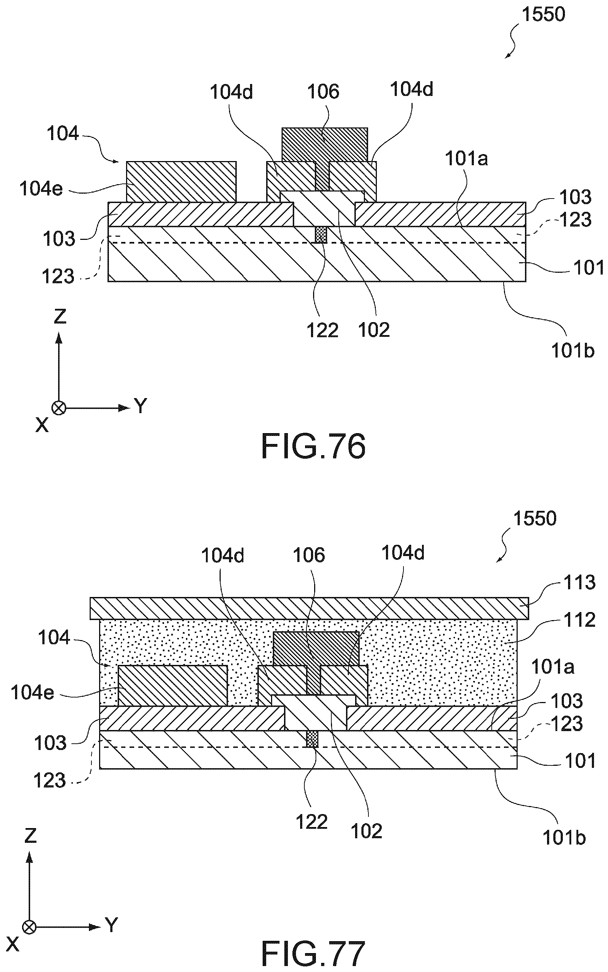

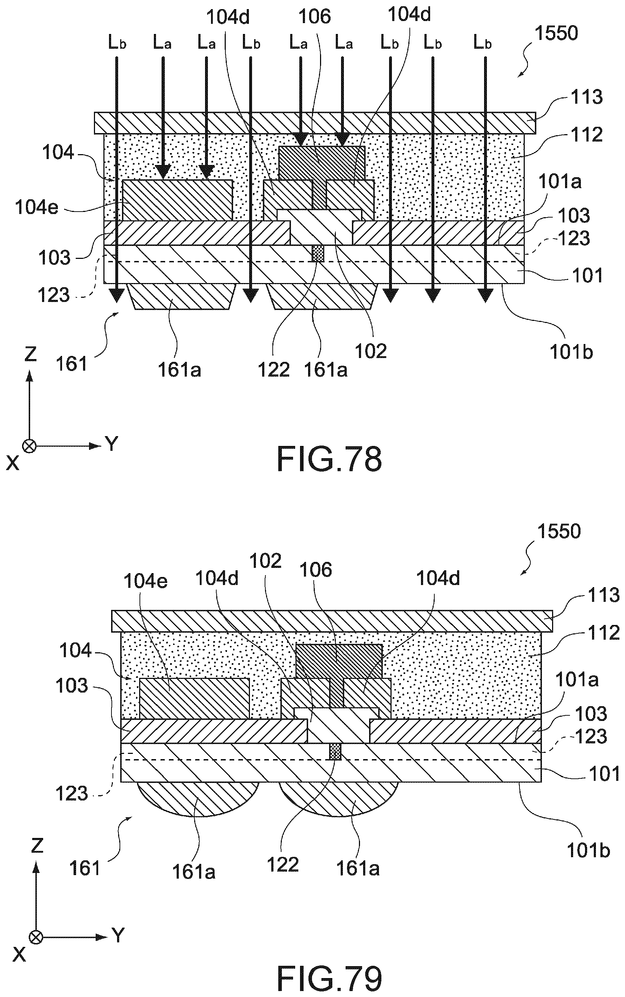

Subsequently, as shown in Fig. 76, the upper light-reflecting layer 106 is formed thereon by lift-off. Subsequently, as shown in Fig. 77, the wax 112 is applied to the side of the first main surface 101a of the substrate 101 and bonded to the support substrate 113. Further, the second main surface 101b is ground by a grinding device to reduce the thickness of the second main surface 101b. The thickness of the substrate 101 after the thickness reduction is, for example, 30 µm. Subsequently, the photosensitive layer 161 is formed on the second main surface 101b, and exposure is performed from the side of the first main surface 101a as shown in Fig. 78. The light beam Lₐ is blocked by the light-blocking structure 141 (see Fig. 73), and the light L_{b} forms a denatured region in the photosensitive layer 161. The denatured region is removed by etching, and the pattern of the photosensitive layer 161 including the non-denatured region 161a is formed as shown in Fig. 78.

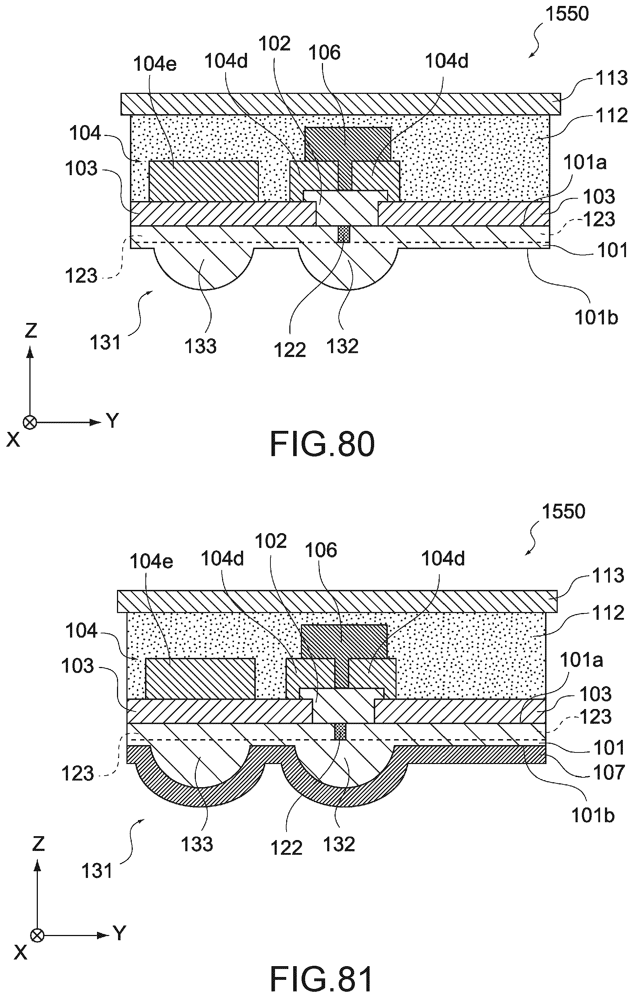

Subsequently, the photosensitive layer 161 is heated and reflowed to ball up the photosensitive layer 161 as shown in Fig. 79. As a result, the photosensitive layer 161 has a shape having a predetermined radius. This radius of curvature is, for example, 50 µm. Subsequently, the balled-up photosensitive layer 161 is used to form the lens structure 131 as shown in Fig. 80. The lens structure 131 can be formed by etching the substrate 101 using the balled-up photosensitive layer 161 as an etching mask. Further, the balled-up photosensitive layer 161 may be used as the lens structure 131.

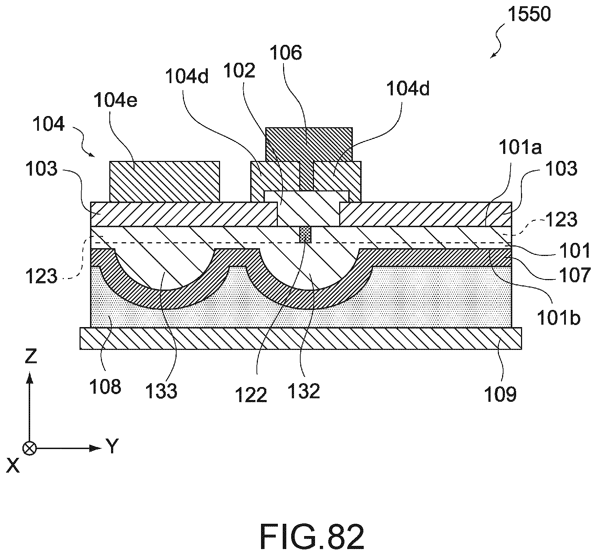

Subsequently, as shown in Fig. 81, the lower light-reflecting layer 107 is formed on the lens structure 131. Further, as shown in Fig. 82, the support substrate 109 is joined to the lower light-reflecting layer 107 with the wax 108, and the wax 112 and the support substrate 113 are removed. This exposes the light-emitting surface. Further, the third the upper electrode 104f (see Fig. 72) is formed on the first upper electrode 104d and the insulation layer 103 to electrically connect the first upper electrode 104d and the second upper electrode 104e to each other. In this way, the light-emitting device 1500 (see Fig. 72) can be produced.

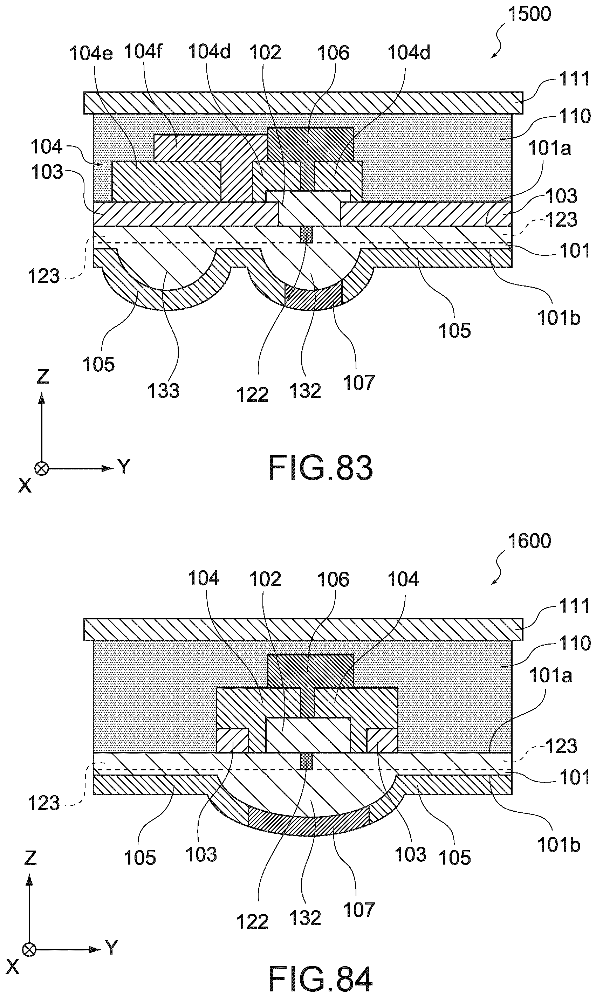

Note that although the above-mentioned light-emitting device 1500 has a front surface emitting structure, the light-emitting device 1500 may have a back surface emitting structure. Fig. 83 is a cross-sectional view of the light-emitting device 1500 having a back surface emitting structure. As shown in the figure, in this light-emitting device 1500, the lower light-reflecting layer 107 is provided only on the lens 132, and the lower electrode 105 is provided around the lower light-reflecting layer 107. Further, the support substrate 111 is joined to the side of the first main surface 101a of the substrate 101 with the conductive paste 110. The other configurations are the same as those of the light-emitting device 1500 of a front surface emitting type.

In the light-emitting device 1500 according to the Example 5, since the light-blocking structure 141 is used to form the lens structure 131 as described above, it is possible to align the lens 132 and the current injection region 122 with high accuracy. Further, since the third the upper electrode 104f is formed after the exposure process (see Fig. 78) to electrically connect the first upper electrode 104d and the second upper electrode 104e to each other, it is possible to reduce the device area of the light-emitting device 1500, improve yield, and reduce the wiring resistance of the upper electrode 104.

### <Example 6>

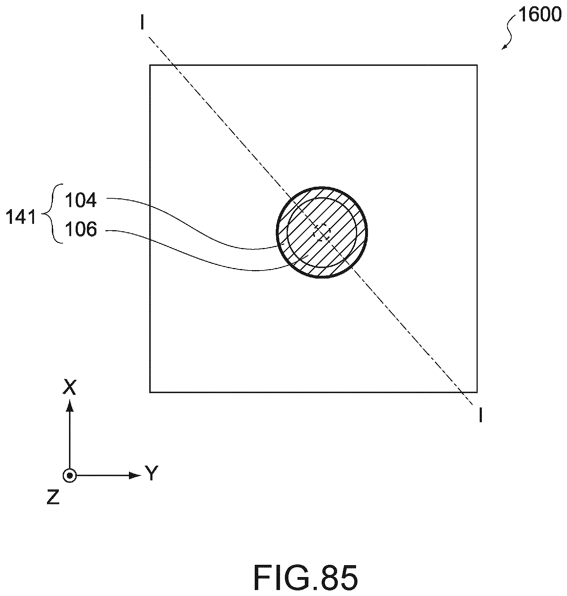

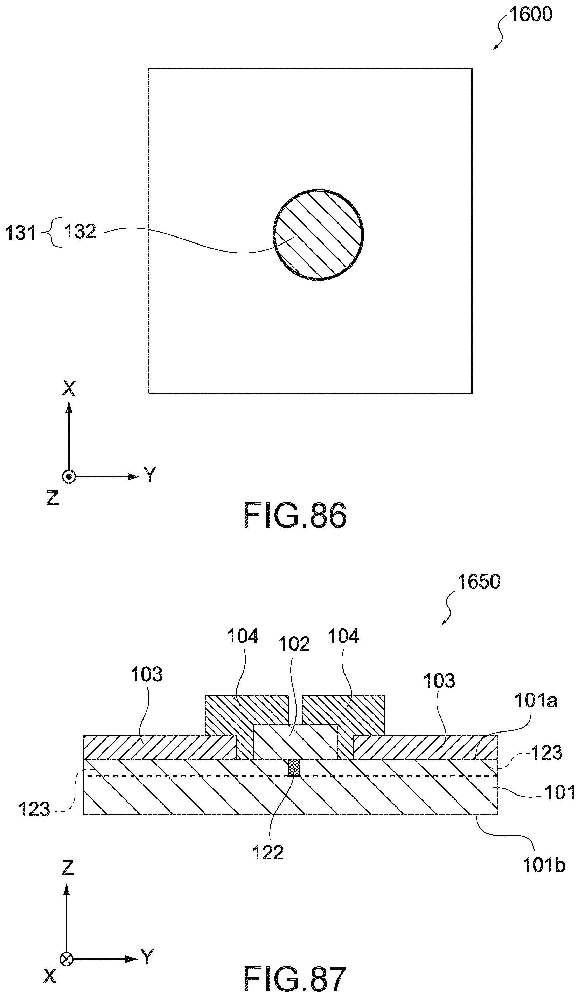

An Example 6 is a modified example of the Example 1. Fig. 84 is a cross-sectional view of a light-emitting device 1600 according to the Example 6. Fig. 85 is a schematic diagram showing the light-blocking structure 141 included in the light-emitting device 1600, and is a plan view of the light-blocking structure 141 as viewed from the direction (Z direction) perpendicular to the first main surface 101a. As shown in the figure, in the light-emitting device 1600, the light-blocking structure 141 includes the upper electrode 104 and the upper light-reflecting layer 106. Fig. 86 is a schematic diagram showing the lens structure 131 included in the light-emitting device 1600, and is a plan view of the lens structure 131 as viewed from the direction (Z direction) perpendicular to the first main surface 101a. Note that Fig. 84 is a cross-sectional view taken along the line I-I in Fig. 85.

As shown in Fig. 85 and Fig. 86, the outer shape of the lens structure 131 as viewed from the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

Fig. 87 to Fig. 95 are each a schematic diagram showing a method of producing the light-emitting device 1600. As shown in Fig. 87, the current injection region 122 and the insulation region 123 are formed in the substrate 101 to form a light-emitting device 1650. Further, the insulation layer 103 having a certain aperture ratio is formed on the first main surface 101a, and the transparent conductive layer 102 is formed on the first main surface 101a. Further, the upper electrode 104 having a certain opening diameter is formed thereon. The outer diameter of the upper electrode 104 is, for example, 30 µm.

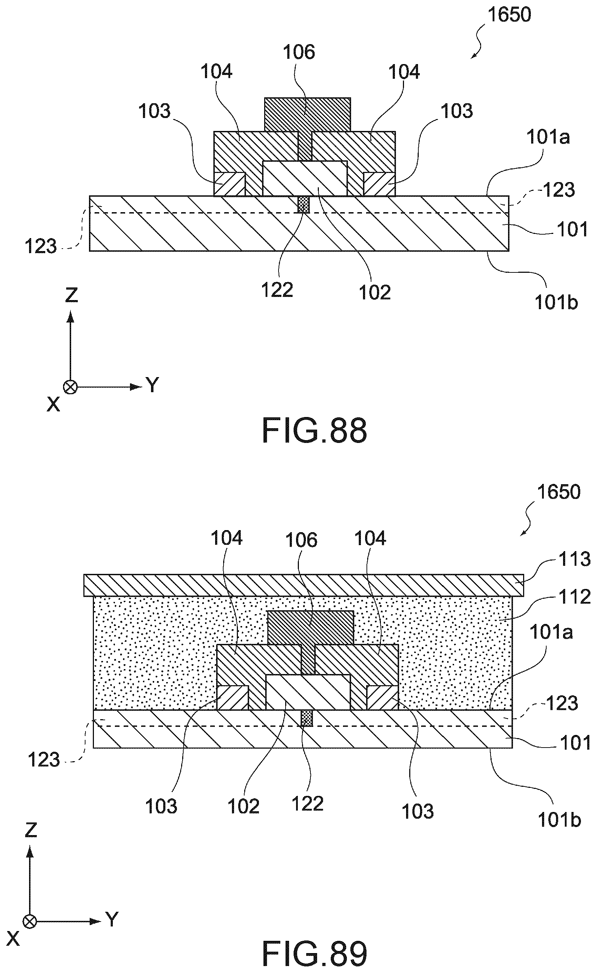

Subsequently, as shown in Fig. 88, the upper light-reflecting layer 106 is formed on the transparent conductive layer 102 and the upper electrode 104, and part of the upper light-reflecting layer 106 is removed by dry etching. This dry etching also removes the outer periphery portion of the insulation layer 103. Subsequently, as shown in Fig. 89, the wax 112 is applied to the side of the first main surface 101a of the substrate 101 and bonded to the support substrate 113. Further, the second main surface 101b is ground by a grinding device to reduce the thickness of the second main surface 101b. The thickness of the substrate 101 after the thickness reduction is, for example, 30 µm.

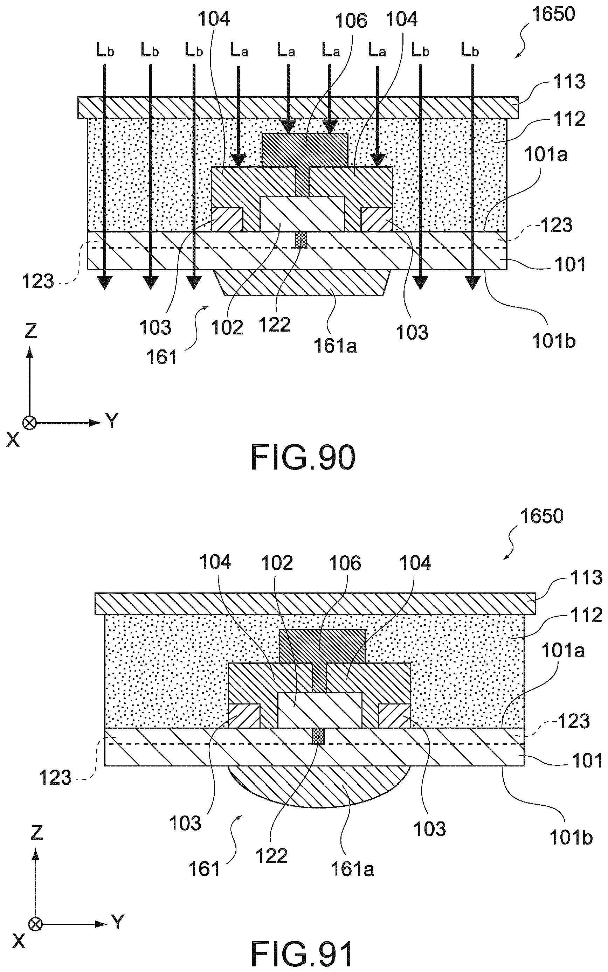

Subsequently, the photosensitive layer 161 is formed on the second main surface 101b, and exposure is performed from the side of the first main surface 101a as shown in Fig. 90. The light beam Lₐ is blocked by the light-blocking structure 141 (see Fig. 85), and the light L_{b} forms a denatured region in the photosensitive layer 161. The denatured region is removed by etching, and the pattern of the photosensitive layer 161 including the non-denatured region 161a is formed as shown in Fig. 90.

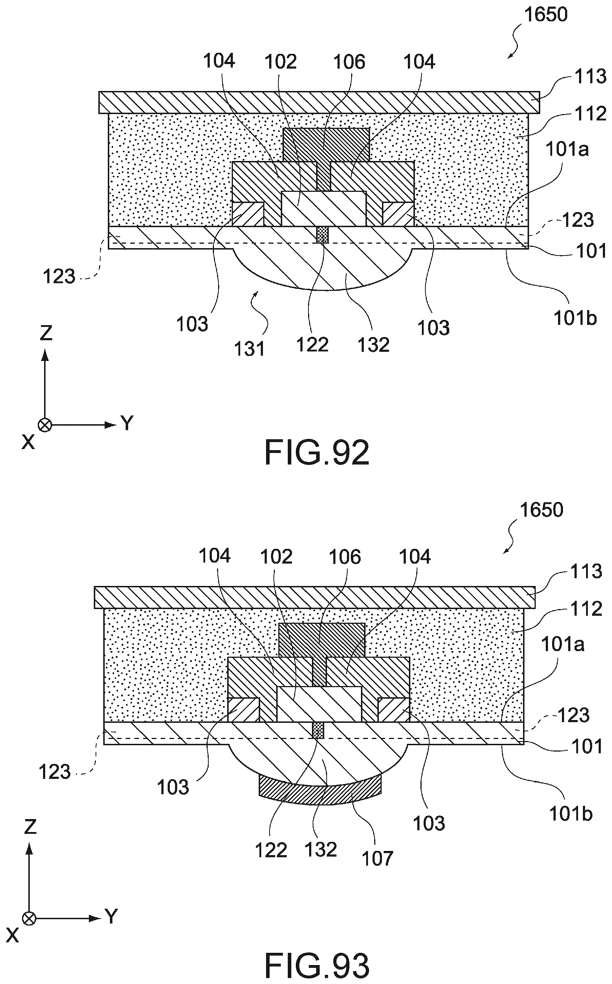

Subsequently, the photosensitive layer 161 is heated and reflowed to ball up the photosensitive layer 161 as shown in Fig. 91. As a result, the photosensitive layer 161 has a shape having a predetermined radius of curvature. This radius of curvature is, for example, 50 µm. Subsequently, the balled-up photosensitive layer 161 is used to form the lens structure 131 as shown in Fig. 92. The lens structure 131 can be formed by etching the substrate 101 using the balled-up photosensitive layer 161 as an etching mask. Further, the balled-up photosensitive layer 161 may be used as the lens structure 131.

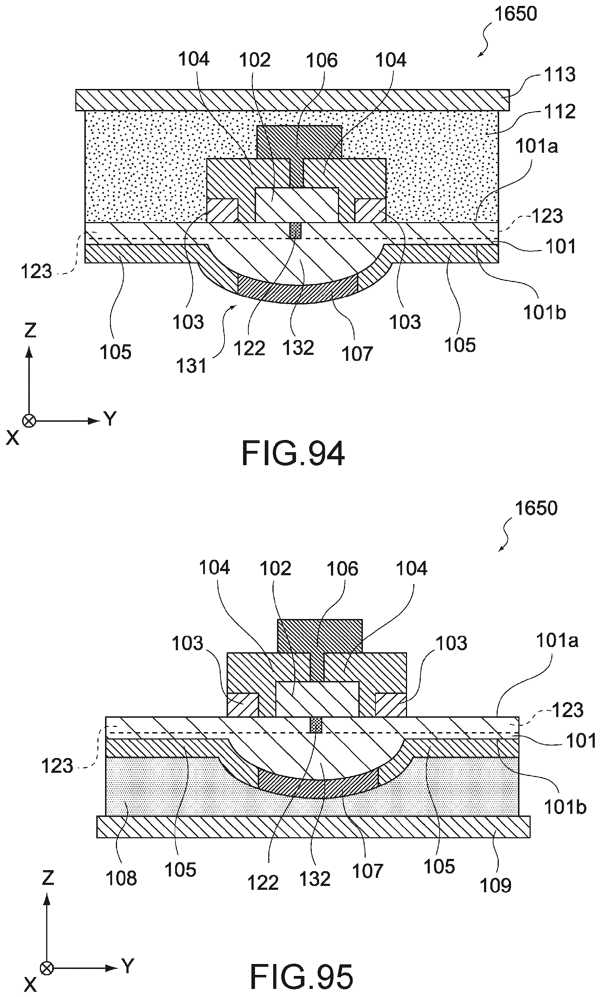

Subsequently, as shown in Fig. 93, the lower light-reflecting layer 107 is formed on the second main surface 101b, and the lower light-reflecting layer 107 on the peripheral region of the lens 132 is removed. Further, as shown in Fig. 94, the lower electrode 105 is formed on the peripheral region of the lens 132 of the second main surface 101b. Further, as shown in Fig. 95, the support substrate 109 is joined to the lower light-reflecting layer 107 and the lower electrode 105 with the wax 108. Subsequently, the support substrate 111 is joined to the side of the first main surface 101a of the substrate 101 with the conductive paste 110 (see Fig. 84), and the wax 112 and the support substrate 113 are removed. This exposes the light-emitting surface. In this way, the light-emitting device 1600 (see Fig. 84) having a back surface emitting structure can be produced.

In the light-emitting device 1600 according to the Example 6, since the light-blocking structure 141 is used to form the lens structure 131 as described above, it is possible to align the lens 132 and the current injection region 122 with high accuracy. Further, by performing mounting using the conductive paste 110, it is possible to improve the heat dissipation of the light-emitting device 1600.

### <Example 7>

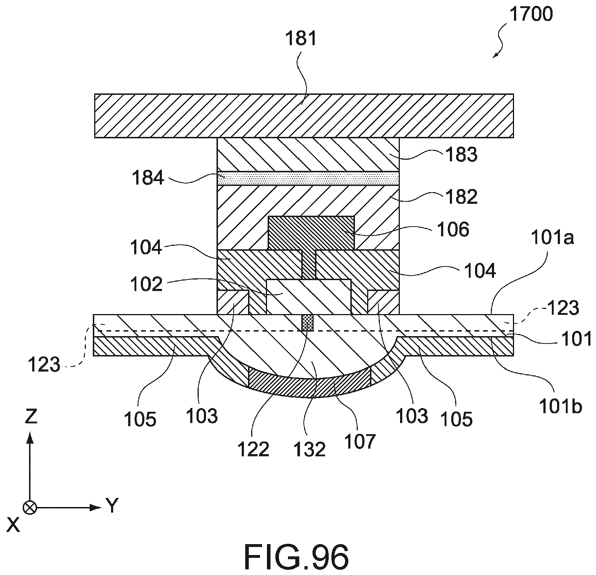

An Example 7 is a modified example of the Example 6. Fig. 96 is a cross-sectional view of a light-emitting device 1700 according to the Example 7. As shown in the figure, the light-emitting device 1700 further includes a light-emitting device driving unit 181, a conductive layer 182, a drive unit terminal 183, and a joining unit 184. The light-emitting device driving unit 181 is, for example, a laser driver.

The light-blocking structure 141 of the light-emitting device 1700 includes the upper electrode 104 and the upper light-reflecting layer 106, and the shape of the light-blocking structure 141 as viewed from the direction (Z direction) perpendicular to the first main surface 101a is the same as that in the Example 6 (see Fig. 85). The shape of the lens structure 131 of the light-emitting device 1700 as viewed from the direction (Z direction) perpendicular to the first main surface 101a is also the same as that in the Example 6 (see Fig. 86). Therefore, the outer shape of the lens structure 131 as viewed from the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

The method of producing the light-emitting device 1700 is similar to that for the light-emitting device 1600 except for the final process. That is, after the support substrate 109 is joined to the lower light-reflecting layer 107 and the lower electrode 105 with the wax 108 (see Fig. 95), the conductive layer 182 (see Fig. 96) is provided on the upper light-reflecting layer 106 and the upper electrode 104. Further, the conductive layer 182 and the drive unit terminal 183 are joined together with the joining unit 184. The joining unit 184 is, for example, an Au-Au joint. Subsequently, the wax 108 and the support substrate 109 are removed. In this way, the light-emitting device 1700 (see Fig. 96) having a back surface emitting structure can be produced.

In the light-emitting device 1700 according to the Example 7, since the light-blocking structure 141 is used to form the lens structure 131 as described above, it is possible to align the lens 132 and the current injection region 122 with high accuracy. Further, the light-emitting device 1700 can be individually driven by the light-emitting device driving unit 181.

### <Example 8>

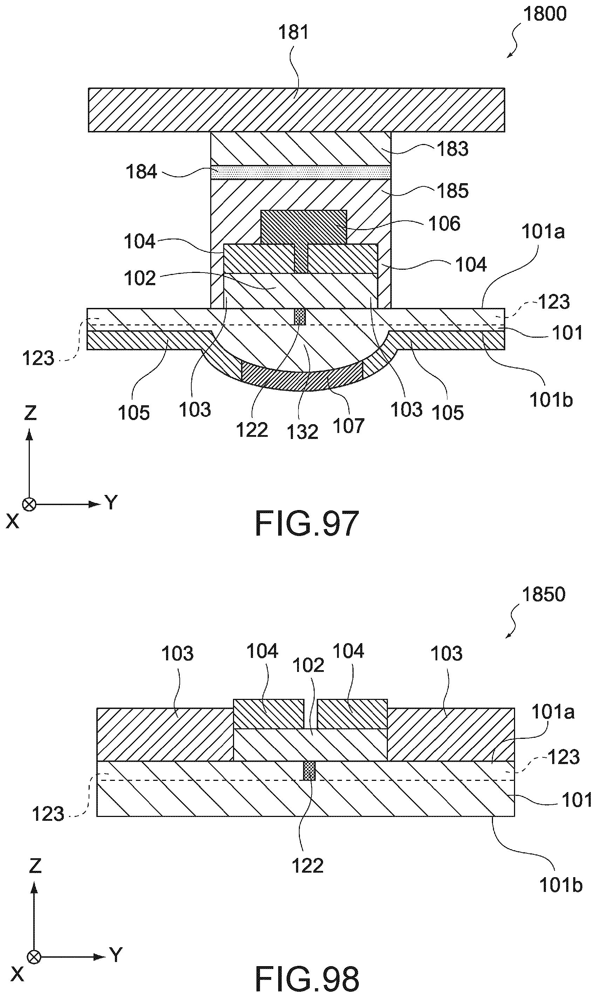

An Example 8 is a modified example of the Example 6. Fig. 97 is a cross-sectional view of a light-emitting device 1800 according to the Example 8. As shown in the figure, the light-emitting device 1800 further includes the light-emitting device driving unit 181, the drive unit terminal 183, the joining unit 184, and a transparent conductive layer 185. The light-emitting device driving unit 181 is, for example, a laser driver.

The light-blocking structure 141 of the light-emitting device 1800 includes the upper electrode 104 and the upper light-reflecting layer 106, and the shape of the light-blocking structure 141 as viewed from the direction (Z direction) perpendicular to the first main surface 101a is the same as that in the Example 6 (see Fig. 85). The shape of the lens structure 131 of the light-emitting device 1800 as viewed from the direction (Z direction) perpendicular to the first main surface 101a is also the same as that in the Example 6 (see Fig. 86). Therefore, the otuer shape of the lens structure 131 as viewed from the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

Fig. 98 to Fig. 107 are each a schematic diagram showing a method of producing the light-emitting device 1800. As shown in Fig. 98, the current injection region 122 and the insulation region 123 are formed in the substrate 101 to form a light-emitting device 1850. Further, the transparent conductive layer 102 and the insulation layer 103 are formed on the first main surface 101a, and the upper electrode 104 is formed on the transparent conductive layer 102. The outer diameter of the upper electrode 104 is, for example, 30 µm.

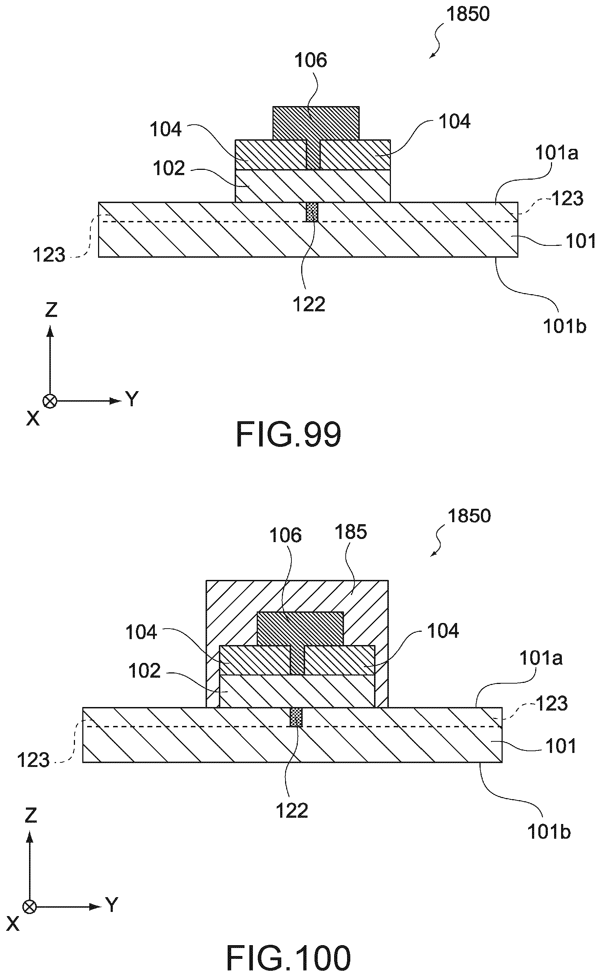

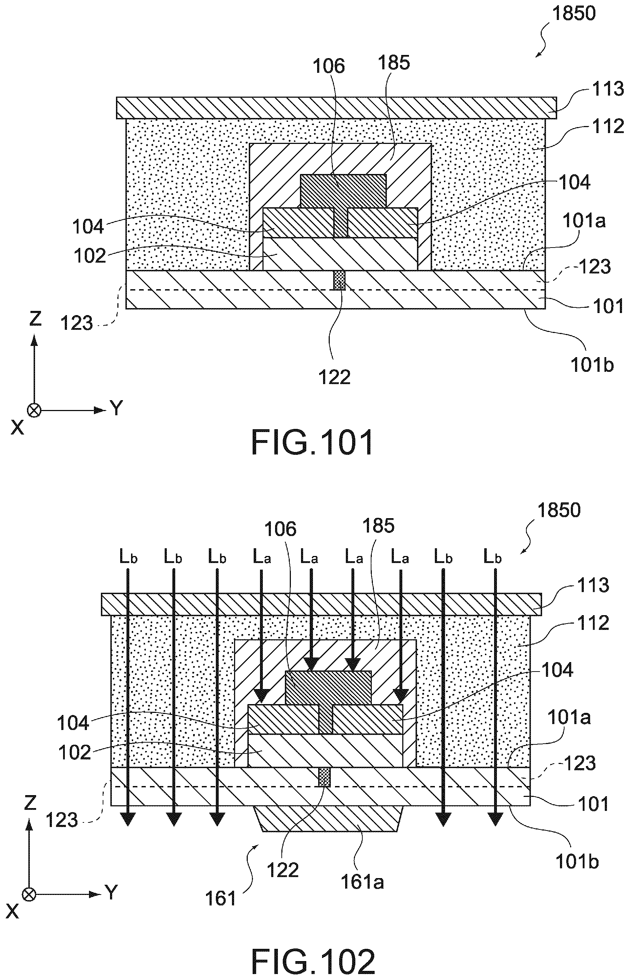

Subsequently, as shown in Fig. 99, the upper light-reflecting layer 106 is formed on the transparent conductive layer 102 and the upper electrode 104, and part of the upper light-reflecting layer 106 is removed by dry etching. This dry etching also removes the insulation layer 103. Subsequently, as shown in Fig. 100, the transparent conductive layer 185 is formed on the upper electrode 104 and the upper light-reflecting layer 106. The transparent conductive layer 185 is formed of, for example, ITO (Indium Tin Oxide). Subsequently, as shown in Fig. 101, the wax 112 is applied to the side of the first main surface 101a of the substrate 101 and bonded to the support substrate 113. Further, the second main surface 101b is ground by a grinding device to reduce the thickness of the second main surface 101b. The thickness of the substrate 101 after the thickness reduction is, for example, 30 µm.

Subsequently, the photosensitive layer 161 is formed on the second main surface 101b, and exposure is performed from the side of the first main surface 101a as shown in Fig. 102. The light beam Lₐ is blocked by the light-blocking structure 141 (see Fig. 85), and the light L_{b} forms a denatured region in the photosensitive layer 161. The denatured region is removed by etching, and the pattern of the photosensitive layer 161 including the non-denatured region 161a is formed as shown in Fig. 102.

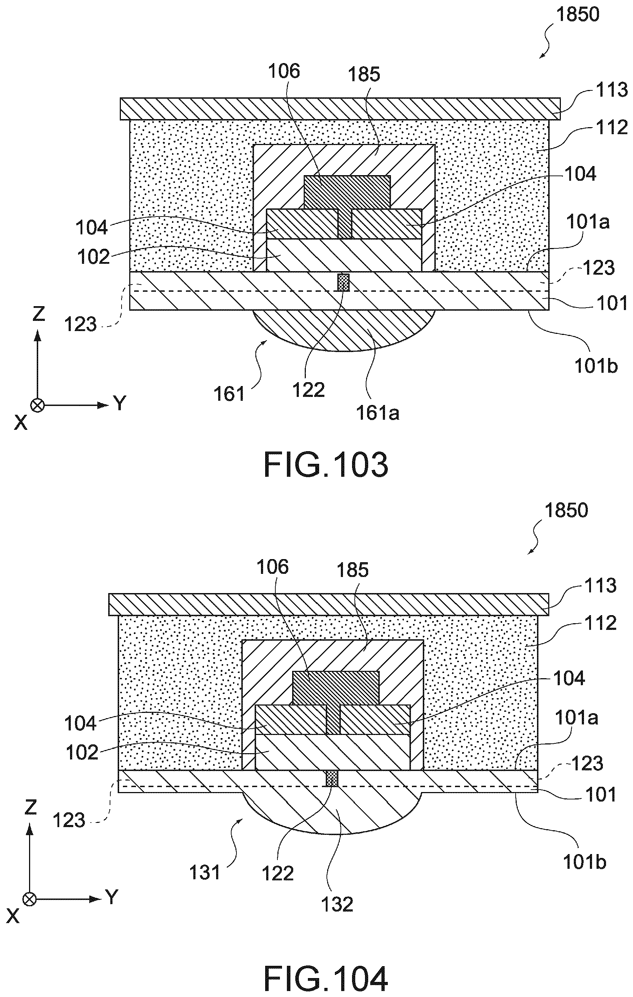

Subsequently, the photosensitive layer 161 is heated and reflowed to ball up the photosensitive layer 161 as shown in Fig. 103. As a result, the photosensitive layer 161 has a shape having a predetermined radius of curvature. This radius of curvature is, for example, 50 µm. Subsequently, the balled-up photosensitive layer 161 is used to form the lens structure 131 as shown in Fig. 104. The lens structure 131 can be formed by etching the substrate 101 using the balled-up photosensitive layer 161 as an etching mask. Further, the balled-up photosensitive layer 161 may be used as the lens structure 131.

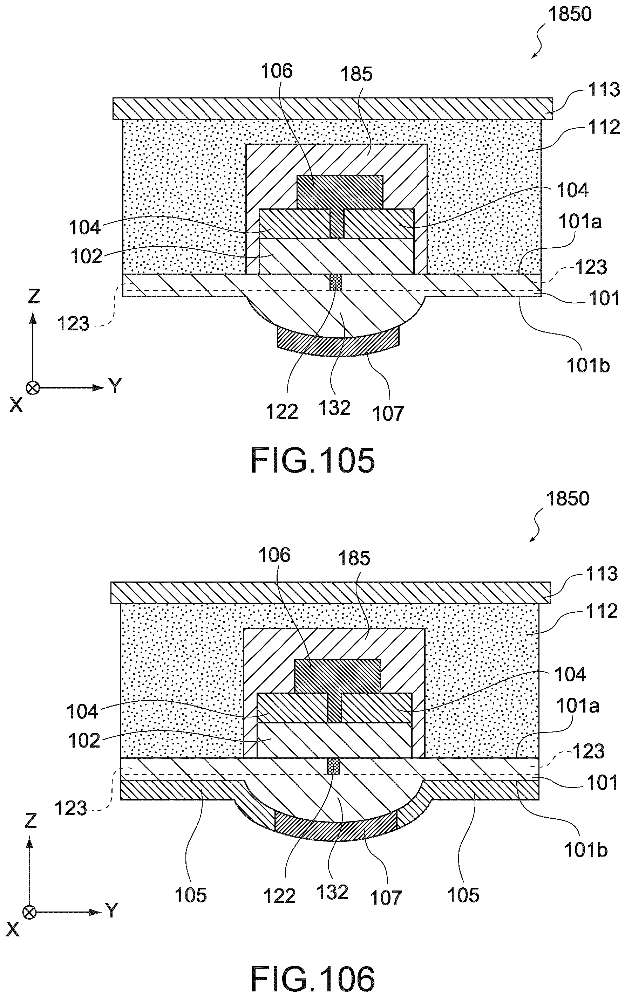

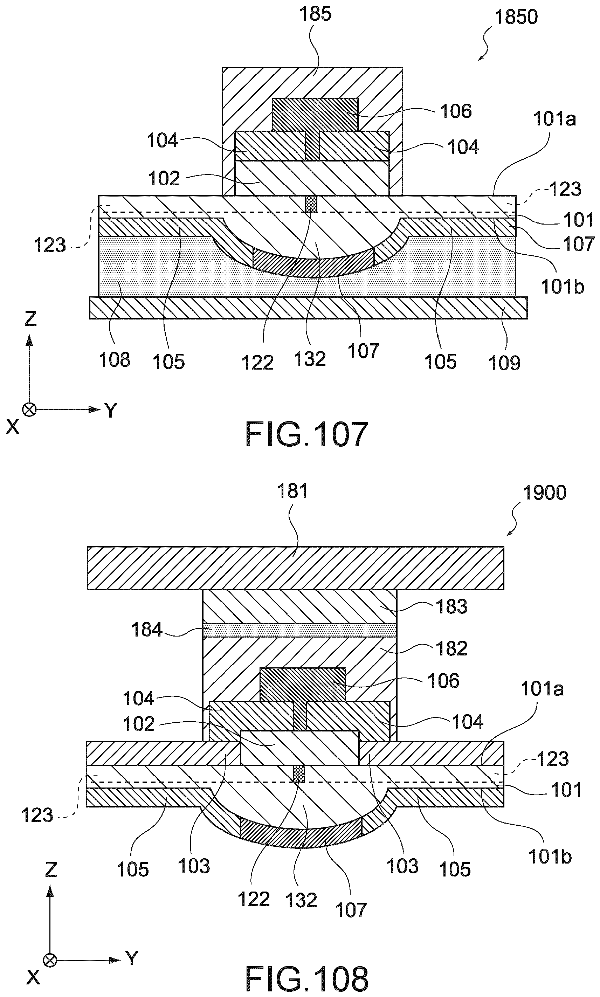

Subsequently, as shown in Fig. 105, the lower light-reflecting layer 107 is formed on the second main surface 101b, and the lower light-reflecting layer 107 on the peripheral region of the lens 132 is formed. Further, as shown in Fig. 106, the lower electrode 105 is formed on the peripheral region of the lens 132 of the second main surface 101b. Further, as shown in Fig. 107, the support substrate 109 is joined to the lower light-reflecting layer 107 and the lower electrode 105 with the wax 108, and the wax 112 and the support substrate 113 are removed. Further, the transparent conductive layer 185 and the drive unit terminal 183 are joined together with the joining unit 184 (see Fig. 97). The joining unit 184 is, for example, an Au-Au joint. Subsequently, the wax 108 and the support substrate 109 are removed. In this way, the light-emitting device 1800 (see Fig. 97) can be produced.

In the light-emitting device 1800 according to the Example 8, since the light-blocking structure 141 is used to form the lens structure 131 as described above, it is possible to align the lens 132 and the current injection region 122 with high accuracy. Further, the light-emitting device 1800 can be individually driven by the light-emitting device driving unit 181.

### <Example 9>

An Example 9 is a modified example of the Example 6. Fig. 108 is a cross-sectional view of a light-emitting device 1900 according to the Example 9. As shown in the figure, the light-emitting device 1900 further includes the light-emitting device driving unit 181, the conductive layer 182, the drive unit terminal 183, and the joining unit 184. The light-emitting device driving unit 181 is, for example, a laser driver.

The light-blocking structure 141 of the light-emitting device 1900 includes the upper electrode 104 and the upper light-reflecting layer 106, and the shape of the light-blocking structure 141 as viewed from the direction (Z direction) perpendicular to the first main surface 101a is the same as that in the Example 6 (see Fig. 85). The shape of the lens structure 131 of the light-emitting device 1900 as viewed from the direction (Z direction) perpendicular to the first main surface 101a is the same as that in the Example 6 (see Fig. 86). Therefore, the outer shape of the lens structure 131 as viewed from the direction (Z direction) perpendicular to the first main surface 101a is similar to the outer shape of the light-blocking structure 141 as viewed from the same direction (Z direction), and the center of gravity as viewed from the same direction (Z direction) matches the center of gravity of the light-blocking structure 141 as viewed from the same direction (Z direction).

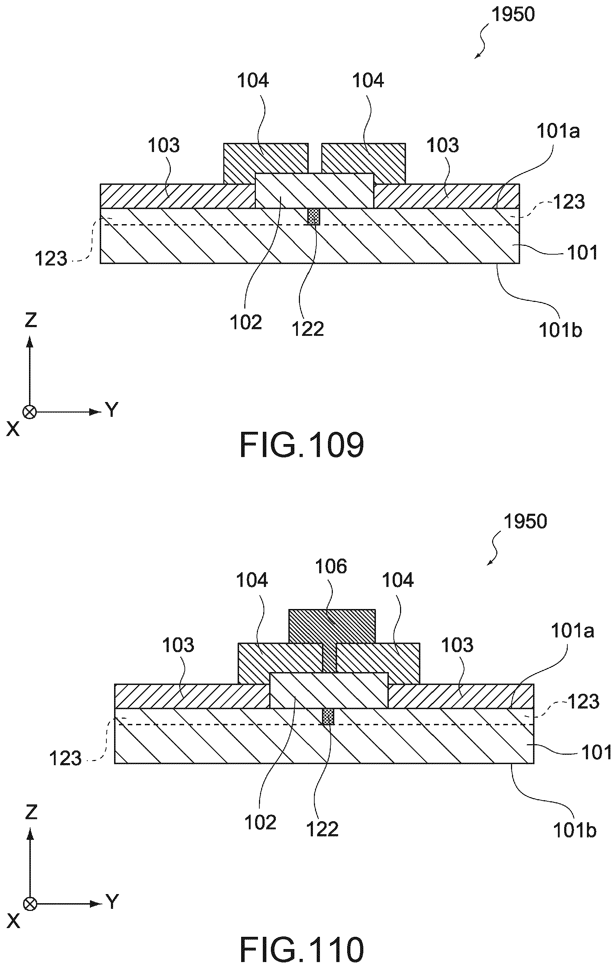

Fig. 109 to Fig. 116 are each a schematic diagram showing a method of producing the light-emitting device 1900. As shown in Fig. 109, the current injection region 122 and the insulation region 123 are formed in the substrate 101 to form a light-emitting device 1950. Further, the transparent conductive layer 102 and the insulation layer 103 are formed on the first main surface 101a, and the upper electrode 104 is formed on the transparent conductive layer 102 and the insulation layer 103. The outer diameter of the upper electrode 104 is, for example, 30 µm.

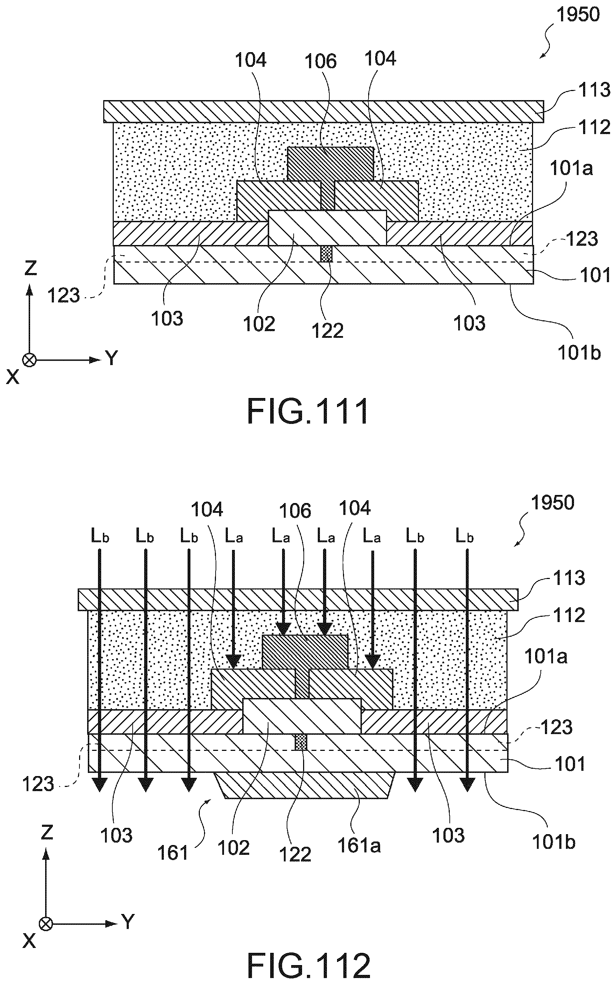

Subsequently, as shown in Fig. 110, the upper light-reflecting layer 106 is formed on the upper electrode 104 by lift-off. Subsequently, as shown in Fig. 111, the wax 112 is applied to the side of the first main surface 101a of the substrate 101 and bonded to the support substrate 113. Further, the second main surface 101b is ground by a grinding device to reduce the thickness of the second main surface 101b. The thickness of the substrate 101 after the thickness reduction is, for example, 30 µm.

Subsequently, the photosensitive layer 161 is formed on the second main surface 101b, and exposure is performed from the side of the first main surface 101a as shown in Fig. 112. The light beam Lₐ is blocked by the light-blocking structure 141 (see Fig. 85), and the light L_{b} forms a denatured region in the photosensitive layer 161. The denatured region is removed by etching, and the pattern of the photosensitive layer 161 including the non-denatured region 161a is formed as shown in Fig. 112.

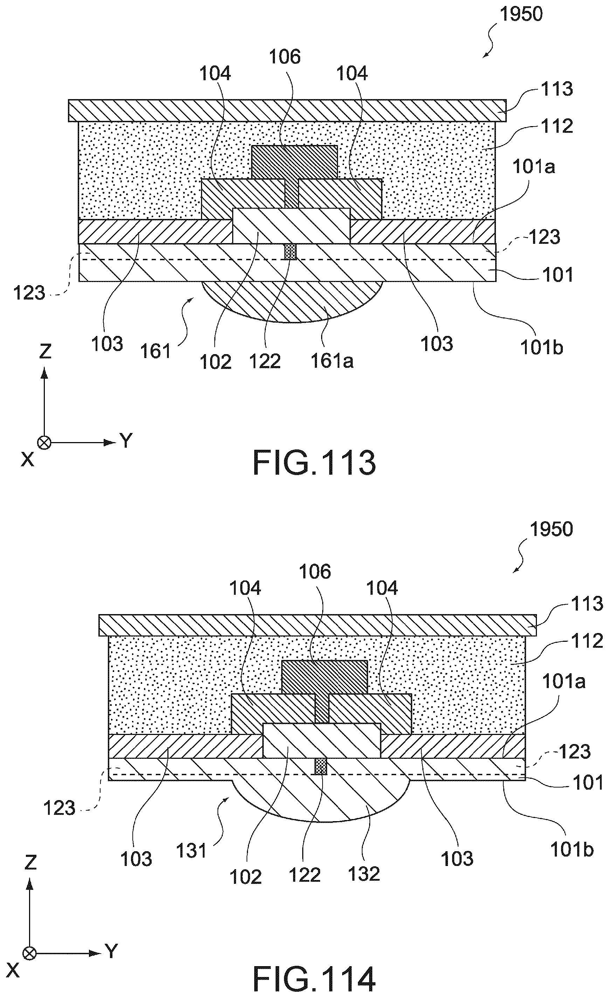

Subsequently, the photosensitive layer 161 is heated and reflowed to ball up the photosensitive layer 161 as shown in Fig. 113. As a result, the photosensitive layer 161 has a shape having a predetermined radius of curvature. This radius of curvature is, for example, 50 µm. Subsequently, the balled-up photosensitive layer 161 is used to form the lens structure 131 as shown in Fig. 114. The lens structure 131 can be formed by etching the substrate 101 using the balled-up photosensitive layer 161 as an etching mask. Further, the balled-up photosensitive layer 161 may be used as the lens structure 131.

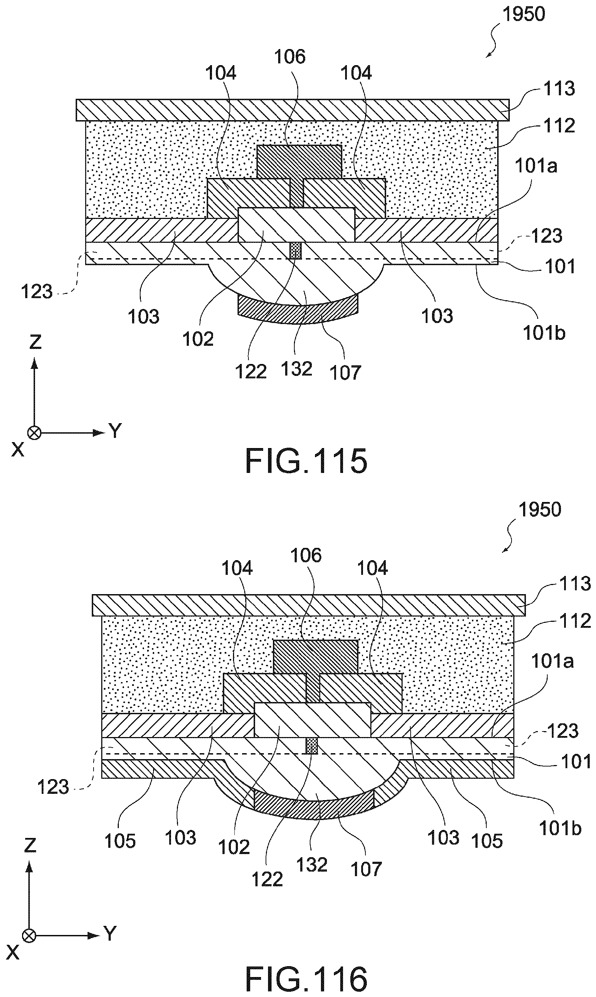

Subsequently, as shown in Fig. 115, the lower light-reflecting layer 107 is formed on the second main surface 101b, and the lower light-reflecting layer 107 on the peripheral region of the lens 132 is removed. Further, as shown in Fig. 116, the lower electrode 105 is formed on the peripheral region of the lens 132 of the second main surface 101b. Subsequently, the wax 112 and the support substrate 113 are removed, and the conductive layer 182 (see Fig. 108) is formed on the upper electrode 104 and the upper light-reflecting layer 106. Further, the conductive layer 182 and the drive unit terminal 183 are joined together with the joining unit 184. The joining unit 184 is, for example, an Au-Au joint. In this way, the light-emitting device 1800 (see Fig. 108) can be produced.

In the light-emitting device 1900 according to the Example 9, since the light-blocking structure 141 is used to form the lens structure 131 as described above, it is possible to align the lens 132 and the current injection region 122 with high accuracy. Further, the light-emitting device 1900 can be individually driven by the light-emitting device driving unit 181.

### [Regarding present disclosure]

The effects described in the present disclosure are merely examples and are not limited, and additional effects may be exerted. The description of the plurality of effects described above does not necessarily mean that these effects are exhibited simultaneously. It means that at least one of the effects described above can be achieved in accordance with the conditions or the like, and there is a possibility that an effect that is not described in the present disclosure is exerted. Further, at least two feature portions of the feature portions described in the present disclosure may be arbitrarily combined with each other.

### Reference Signs List

- 100: light-emitting device
- 101: substrate
- 101a: first main surface
- 101b: second main surface
- 102: transparent conductive layer
- 103: insulation layer
- 104: upper electrode
- 105: lower electrode
- 106: upper light-reflecting layer
- 107: lower light-reflecting layer
- 121: active layer
- 122: current injection region
- 123: insulation region
- 131: lens structure
- 132: lens
- 133: protective portion
- 141: light-blocking structure
- 161: photosensitive layer
- 161a: non-denatured region
- 161b: denatured region

## Claims

1. A method of producing a light-emitting device (100), comprising:
forming a light-blocking structure (141) that is a structure opaque to an exposure wavelength on a side of a first main surface of a substrate (101) having the first main surface (101a) and a second main surface (101b) on a side opposite to the first main surface;
forming a photosensitive layer (161) that is formed of a photosensitive material on a side of the second main surface of the substrate;
applying light having the exposure wavelength to the substrate from the side of the first main surface and forming the photosensitive layer into a pattern corresponding to the light-blocking structure; and
forming a lens (131) using the photosensitive layer.

2. The method of producing a light-emitting device according to claim 1, wherein
The step of applying light having the exposure wavelength includes forming, in the photosensitive layer, a denatured region that light that has not been blocked by the light-blocking structure has entered, and forming the photosensitive layer into a pattern corresponding to a shape of the light-blocking structure by removing the denatured region.

3. The method of producing a light-emitting device according to claim 2, wherein
the step of applying light having the exposure wavelength includes forming, by removing the denatured region, the photosensitive layer in a shape in which an outer shape of the photosensitive layer as viewed from a direction perpendicular to the first main surface is similar to an outer shape of the light-blocking structure as viewed from the direction perpendicular to the first main surface and a center of gravity of the photosensitive layer as viewed from the direction perpendicular to the first main surface matches a center of gravity of the light-blocking structure as viewed from the direction perpendicular to the first main surface.

4. The method of producing a light-emitting device according to claim 1, wherein
the step of forming a lens includes heating the photosensitive layer to ball up the photosensitive layer.

5. The method of producing a light-emitting device according to claim 4, wherein
the step of forming a lens includes using the balled-up photosensitive layer as the lens.

6. The method of producing a light-emitting device according to claim 4, wherein
the step of forming a lens includes etching the substrate using the balled-up photosensitive layer as an etching mask to form the lens.

7. The method of producing a light-emitting device according to claim 4, wherein
the balled-up photosensitive layer has an outer shape as viewed from a direction perpendicular to the first main surface similar to an outer shape of the light-blocking structure as viewed from the direction perpendicular to the first main surface and a center of gravity as viewed from the direction perpendicular to the first main surface that matches a center of gravity of the light-blocking structure as viewed from the direction perpendicular to the first main surface.

8. The method of producing a light-emitting device according to claim 1, wherein
the substrate is formed of GaN, GaAs, or InP.

9. The method of producing a light-emitting device according to claim 1, wherein
the light-blocking structure is formed of one or both of a metal and a multilayer light-reflecting film.

10. The method of producing a light-emitting device according to claim 1, wherein
the photosensitive material is a positive photoresist.

11. A light-emitting device (100), comprising:
a substrate (101) having a first main surface (101a) and a second main surface (101b) on a side opposite to the first main surface;
a light-blocking structure (141) that is a structure opaque to an exposure wavelength on a side of the first main surface of the substrate; and
a lens structure (131) formed of a photosensitive material that is formed on a side of the second main surface of the substrate by applying light having the exposure wavelength to the substrate from the side of the first main surface and forming a photosensitive layer (161) formed of the photosensitive material into a pattern corresponding to the light-blocking structure, the lens structure having a shape in which an outer shape of the lens structure as viewed from a direction perpendicular to the first main surface is similar to an outer shape of the light-blocking structure as viewed from the direction perpendicular to the first main surface and a center of gravity of the lens structure as viewed from the direction perpendicular to the first main surface matches a center of gravity of the light-blocking structure as viewed from the direction perpendicular to the first main surface.

12. The light-emitting device according to claim 11, wherein
a current injection region is provided in the substrate,
the lens structure includes a lens, and
the light-emitting device further includes a light-reflecting layer that is formed on a surface of the lens and forms a concave mirror that collects light generated in the substrate into the current injection region.

13. The light-emitting device according to claim 12, wherein
the lens has a center as viewed from the direction perpendicular to the first main surface that matches a center of the current injection region as viewed from the direction perpendicular to the first main surface.

14. The light-emitting device according to claim 11, wherein
the substrate is formed of GaN, GaAs, or InP.

15. The light-emitting device according to claim 11, wherein
the light-blocking structure is formed of one or both of a metal and a multilayer light-reflecting film.

## Patentansprüche

1. Verfahren zum Herstellen einer lichtemittierenden Vorrichtung (100), umfassend:
Bilden einer lichtblockierenden Struktur (141), die eine für eine Belichtungswellenlänge undurchsichtige Struktur ist, auf einer Seite einer ersten Hauptoberfläche eines Substrats (101), das die erste Hauptoberfläche (101a) und eine zweite Hauptoberfläche (101b) auf einer der ersten Hauptoberfläche gegenüberliegenden Seite aufweist;
Bilden einer lichtempfindlichen Schicht (161), die aus einem lichtempfindlichen Material besteht, auf einer Seite der zweiten Hauptoberfläche des Substrats;
Aufbringen von Licht mit der Belichtungswellenlänge auf das Substrat von der Seite der ersten Hauptoberfläche aus und Formen der lichtempfindlichen Schicht in ein Muster, das der lichtblockierenden Struktur entspricht; und
Bilden einer Linse (131) unter Verwendung der lichtempfindlichen Schicht.

2. Verfahren zur Herstellung einer lichtemittierenden Vorrichtung nach Anspruch 1, wobei
der Schritt des Anwendens von Licht mit der Belichtungswellenlänge das Bilden eines denaturierten Bereichs in der lichtempfindlichen Schicht umfasst, in den Licht eindringt, das nicht von der lichtblockierenden Struktur blockiert wurde, und das Formen der lichtempfindlichen Schicht in ein Muster, das einer Form der lichtblockierenden Struktur entspricht, indem der denaturierte Bereich entfernt wird.

3. Verfahren zur Herstellung einer lichtemittierenden Vorrichtung nach Anspruch 2, wobei
der Schritt des Anwendens von Licht mit der Belichtungswellenlänge das Ausbilden der lichtempfindlichen Schicht durch Entfernen des denaturierten Bereichs in einer Form umfasst, bei der eine Außenform der lichtempfindlichen Schicht, aus einer Richtung senkrecht zur ersten Hauptoberfläche betrachtet, einer Außenform der lichtblockierenden Struktur, aus der Richtung senkrecht zur ersten Hauptoberfläche betrachtet, ähnelt und ein Schwerpunkt der lichtempfindlichen Schicht, aus der Richtung senkrecht zur ersten Hauptoberfläche betrachtet, mit einem Schwerpunkt der lichtblockierenden Struktur, aus der Richtung senkrecht zur ersten Hauptoberfläche betrachtet, übereinstimmt.

4. Verfahren zur Herstellung einer lichtemittierenden Vorrichtung nach Anspruch 1, wobei
der Schritt zum Bilden einer Linse das Erhitzen der lichtempfindlichen Schicht umfasst, um diese zu einer Kugel zu formen.

5. Verfahren zur Herstellung einer lichtemittierenden Vorrichtung nach Anspruch 4, wobei
der Schritt des Bildens einer Linse das Verwenden der zusammengeballten lichtempfindlichen Schicht als Linse umfasst.

6. Verfahren zur Herstellung einer lichtemittierenden Vorrichtung nach Anspruch 4, wobei
der Schritt zum Bilden einer Linse das Ätzen des Substrats unter Verwendung der aufgeballten lichtempfindlichen Schicht als Ätzmaske zum Bilden der Linse umfasst.

7. Verfahren zur Herstellung einer lichtemittierenden Vorrichtung nach Anspruch 4, wobei
die zusammengeballte lichtempfindliche Schicht aus einer Richtung senkrecht zur ersten Hauptfläche betrachtet eine Außenform aufweist, die der Außenform der lichtblockierenden Struktur, aus der Richtung senkrecht zur ersten Hauptfläche betrachtet, ähnelt, und einen Schwerpunkt, aus der Richtung senkrecht zur ersten Hauptfläche betrachtet, aufweist, der mit dem Schwerpunkt der lichtblockierenden Struktur, aus der Richtung senkrecht zur ersten Hauptfläche betrachtet, übereinstimmt.

8. Verfahren zur Herstellung einer lichtemittierenden Vorrichtung nach Anspruch 1, wobei
das Substrat aus GaN, GaAs oder InP besteht.

9. Verfahren zur Herstellung einer lichtemittierenden Vorrichtung nach Anspruch 1, wobei
die lichtblockierende Struktur aus einem oder beiden aus einem Metall und einem mehrschichtigen lichtreflektierenden Film geformt ist.

10. Verfahren zur Herstellung einer lichtemittierenden Vorrichtung nach Anspruch 1, wobei
das lichtempfindliche Material ein positiver Fotolack ist.

11. Lichtemittierende Vorrichtung (100), umfassend:
ein Substrat (101) mit einer ersten Hauptoberfläche (101a) und einer zweiten Hauptoberfläche (101b) auf einer der ersten Hauptoberfläche gegenüberliegenden Seite;
eine lichtblockierende Struktur (141), die eine für eine Belichtungswellenlänge undurchsichtige Struktur auf einer Seite der ersten Hauptoberfläche des Substrats ist; und
eine Linsenstruktur (131) aus einem lichtempfindlichen Material, die auf einer Seite der zweiten Hauptoberfläche des Substrats dadurch gebildet wird, dass Licht mit der Belichtungswellenlänge von der Seite der ersten Hauptoberfläche aus auf das Substrat aufgebracht wird und eine aus dem lichtempfindlichen Material gebildete lichtempfindliche Schicht (161) in einem Muster gebildet wird, das der lichtblockierenden Struktur entspricht, wobei die Linsenstruktur eine Form aufweist, bei der eine Außenform der Linsenstruktur, aus einer Richtung senkrecht zur ersten Hauptoberfläche betrachtet, einer Außenform der lichtblockierenden Struktur, aus der Richtung senkrecht zur ersten Hauptoberfläche betrachtet, ähnelt und ein Schwerpunkt der Linsenstruktur, aus der Richtung senkrecht zur ersten Hauptoberfläche betrachtet, mit einem Schwerpunkt der lichtblockierenden Struktur, aus der Richtung senkrecht zur ersten Hauptoberfläche betrachtet, übereinstimmt.

12. Lichtemittierende Vorrichtung nach Anspruch 11, wobei
ein Strominjektionsbereich im Substrat vorgesehen ist,
die Linsenstruktur eine Linse umfasst und
die lichtemittierende Vorrichtung ferner eine lichtreflektierende Schicht umfasst, die auf einer Oberfläche der Linse ausgebildet ist und einen konkaven Spiegel bildet, der im Substrat erzeugtes Licht in den Strominjektionsabschnitt sammelt.

13. Lichtemittierende Vorrichtung nach Anspruch 12, wobei
die Linse einen Mittelpunkt, aus der Richtung senkrecht zur ersten Hauptoberfläche betrachtet , aufweist, der mit dem Mittelpunkt des Strominjektionsbereichs, aus der Richtung senkrecht zur ersten Hauptoberfläche betrachtet, übereinstimmt.

14. Lichtemittierende Vorrichtung nach Anspruch 11, wobei
das Substrat aus GaN, GaAs oder InP besteht.

15. Lichtemittierende Vorrichtung nach Anspruch 11, wobei
die lichtblockierende Struktur aus einem oder beiden aus einem Metall und einem mehrschichtigen lichtreflektierenden Film geformt ist.

## Revendications

1. Procédé de production d'un dispositif émetteur de lumière (100), comprenant :
la formation d'une structure de blocage de lumière (141) qui est une structure opaque à une longueur d'onde d'exposition sur un côté d'une première surface principale d'un substrat (101) ayant la première surface principale (101a) et une seconde surface principale (101b) sur un côté opposé à la première surface principale ;
la formation d'une couche photosensible (161) qui est formée d'un matériau photosensible sur un côté de la seconde surface principale du substrat ;
l'application de lumière ayant la longueur d'onde d'exposition au substrat à partir du côté de la première surface principale et la formation de la couche photosensible en un motif correspondant à la structure de blocage de lumière ; et
la formation d'une lentille (131) à l'aide de la couche photosensible.

2. Procédé de production d'un dispositif émetteur de lumière selon la revendication 1, dans lequel
l'étape d'application de lumière ayant la longueur d'onde d'exposition comporte la formation, dans la couche photosensible, d'une région dénaturée dans laquelle de la lumière qui n'a pas été bloquée par la structure de blocage de lumière est entrée, et la formation de la couche photosensible en un motif correspondant à une forme de la structure de blocage de lumière en retirant la région dénaturée.

3. Procédé de production d'un dispositif émetteur de lumière selon la revendication 2, dans lequel
l'étape d'application de lumière ayant la longueur d'onde d'exposition comporte la formation, en retirant la région dénaturée, de la couche photosensible sous une forme dans laquelle la forme externe de la couche photosensible telle que visualisée à partir d'une direction perpendiculaire à la première surface principale est similaire à une forme externe de la structure de blocage de lumière telle que visualisée à partir de la direction perpendiculaire à la première surface principale et un centre de gravité de la couche photosensible tel que visualisé à partir de la direction perpendiculaire à la première surface principale concorde avec un centre de gravité de la structure de blocage de lumière tel que visualisé à partir de la direction perpendiculaire à la première surface principale.

4. Procédé de production d'un dispositif émetteur de lumière selon la revendication 1, dans lequel
l'étape de formation d'une lentille comporte le chauffage de la couche photosensible pour rouler en boule la couche photosensible.

5. Procédé de production d'un dispositif émetteur de lumière selon la revendication 4, dans lequel
l'étape de formation d'une lentille comporte l'utilisation de la couche photosensible roulée en boule en guise de lentille.

6. Procédé de production d'un dispositif émetteur de lumière selon la revendication 4, dans lequel
l'étape de formation d'une lentille comporte la gravure du substrat à l'aide de la couche photosensible roulée en boule en tant que masque de gravure pour former la lentille.

7. Procédé de production d'un dispositif émetteur de lumière selon la revendication 4, dans lequel
la couche photosensible roulée en boule a une forme externe telle que visualisée à partir d'une direction perpendiculaire à la première surface principale similaire à une forme externe de la structure de blocage de lumière telle que visualisée à partir de la direction perpendiculaire à la première surface principale et un centre de gravité tel que visualisé à partir de la direction perpendiculaire à la première surface principale qui concorde avec un centre de gravité de la structure de blocage de lumière tel que visualisé à partir de la direction perpendiculaire à la première surface principale.

8. Procédé de production d'un dispositif émetteur de lumière selon la revendication 1, dans lequel
le substrat est formé de GaN, de GaAs ou d'InP.

9. Procédé de production d'un dispositif émetteur de lumière selon la revendication 1, dans lequel
la structure de blocage de lumière est formée de l'un et/ou de l'autre parmi un métal et un film de réflexion de lumière multicouche.

10. Procédé de production d'un dispositif émetteur de lumière selon la revendication 1, dans lequel
le matériau photosensible est une photorésine positive.

11. Dispositif émetteur de lumière (100), comprenant :
un substrat (101) ayant une première surface principale (101a) et une seconde surface principale (101b) sur un côté opposé à la première surface principale ;
une structure de blocage de lumière (141) qui est une structure opaque à une longueur d'onde d'exposition sur un côté de la première surface principale du substrat ; et
une structure de lentille (131) formée d'un matériau photosensible qui est formé sur un côté de la seconde surface principale du substrat en appliquant de la lumière ayant la longueur d'onde d'exposition au substrat à partir du côté de la première surface principale et en formant une couche photosensible (161) formée du matériau photosensible en un motif correspondant à la structure de blocage de lumière, la structure de lentille ayant une forme dans laquelle une forme externe de la structure de lentille telle que visualisée à partir d'une direction perpendiculaire à la première surface principale est similaire à une forme externe de la structure de blocage de lumière telle que visualisée à partir de la direction perpendiculaire à la première surface principale et un centre de gravité de la structure de lentille tel que visualisé à partir de la direction perpendiculaire à la première surface principale concorde avec un centre de gravité de la structure de blocage de lumière tel que visualisé à partir de la direction perpendiculaire à la première surface principale.

12. Dispositif émetteur de lumière selon la revendication 11, dans lequel
une région d'injection de courant est fournie dans le substrat,
la structure de lentille comporte une lentille, et
le dispositif émetteur de lumière comporte en outre une couche de réflexion de lumière qui est formée sur une surface de la lentille et forme un miroir concave qui collecte la lumière générée dans le substrat dans la région d'injection de courant.

13. Dispositif émetteur de lumière selon la revendication 12, dans lequel
la lentille a un centre tel que visualisé à partir de la direction perpendiculaire à la première surface principale qui concorde avec un centre de la région d'injection de courant tel que visualisé à partir de la direction perpendiculaire à la première surface principale.

14. Dispositif émetteur de lumière selon la revendication 11, dans lequel
le substrat est formé de GaN, de GaAs ou d'InP.

15. Dispositif émetteur de lumière selon la revendication 11, dans lequel
la structure de blocage de lumière est formée de l'un et/ou de l'autre parmi un métal et un film de réflexion de lumière multicouche.
